# FASCICULE DE BREVET EUROPEEN

(11) **EP 3 646 398 B1**
(45) Date de publication et mention de la délivrance du brevet: **18.08.2021**
(21) Numéro de dépôt: 18752541.5
(22) Date de dépôt: 28.06.2018
(51) Int. Cl.: H01M 50/129, H01M 50/116, H01M 10/0585, H01M 10/0562, H01M 10/0525, H01M 10/04, H01M 6/18, H01M 6/40, H01M 50/105

(54) **SYSTÈME D'ENCAPSULATION POUR COMPOSANTS ÉLECTRONIQUES ET BATTERIES**
EINKAPSELUNGSSYSTEM FÜR ELEKTRONISCHE BAUTEILE UND BATTERIEN
ENCAPSULATION SYSTEM FOR ELECTRONIC COMPONENTS AND BATTERIES

(30) Priorité: 29.06.2017 FR 1756079; 06.07.2017 FR 1756364; 07.05.2018 FR 1853930
(43) Date de publication de la demande: 06.05.2020
(60) Demande divisionnaire: 20189732.9
(73) Titulaire: I-TEN, 69570 Dardilly (FR)
(72) Inventeur: GABEN, Fabien, 69570 Dardilly (FR)
(74) Mandataire: Schmidt, Martin Peter
(86) Numéro de dépôt international: PCT/FR2018/051582
(87) Numéro de publication internationale: WO 2019/002768

(56) Documents cités:
- EP-A1- 2 868 770
- CN-A- 105 552 254
- US-A- 5 561 004
- US-A1- 2002 071 989

## Description

### Domaine technique de l'invention

La présente invention se rapporte aux systèmes d'encapsulation d'objets tels de que composants microélectroniques et batteries. Elle concerne plus particulièrement le domaine des batteries, et notamment des batteries à ions de lithium, qui peuvent être encapsulées de cette manière. L'invention concerne également un nouveau procédé de fabrication de batteries à couches minces à ions de lithium, présentant une architecture et encapsulation nouvelles qui leur confèrent une autodécharge particulièrement faible, et une durée de vie améliorée.

### Etat de la technique

Les composants microélectroniques et batteries, et en particulier les batteries en couches minces, doivent être encapsulées pour être durables car l'oxygène et l'humidité les dégradent. En particulier, les batteries à ions de lithium sont très sensibles à l'humidité, et ont besoin d'une encapsulation qui leur assure une durée de vie supérieure à 10 ans. Avec la généralisation des dispositifs électroniques portables et des réseaux de capteurs autonomes, le besoin en batteries rechargeables à forte densité d'énergie et forte densité de puissance s'est renforcé considérablement. Les batteries à ions de lithium en couches minces disposent d'une forte densité d'énergie et d'une forte densité de puissance, sont rechargeables, et ne présentent pas d'effet mémoire : elles sont capables de satisfaire ce besoin, mais leur fiabilité et leur durée de vie restent des facteurs critiques.

Les batteries à ions de lithium en couches minces comprennent des électrodes et un électrolyte entièrement solides, c'est-à-dire exempts de liquide. L'épaisseur des différentes couches qui les constituent ne dépasse normalement pas les 10 µm, et est souvent comprise entre 1 et 4 µm. On observe que ces batteries en couches minces, telles que les batteries multicouches, sont sensibles à l'autodécharge. En fonction du positionnement des électrodes, notamment de la proximité des bords des électrodes pour les batteries multicouches et de la propreté des découpes, un courant de fuite peut apparaitre sur les extrémités, un court-circuit rampant qui diminue la performance de la batterie. Ce phénomène est exacerbé si le film d'électrolyte est très mince.

Ces batteries à ions de lithium entièrement solides en couches minces utilisent le plus souvent des anodes comportant une couche de lithium métallique. On observe que les matériaux d'anode présentent une forte variation de leur volume pendant les cycles de charge et décharge de la batterie. En effet, lors d'un cycle de charge et de décharge, une partie du lithium métallique est transformée en ions de lithium qui s'insèrent dans la structure des matériaux de cathode, ce qui s'accompagne d'une réduction du volume de l'anode. Cette variation cyclique du volume peut détériorer les contacts mécaniques et électriques entre les couches d'électrodes et d'électrolyte. Cela diminue les performances de la batterie au cours de sa vie.

La variation cyclique du volume des matériaux d'anode induit également une variation cyclique du volume des cellules des batteries. Elle engendre ainsi des contraintes cycliques sur le système d'encapsulation, susceptibles d'amorcer des fissures qui sont à l'origine de la perte d'étanchéité (ou même d'intégrité) du système d'encapsulation. Ce phénomène est une autre cause de la diminution des performances de la batterie au cours de sa vie.

En effet, les matériaux actifs des batteries à ions de lithium sont très sensibles à l'air et en particulier à l'humidité. Les ions de lithium mobiles réagissent spontanément avec des traces d'eau pour former du LiOH, conduisant à un vieillissement calendaire des batteries. Tous les matériaux à insertion et électrolytes conducteurs des ions de lithium ne sont pas réactifs au contact de l'humidité. A titre d'exemple, le Li₄Ti₅O₁₂ ne se détériore pas au contact de l'atmosphère ou de traces d'eau. En revanche, dès qu'il est chargé en lithium sous forme Li₄₊ₓTi₅O₁₂ avec x>0, alors le surplus de lithium inséré (x) est, quant à lui, sensible à l'atmosphère et réagit spontanément avec les traces d'eau pour former du LiOH. Le lithium ayant réagi n'est alors plus disponible pour le stockage d'électricité, induisant une perte de capacité de la batterie.

Pour éviter l'exposition des matériaux actifs de la batterie à ions de lithium à l'air et à l'eau et empêcher ce type de vieillissement, il est essentiel de la protéger par un système d'encapsulation. De nombreux systèmes d'encapsulation pour des batteries en couches minces sont décrits dans la littérature.

Le document US 2002 / 0 071 989 décrit un système d'encapsulation d'une batterie en couches minces entièrement solide comprenant un empilement d'une première couche d'un matériau diélectrique choisi parmi l'alumine (Al₂O₃), la silice (SiO₂), le nitrure de silicium (Si₃N₄), le carbure de silicium (SiC), l'oxyde de tantale (Ta₂O₅) et le carbone amorphe, d'une seconde couche d'un matériau diélectrique et d'une couche d'étanchéité disposée sur la seconde couche et recouvrant la totalité de la batterie.

Le document US 5 561 004 décrit plusieurs systèmes de protection d'une batterie à ions de lithium en couches minces. Un premier système proposé comprend une couche de parylène recouverte d'un film d'aluminium déposée sur les composants actifs de la batterie. Toutefois, ce système de protection contre la diffusion de l'air et de la vapeur d'eau n'est efficace que pendant environ un mois. Un deuxième système proposé comprend des couches alternées de parylène (500 nm d'épaisseur) et de métal (environ 50 nm d'épaisseur). Le document précise qu'il est préférable de revêtir ces batteries encore d'une couche d'époxy durcie aux ultraviolets (UV) de manière à réduire la vitesse de dégradation de la batterie par des éléments atmosphériques.

D'autres systèmes d'encapsulation pour batteries au lithium sont décrits dans les documents CN 105 552 254 A et EP 2 868 770 A1.

Selon l'état de la technique la plupart des batteries à ions de lithium sont encapsulées dans des feuilles de polymère métallisées (appelées « pouch ») refermées autour de la cellule batterie et thermoscellées au niveau des rubans (appelés « tabs ») de connectique. Ces emballages sont relativement souples et les connections positive et négative de la batterie sont alors noyées dans le polymère thermoscellé qui a servi à refermer l'emballage autour de la batterie. Toutefois, cette soudure entre les feuilles de polymère n'est pas totalement étanche aux gaz de l'atmosphère, les polymères servant à thermo-sceller la batterie sont assez perméables aux gaz de l'atmosphère. On observe que la perméabilité augmente avec la température, ce qui accélère le vieillissement. Cependant la surface de ces soudures exposées à l'atmosphère reste très faible, et le reste du packaging est constitué de feuilles d'aluminium pris en sandwich entre ces feuilles de polymère. En général, deux feuilles d'aluminium sont associées afin de minimiser les effets liés à la présence de trous, de défauts dans chacune de ces feuilles d'aluminium. La probabilité pour que deux défauts, sur chacun des feuillards soient alignés est fortement réduite.

Ces technologies de packaging permettent de garantir environ 10 à 15 ans de durée de vie calendaire pour une batterie de 10 Ah de 10 x 20 cm² de surface, dans des conditions normales d'utilisation. Si la batterie est exposée à une température élevée, cette durée de vie peut se réduire à moins de 5 ans ; cela reste insuffisant pour de nombreuses applications. Des technologies similaires peuvent être utilisées pour d'autres composants électroniques, tels que des condensateurs, des composants actifs.

En conséquence, il existe un besoin pour des systèmes et des procédés d'encapsulation de batteries en couches minces et d'autres composants électroniques, qui protègent le composant contre l'air, l'humidité et les effets de la température. Plus particulièrement il existe un besoin pour des systèmes et procédés d'encapsulation des batteries à ions de lithium en couches minces, qui les protège contre l'air et l'humidité ainsi que contre leur détérioration lorsque la batterie est soumise à des cycles de charge et de décharge. Le système d'encapsulation doit être étanche et hermétique, doit envelopper et recouvrir totalement le composant ou la batterie, doit être suffisamment souple pour pouvoir accompagner des légers changements de dimensions (« respirations ») de la cellule batterie, et doit également permettre de séparer galvaniquement les bords d'électrodes de signes opposés afin d'éviter tout court-circuit rampant.

Un objectif de la présente invention est de remédier au moins en partie aux inconvénients de l'art antérieur évoqués ci-dessus.

Un autre objectif de la présente invention est de proposer des batteries à ions de lithium dotées d'une durée de vie très élevée et présentant une faible autodécharge.

### Objets de l'invention

Au moins un des objectifs ci-dessus est atteint par l'intermédiaire d'au moins l'un des objets selon l'invention tel que présenté ci-après. La présente invention propose comme premier objet un système d'encapsulation **30** d'un objet **1000** tel qu'un composant électronique ou électrochimique tel qu'une batterie, caractérisé en ce qu'il est formé par trois couches successives comprenant
i. une première couche de recouvrement **31, 31'** composée d'une matière électriquement isolante déposée par dépôt de couches atomiques (ci-après ALD, acronyme de Atomic Layer Déposition), qui recouvre au moins en partie ledit objet,
ii. une deuxième couche de recouvrement **32**, **32**' comprenant du parylène et/ou du polyimide, disposée sur la première couche de recouvrement,
iii. une troisième couche de recouvrement **33**, **33**' déposée sur la deuxième couche de recouvrement de manière à protéger la deuxième couche d'encapsulation, notamment, vis-à-vis de l'oxygène, et à accroître la durée de vie de l'objet.

Avantageusement, le système d'encapsulation d'un objet comprend une couche de recouvrement comprenant du parylène et/ou du polyimide, de préférence du parylène N et un système d'encapsulation (30) déposé sur la dite couche de recouvrement comprenant du parylène et/ou du polyimide.

Avantageusement, la troisième couche de recouvrement **33**, **33**' est à base de résine époxy, de polyéthylène naphtalate (PEN), polyimide, polyamide, polyuréthane ou de silicone.

Un deuxième objet de l'invention est un composant électronique ou électrochimique tel qu'une batterie, de préférence une batterie en couches minces comprenant un système d'encapsulation 30.Un autre objet de l'invention est un composant électrochimique, ledit composant étant une batterie en couches minces, ladite batterie comprenant
- un empilement alterné entre au moins une anode **10**, **10**' et au moins une cathode **20, 20',** chacune constituée d'un empilement de couches minces et dans lequel l'anode **10, 10'** comprend
   ∘ au moins une couche mince d'un matériau actif d'anode **12**, et
   ∘ éventuellement une couche mince d'un matériau d'électrolyte **13**, et dans lequel empilement la cathode **20, 20**'comprend
   ∘ au moins une couche mince d'un matériau actif de cathode **22**, et
   ∘ éventuellement une couche mince d'un matériau d'électrolyte **23** de sorte que la batterie comprenne successivement au moins une couche mince d'un matériau actif d'anode **12**, au moins une couche mince d'un matériau d'électrolyte **13,23** et au moins une couche mince d'un matériau actif de cathode **22**,
- un système d'encapsulation **30** dans lequel ladite première couche 31**,31'** recouvre au moins en partie l'empilement,
ledit système d'encapsulation **30** recouvrant partiellement ledit empilement, une première anode **10** ou cathode **20** comprenant au moins une zone de connexion accessible, alors que la cathode **20** ou l'anode **10** adjacente comprend une zone de recouvrement **ZRT**, qui est recouverte par au moins ladite première couche de recouvrement (31,31') et ladite deuxième couche de recouvrement (32,32'), ladite zone de recouvrement étant située en regard des zones de connexion **ZC** de la première anode ou cathode, selon une direction perpendiculaire au plan dudit empilement.

Un autre objet de l'invention est un procédé de fabrication d'un composant électronique ou électrochimique encapsulé, comprenant la formation d'un système d'encapsulation **30** et dans lequel on dépose successivement de manière à former ledit système d'encapsulation **30** :
(i) une première couche **31,31'** de recouvrement composée d'une matière électriquement isolante par ALD,
(ii) une deuxième couche de recouvrement **32,32'** comprenant du parylène et/ou du polyimide, déposée sur ladite première couche de recouvrement,
(iii) une troisième couche de recouvrement **33**,**33**', déposée sur la deuxième couche de recouvrement, apte à, et déposée de manière à, protéger la deuxième couche d'encapsulation notamment de l'oxygène.

Un autre objet de l'invention est un procédé de fabrication d'un composant électronique ou d'une batterie encapsulé, comprenant la formation d'un système d'encapsulation selon l'invention et dans lequel on dépose successivement de manière à former ledit système d'encapsulation :
- une couche de prétraitement comprenant du parylène et/ou du polyimide sur ledit composant électronique ou électrochimique,
- une première couche (31,31') de recouvrement composée d'une matière électriquement isolante par ALD déposée sur ladite couche de recouvrement comprenant du parylène et/ou du polyimide,
- une deuxième couche de recouvrement (32,32') comprenant du parylène et/ou du polyimide, déposée sur ladite première couche de recouvrement,
- une troisième couche de recouvrement (33,33'), déposée sur la deuxième couche de recouvrement, apte à, et déposée de manière à, protéger la deuxième couche d'encapsulation notamment de l'oxygène.

Encore un autre objet de l'invention est un procédé de fabrication d'une batterie en couches minces,
ladite batterie comprenant un empilement alterné entre au moins une anode **10**, **10**' et au moins une cathode **20**, **20**', chacune constituée d'un empilement de couches minces et dans lequel l'anode **10, 10'** comprend,
∘ au moins une couche mince d'un matériau actif d'anode **12**, et
∘ éventuellement une couche mince d'un matériau d'électrolyte **13**, et dans lequel la cathode **20**, **20**' comprend
∘ au moins une couche mince d'un matériau actif de cathode **22**, et
∘ éventuellement une couche mince d'un matériau d'électrolyte **23** de sorte que la batterie comprenne successivement au moins une couche mince d'un matériau actif d'anode **12**, au moins une couche mince d'un matériau d'électrolyte **13**,**23** et au moins une couche mince d'un matériau actif de cathode **22**,
ledit procédé comprenant les étapes suivantes :
(a) on forme une superposition primaire, comprenant une succession alternée de feuilles de cathode et de feuilles d'anode, ladite superposition primaire étant destinée à former au moins une batterie, deux feuilles adjacentes définissant au moins une région en saillie **RS**, destinée à former ladite zone de connexion accessible **ZC**, ainsi qu'au moins une région en retrait **RT**, destinée à former ladite zone de recouvrement **RTC**,
(b) on dépose le système d'encapsulation selon l'invention par le procédé précédemment décrit.

Avantageusement, après l'étape (b), on fait apparaître la zone de connexion accessible **ZC** ou chaque zone de connexion accessible **ZC**.

Dans un mode de réalisation, après l'étape (b), on réalise une étape (c) comprenant au moins une découpe primaire perpendiculairement au plan de ladite superposition primaire de manière à rendre accessible une zone de connexion **ZC** au niveau de l'anode ci-après zone de connexion anodique et on réalise au moins une découpe primaire perpendiculairement au plan de ladite superposition primaire de manière à rendre accessible une zone de connexion **ZC** au niveau de la cathode ci-après zone de connexion cathodique.

Avantageusement, on réalise les découpes primaires au niveau de bords opposés de ladite superposition primaire.

Dans un premier mode de réalisation, les bords des deux feuilles adjacentes de la superposition primaire comprenant une succession alternée de feuilles de cathode et de feuilles d'anode sont des bords droits, le bord d'une première feuille formant la région en saillie **RS** alors que le bord d'une deuxième feuille formant la région en retrait **RR**.

Dans un second mode de réalisation, on réalise dans le bord d'une première feuille de la superposition primaire comprenant une succession alternée de feuilles de cathode et de feuilles d'anode, des premières échancrures **50**, **50**', **50**", **50'''** ayant une première ou grande section, la paroi desdites premières échancrures constituant ladite région en retrait **RR**, et on réalise, dans une deuxième feuille adjacente, des deuxièmes échancrures ayant une deuxième ou petite section, inférieure à la première section, la paroi desdites deuxièmes échancrures **50**, **50**', **50**", **50'''** constituant ladite région en saillie **RS**.

Avantageusement, les feuilles de cathode et les feuilles d'anode, présentent des échancrures **50**, **50**', **50**", **50'''** en forme de cercle.

Avantageusement, on réalise, dans une première feuille, des premiers orifices ayant une première ou grande section, la paroi desdits orifices constituant ladite région en retrait **RR**, on réalise, dans une deuxième feuille adjacente, des deuxièmes orifices ayant une deuxième ou petite section, inférieure à la première section, la paroi desdits orifices constituant ladite région en saillie **RS**, on remplit le volume intérieur desdits orifices au moyen du système d'encapsulation ou une de ces variantes et on réalise au moins une découpe secondaire, de préférence chaque découpe secondaire, à l'intérieur desdits premiers et deuxièmes orifices, de sorte que les zones de connexion **ZC** sont formées au voisinage des parois présentant la petite section et les zones de recouvrement sont formées au voisinage des parois présentant la grande section.

Avantageusement, on réalise, dans deux feuilles adjacentes, des premières et deuxièmes fentes, mutuellement décalées selon la direction perpendiculaire au plan desdites feuilles, on remplit le volume intérieur desdites fentes au moyen du système d'encapsulation et on réalise au moins une découpe secondaire, de préférence chaque découpe secondaire, à l'intérieur desdites fentes, de sorte que les zones de connexion sont formées au voisinage des parois d'une première fente et les zones de recouvrement sont formées au voisinage des parois d'une deuxième fente.

Avantageusement, après l'étape (c), on connecte les zones de connexion ZC anodique et cathodique électriquement entre elles par un dépôt en couche mince d'un conducteur électronique et dans lequel le dépôt est réalisé par ALD **41**, **41**'.

Avantageusement, on réalise des terminaisons **40**, **40**' anodiques et cathodiques par métallisation des sections préalablement recouvertes d'une couche mince d'un conducteur électronique.

Avantageusement, après l'étape (c), on connecte les zones de connexion anodique et cathodique électriquement entre elles par un système de terminaison comprenant successivement :
∘ une première couche électroniquement conductrice, de préférence métallique, optionnelle, de préférence déposée par ALD **41**, **41**',
∘ une seconde couche **42**, **42**' à base de résine époxy chargée à l'argent, déposée sur la première couche électroniquement conductrice, et
∘ une troisième couche **43**, **43**' à base d'étain, déposée sur la deuxième couche.

Dans un autre mode de réalisation, après l'étape (c), on connecte les zones de connexion anodique et cathodique électriquement entre elles par un système de terminaison comprenant successivement :
∘ une première couche électroniquement conductrice, de préférence métallique, optionnelle, de préférence déposée par ALD (41),
∘ une seconde couche (42) à base de résine époxy chargée à l'argent, déposée sur la première couche électroniquement conductrice, et
∘ une troisième couche (43a) à base de nickel, déposée sur la deuxième couche,
∘ une quatrième couche (43b) à base d'étain ou de cuivre, déposée sur la troisième couche.

Avantageusement, les feuilles présentent des dimensions nettement supérieures à celles de la batterie finale, caractérisé en ce qu'on réalise au moins une autre découpe dite tertiaire, dans une partie médiane desdites feuilles.

Avantageusement, ladite matière électriquement isolante est choisie parmi des matières polymères organiques ou inorganiques non conductrices ayant des propriétés de barrière par rapport à l'eau. Avantageusement, ladite matière électriquement isolante est choisie parmi Al₂O₃, SiO₂, SiO_{y}Nₓ et les résines époxydes.

Avantageusement, la deuxième couche de recouvrement comprend du parylène N.

Avantageusement, l'épaisseur de la première couche mince de recouvrement est inférieure à 200 nm, de préférence comprise entre 5 nm et 200 nm, et encore plus préférentiellement d'environ 50 nm et l'épaisseur de la deuxième couche de recouvrement est comprise entre 1 µm et 50 µm, de préférence d'environ 10 µm.

Avantageusement, l'épaisseur de la troisième couche mince de recouvrement est comprise entre 1 µm et 50 µm, de préférence inférieure à 10 µm, préférentiellement inférieure à 5 µm et encore plus préférentiellement d'environ 2 µm.

Avantageusement, la couche de matériau d'anode est réalisée à partir d'un matériau choisi parmi :
(i) les oxynitrures d'étain (de formule typique SnOₓN_{y}) ;
(ii) le phosphate de fer lithié (de formule typique LiFePO₄) ;
(iii) les oxynitrures mixtes de silicium et étain (de formule typique SiₐSn_{b}O_{y}N_{z} avec a>0, b>0, a+b≤2, 0<y≤4, 0<z≤3) (appelés aussi SiTON), et en particulier le SiSn_{0,87}O_{1,2}N_{1,72} ; ainsi que les oxynitrures-carbures de formule typique SiₐSn_{b}C_{c}O_{y}N_{z} avec a>0, b>0, a+b≤2, 0<c<10, 0<y<24, 0<z<17; SiₐSn_{b}C_{c}O_{y}N_{z}Xₙ avec X au moins un des éléments parmi F, Cl, Br, I, S, Se, Te, P, As, Sb, Bi, Ge, Pb et a>0, b>0, a+b>0, a+b≤2, 0<c<10, 0<y<24 et 0<z<17; et SiₐSn_{b}O_{y}N_{z}Xₙ avec Xₙ au moins un des éléments parmi F, Cl, Br, I, S, Se, Te, P, As, Sb, Bi, Ge, Pb et a>0, b>0, a+b≤2, 0<y≤4 et 0<z≤3;
(iv) les nitrures de type SiₓN_{y} (en particulier avec x=3 et y=4), SnₓN_{y} (en particulier avec x=3 et y=4), ZnₓN_{y} (en particulier avec x=3 et y=4), Li₃₋ₓMₓN (avec M = Co et 0≤x≤0.5, avec M = Ni et 0≤x≤0.6 ou avec M = Cu et 0≤x≤0.3) ;
(v) les oxydes SnO₂, Li₄Ti₅O₁₂, SnB_{0,6}P_{0,4}O_{2,9} et TiO₂.

Avantageusement, la couche de matériau de cathode peut être réalisée à partir d'un matériau de cathode choisi parmi :
- les oxydes LiMn₂O₄, LiCoO₂, LiNiO₂, LiMn_{1,5}Ni_{0,5}O₄, LiMn_{1,5}Ni_{0,5-x}XₓO₄ où X est sélectionné parmi Al, Fe, Cr, Co, Rh, Nd, autres terres rares tels que Sc, Y, Lu, La, Ce, Pr, Pm, Sm, Eu, Gd, Tb, Dy, Ho, Er, Tm, Yb, et où 0 < x < 0,1, LiMn₂₋ₓMₓO₄ avec M = Er, Dy, Gd, Tb, Yb, Al, Y, Ni, Co, Ti, Sn, As, Mg ou un mélange de ces composés et où 0 < x < 0,4, LiFeO₂, LiMn_{1/3}Ni_{1/3}CO_{1/3}O₂, ,LiNi_{0.8}Co_{0.15}Al_{0.05}O₂,
- les phosphates LiFePO₄, LiMnPO₄, LiCoPO₄, LiNiPO₄, Li₃V₂(PO₄)₃ ; les phosphates de formule LiMM'PO₄, avec M et M' (M ≠ M') sélectionnés parmi Fe, Mn, Ni, Co, V ;
- toutes les formes lithiées des chalcogénides suivants : V₂O₅, V₃O₈, TiS₂, les oxysulfures de titane (TiO_{y}S_{z} avec z=2-y et 0,3≤y≤1), les oxysulfures de tungstène (WO_{y}S_{z} avec 0.6<y<3 et 0.1 <z<2), CuS, CuS₂, de préférence LiₓV₂O₅ avec 0 <x≤2, LiₓV₃O₈ avec 0 < x ≤ 1,7, LiₓTiS₂ avec 0 < x ≤ 1, les oxysulfures de titane et de lithium LiₓTiO_{y}S_{z} avec z=2-y, 0,3≤y≤1 , LiₓWO_{y}S_{z}, LiₓCuS, LiₓCuS₂.

Avantageusement, la couche de matériau d'électrolyte est réalisée à partir de matériau d'électrolyte choisi parmi :
∘ les grenats de formule Li_{d} A¹ₓ A²_{y}(TO₄)_{z} où
   ▪ A¹ représente un cation de degré d'oxydation +II, de préférence Ca, Mg, Sr, Ba, Fe, Mn, Zn, Y, Gd ; et où
   ▪ A² représente un cation de degré d'oxydation +III, de préférence Al, Fe, Cr, Ga, Ti, La ; et où
   ▪ (TO₄) représente un anion dans lequel T est un atome de degré d'oxydation +IV, situé au centre d'un tétraèdre formé par les atomes d'oxygène, et dans lequel TO₄ représente avantageusement l'anion silicate ou zirconate, sachant que tout ou partie des éléments T d'un degré d'oxydation +IV peuvent être remplacés par des atomes d'un degré d'oxydation +III ou +V, tels que Al, Fe, As, V, Nb, In, Ta ;
   ▪ sachant que : d est compris entre 2 et 10, préférentiellement entre 3 et 9, et encore plus préférentiellement entre 4 et 8 ; x est de 3 mais peut être compris entre 2,6 et 3,4 (de préférence entre 2,8 et 3,2) ; y est de 2 mais peut être compris entre 1,7 et 2,3 (de préférence entre 1,9 et 2,1) et z est de 3 mais peut être compris entre 2,9 et 3,1;
∘ les grenats, de préférence choisi parmi : le Li₇La₃Zr₂O₁₂; le Li₆La₂BaTa₂O₁₂ ; le Li_{5,5}La₃Nb_{1,75}In_{0.25}O₁₂ ; le Li₅La₃M₂O₁₂ avec M = Nb ou Ta ou un mélange des deux composés ; le Li₇₋ₓBaₓLa₃₋ₓM₂O₁₂ avec 0≤x≤1 et M = Nb ou Ta ou un mélange des deux composés ; le Li₇₋ₓLa₃Zr₂₋ₓMₓO₁₂ avec 0≤x≤2 et M = Al, Ga ou Ta ou un mélange de deux ou trois de ces composés ;
∘ les phosphates lithiés, de préférence choisi parmi : les phosphates lithiés de type NASICON ; le Li₃PO₄; le LiPO₃; le Li₃Al_{0,4}Sc_{1,6}(PO₄)₃ appelés « LASP » ; le Li₃(Sc₂₋ₓMₓ)(PO₄)₃ avec M=AI ou Y et 0 ≤ x ≤ 1 ; le Li₁₊ₓMₓ(Sc)₂₋ₓ(PO₄)₃ avec M = Al, Y, Ga ou un mélange des trois composés et 0 ≤ x ≤ 0,8 ; le Li₁₊ₓMₓ(Ga_{1-y}SC_{y})₂₋ₓ(PO₄)₃ avec 0 ≤ x ≤ 0,8 ; 0 ≤ y ≤ 1 et M= Al ou Y ou un mélange des deux composés; le Li₁₊ₓMₓ(Ga)₂₋ₓ(PO₄)₃ avec M = Al, Y ou un mélange des deux composés et 0 ≤ x ≤ 0,8 ; le Li₁₊ₓAlₓTi₂₋ₓ(PO₄)₃ avec 0 ≤ x ≤ 1 appelés « LATP » ; ou le Li₁₊ₓAlₓGe₂₋ₓ(PO₄)₃ avec 0 ≤ x ≤ 1 appelés « LAGP » ; ou le Li_{1+x+z}Mₓ(Ge_{1-y}Ti_{y})₂₋ₓSi_{z}P_{3-z}O₁₂ avec 0≤x≤0,8 et 0≤y≤1,0 et 0≤z≤0,6 et M= Al, Ga ou Y ou un mélange de deux ou trois de ces composés ; le Li_{3+y}(Sc₂₋ₓMₓ)Q_{y}P_{3-y}O₁₂ avec M = Al et/ou Y et Q = Si et/ou Se, 0 ≤ x ≤ 0,8 et 0 ≤ y ≤ 1 ; ou le Li_{1+x+y}MₓSc₂₋ₓQ_{y}P_{3-y}O₁₂ avec M = Al, Y, Ga ou un mélange des trois composés et Q = Si et/ou Se, 0 ≤ x ≤ 0,8 et 0 ≤ y ≤ 1 ; ou le Li_{1+x+y+z}Mₓ(Ga_{1-y}SC_{y})₂₋ₓQ_{z}P_{3-z}O₁₂ avec 0 ≤ x ≤ 0,8 , 0 ≤ y ≤ 1 , 0 ≤ z ≤ 0,6 avec M = Al ou Y ou un mélange des deux composés et Q= Si et/ou Se ; ou Li₁₊ₓM³ₓM₂₋ₓP₃O₁₂ avec 0 ≤ x ≤ 1 et M³= Cr et/ou V, M = Sc, Sn, Zr, Hf, Se ou Si, ou un mélange de ces composés ;
∘ les composés soufrés lithiés, de préférence choisi parmi : le LiₓAl_{z-y}Ga_{y}S_{w}(PO₄)_{c} avec 4<w<20, 3<x<10, 0≦y<1, 1≦z<4 et 0<c<20 ; le LiₓAl_{z-y}Ga_{y}S_{w}(BO₃)_{c} avec 4<w<20, 3<x<10, 0≦y<1, 1≦z<4 et 0<c<20; le LiₓAl_{z-y}Sc_{y}S_{w}(PO₄)_{c} avec 4<w<20, 3<x<10, 0≦y<1, 1≦z<4 et 0<c<20 ; le LiₓAl_{z-y}Sc_{y}S_{w}(BO₃)_{c} avec 4<w<20, 3<x<10, 0≦y<1, 1≦z<4 et 0<c<20 ; le LiₓGe_{z-y}Si_{y}S_{w}(PO₄)_{c} avec 4<w<20, 3<x<10, 0≦y<1, 1≦z<4 et 0<c<20 ; le LiₓGe_{(z-y})Si_{y}S_{w}(BO₃)_{c} avec 4<w<20, 3<x<10, 0≦y<1, 1≦z<4 et 0<c<20 ;
∘ les borates lithiés, de préférence choisi parmi : le Li₃(Sc₂₋ₓMₓ)(BO₃)₃ avec M=Al ou Y et 0 ≤ x ≤ 1 ; le Li₁₊ₓMₓ(Sc)₂₋ₓ(BO₃)₃ avec M = Al, Y, Ga ou un mélange des trois composés et 0 ≤ x ≤ 0,8 ; le Li₁₊ₓMₓ(Ga_{1-y}Sc_{y})₂₋ₓ(BO₃)₃ avec 0 ≤ x ≤ 0,8 , 0 ≤ y ≤ 1 et M= Al ou Y ; le Li₁₊ₓMₓ(Ga)₂₋ₓ(BO₃)₃ avec M = Al, Y ou un mélange des deux composés et 0 ≤ x ≤ 0,8; le Li₃BO₃, le Li₃BO₃-Li₂SO₄, le Li₃BO₃-Li₂SiO₄, le Li₃BO₃-Li₂SiO₄-Li₂SO₄ ;
∘ les oxynitrures, de préférence choisis parmi Li₃PO₄₋ₓN_{2x/3}, Li₄SiO₄₋ₓN_{2x/3}, Li₄GeO₄₋ₓN_{2x/3} avec 0 < x < 4 ou Li₃BO₃₋ₓN_{2x/3} avec 0 < x < 3 ;
∘ les composés lithiés à base d'oxynitrure de lithium et de phosphore, appelés « LiPON », sous forme de LiₓPO_{y}N_{z} avec x -2,8 et 2y+3z -7,8 et 0,16 ≤ z ≤ 0,4, et en particulier le Li_{2,9}PO_{3,3}N_{0,46}, mais également les composés Li_{w}POₓN_{y}S_{z} avec 2x+3y+2z = 5 = w ou les composés Li_{w}POₓN_{y}S_{z} avec 3,2 ≤ x ≤ 3,8, 0,13 ≤ y ≤ 0,4, 0 ≤ z ≤ 0,2 , 2,9 ≤ w ≤ 3,3 ou les composés sous forme de LiₜPₓAl_{y}OᵤNᵥS_{w} avec 5x+3y=5, 2u+3v+2w=5+t, 2,9≤t≤3,3, 0,84≤x≤0,94, 0,094≤y≤0,26, 3,2≤u≤3,8, 0,13≤v≤0,46, 0≤w≤0,2 ;
∘ les matériaux à base d'oxynitrures de lithium de phosphore ou de bore, appelés respectivement « LiPON » et « LIBON » pouvant également contenir du silicium, du soufre, du zirconium, de l'aluminium, ou une combinaison d'aluminium, bore, soufre et/ou silicium, et du bore pour les matériaux à base d'oxynitrures de lithium de phosphore ;
∘ les composés lithiés à base d'oxynitrure de lithium, de phosphore et de silicium appelés « LiSiPON », et en particulier le Li_{1.9}Si_{0.28}P_{1.0}O_{1.1}N_{1.0} ;
∘ les oxynitrures de lithium de types LiBON, LiBSO, LiSiPON, LiSON, thio-LiSiCON, LiPONB (ou B, P et S représentent respectivement le bore, le phosphore et le soufre);
∘ les oxynitrures de lithium de type LiBSO tels que (1-x)LiBO₂- xLi₂SO₄ avec 0,4 ≤ x ≤ 0,8 ;
∘ les oxydes lithiés, de préférence choisis parmi le Li₇La₃Zr₂O₁₂ ou le Li₅₊ₓLa₃(Zrₓ,A₂₋ₓ)O₁₂ avec A=Sc, Y, Al, Ga et 1,4 ≤ x ≤ 2 ou le Li_{0,35}La_{0,55}TiO₃ ou le Li₃ₓLa_{2/3-x}TiO₃ avec 0 ≤ x ≤ 0,16 (LLTO) ;
∘ les silicates, de préférence choisis parmi Li₂Si₂O₅, Li₂SiO₃, Li₂Si₂O₆, LiAlSiO₄, Li₄SiO₄, LiAlSi₂O₆;
∘ les électrolytes solides de type anti-perovskite choisis parmi :
   ▪ Li₃OA avec A un halogénure ou un mélange d'halogénures, de préférence au moins un des éléments choisi parmi F, Cl, Br, I ou un mélange de deux ou trois ou quatre de ces éléments ;
   ▪ Li₍₃₋ₓ₎M_{x/2}OA avec 0 < x ≤ 3, M un métal divalent, de préférence au moins un des éléments choisi parmi Mg, Ca, Ba, Sr ou un mélange de deux ou trois ou quatre de ces éléments, A un halogénure ou un mélange d'halogénures, de préférence au moins un des éléments choisi parmi F, Cl, Br, I ou un mélange de deux ou trois ou quatre de ces éléments ;
   ▪ Li₍₃₋ₓ₎ M³_{x/3}OA avec 0 ≤ x ≤ 3, M³ un métal trivalent, A un halogénure ou un mélange d'halogénures, de préférence au moins un des éléments choisi parmi F, Cl, Br, I ou un mélange de deux ou trois ou quatre de ces éléments ; ou LiCOX_{z}Y_{(1-z)} avec X et Y des halogénures comme mentionnés ci-dessus en relation avec A, et 0 ≤ z ≤ 1 ;
∘ les composés La_{0,51}Li_{0,34}Ti_{2,94}, Li_{3,4}V_{0,4}Ge_{0,6}O₄, Li₂O-Nb₂O₅, LiAlGaSPO₄ ;
∘ les formulations à base de Li₂CO₃, B₂O₃, Li₂O, Al(PO₃)₃LiF, P₂S₃, Li₂S, Li₃N, Li₁₄Zn(GeO₄)₄, Li_{3,6}Ge_{0,6}V_{0,4}O₄, LiTi₂(PO₄)₃, Li_{3,25}Ge_{0,25}P_{0,25}S₄, Li_{1,3}Al_{0,3}Ti_{1,7}(PO₄)₃, Li₁₋ₓAlₓM₂₋ₓ(PO₄)₃ (où M = Ge, Ti, et/ou Hf, et où 0 < x < 1), Li_{1+x+y}AlₓTi₂₋ₓSi_{y}P_{3-y}O₁₂ (où 0≤x≤1 et 0≤y≤1).
∘ les électrolytes à base de polymères conducteurs d'ions lithium imprégnés ou non par des sels de lithium,
∘ les électrolytes hybrides comprenant une matrice inorganique telle qu'une matrice céramique dans laquelle une phase porteuse d'ions de lithium est insérée, telle qu'un électrolyte organique comprenant au moins un sel de lithium, qu'une solution formée par un sel de lithium dissout dans un solvant organique ou un mélange de solvants organiques, et/ou comprenant un polymère contenant au moins un sel de lithium possiblement dissout dans un solvant organique ou un mélange de solvants organiques, et/ou comprenant au moins un liquide ionique contenant au moins un sel de lithium possiblement dissout dans un solvant organique ou un mélange de solvants organiques.

Cette phase porteuse d'ions de lithium peut être une solution formée par un sel de lithium dissout dans un solvant organique ou un mélange de solvants organiques, et/ou elle peut comprendre un polymère contenant des sels de lithium, et/ou elle peut comprendre un liquide ionique (i.e. un sel de lithium fondu) contenant un sel de lithium. Cette phase peut également être une solution formée à partir d'un mélange de ces trois composants.

Le sel de lithium peut être par exemple du LiPF₆ ou du LiBF₄ dissout dans un solvant aprotique, ou un liquide ionique contenant des sels de lithium. Les liquides ioniques et électrolytes organiques peuvent également être mélangés. On peut par exemple mélanger à 50 % massiques le LiPF₆ dissous dans EC/DMC avec un liquide ionique contenant des sels de lithium de type LiTFSI :PYR14TFSI 1:9 mol. On peut également réaliser des mélanges de liquides ioniques pouvant fonctionner à basse température comme par exemple le mélange LiTFSI :PYR13FSI :PYR14TFSI (2 :9 :9 mol ratio).
EC est l'abréviation courante de carbonate d'éthylène (n° CAS : 96-49-1). DMC est l'abréviation courante de carbonate de diméthyle (n° CAS : 616-38-6). LITFSI est l'abréviation courante de lithium bis-trifluorométhanesulfonimide (n° CAS : 90076-65-6). PYR13FSI est l'abréviation courante de N-Propyl-N-Méthylpyrrolidinium bis(fluorosulfonyl) imide. PYR14TFSI est l'abréviation courante de 1-butyl-1-méthylpyrrolidinium bis(trifluoro-méthanesulfonyl)imide.

Encore un autre objet de l'invention est une batterie en couches minces susceptible d'être obtenue par le procédé selon l'invention.

Encore un autre objet de l'invention est une batterie en couches minces susceptible d'être obtenue par le procédé selon l'invention caractérisée en ce que ledit système d'encapsulation revêt totalement quatre des six faces de ladite batterie et partiellement les deux faces restantes latéralement opposées, les dites deux faces restantes étant partiellement revêtues par au moins ladite première couche de recouvrement (31,31') et au moins ladite deuxième couche (32,32') et les dites deux faces restantes comprenant une zone de connexion anodique et une zone de connexion cathodique.

Un autre objet de l'invention est une batterie comprenant un empilement alterné entre au moins une anode **10**' et au moins une cathode **20**', chacune constituée d'un empilement de couches minces et dans lequel l'anode **10**' comprend,
o au moins une couche mince d'un matériau actif d'anode **12**', et
o éventuellement une couche mince d'un matériau d'électrolyte **13**',
   et dans lequel la cathode **20**' comprend
o au moins une couche mince d'un matériau actif de cathode **22**', et
o éventuellement une couche mince d'un matériau d'électrolyte **23**' de sorte que la batterie comprenne successivement au moins une couche mince d'un matériau actif d'anode, au moins une couche mince d'un matériau d'électrolyte et au moins une couche mince d'un matériau actif de cathode,
étant entendu que l'anode **10**' présente un premier orifice **50** ayant une première section, la paroi dudit premier orifice constituant au moins une région en retrait **RT** (respectivement en saillie **RS**) et la cathode **20**' adjacente présente un deuxième orifice ayant une deuxième section, inférieure (respectivement supérieure) à la première section, la paroi dudit deuxième orifice constituant au moins une région en saillie **RS** (respectivement en retrait **RT**) ; ladite au moins région en saillie définissant une zone de connexion **ZC** accessible et ladite au moins région en retrait **RT** définissant une zone de recouvrement non accessible.

### Figures

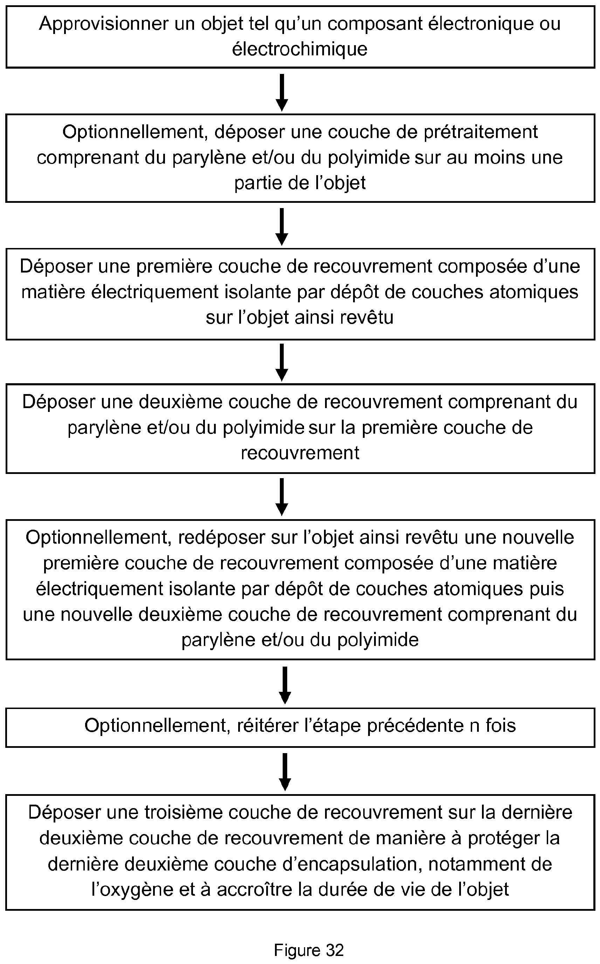

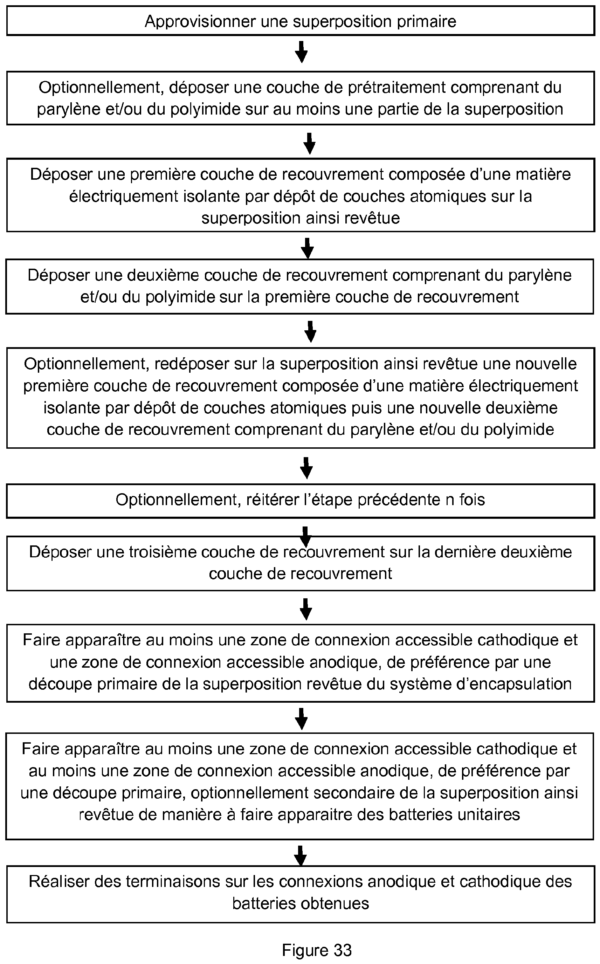

Les figures 1 à 33 illustrent certains aspects de l'invention, mais ne limitent pas sa portée.
La figure 1 représente de manière schématique, une batterie faisant apparaitre un élément central et des terminaisons disposées aux deux extrémités de l'élément central.
La figure 2 représente une vue en perspective avec arrachement selon la ligne II-II d'une batterie entièrement solide, faisant apparaitre la structure interne de l'élément central comprenant un assemblage de cellules élémentaires recouvert par un système d'encapsulation selon l'invention et celle des terminaisons.
La figure 3 est une vue en perspective avec arrachement analogue à la figure 2 illustrant à plus grande échelle le détail III de cette figure 2. Les éléments constitutifs des cellules élémentaires, du système d'encapsulation et des terminaisons sont présentés en plus grand détail respectivement dans les figures 4, 5 et 6.
La figure 4 est une vue en perspective avec arrachement analogue à la figure 3 illustrant à plus grande échelle le détail IV de cette figure 3, illustrant la structure interne de différents éléments constitutifs d'une batterie entièrement solide.
La figure 5 est une vue en perspective avec arrachement analogue à la figure 4 illustrant à plus grande échelle la structure interne du système d'encapsulation selon l'invention.
La figure 6 est une vue en perspective avec arrachement analogue à la figure 4 illustrant à plus grande échelle la structure interne des terminaisons.
La figure 7 représente une vue en perspective éclatée de l'empilement des couches minces d'anode et de cathode, de manière à ce que ces couches soient décalées latéralement.
La figure 8 représente une vue en perspective éclatée du système d'encapsulation selon l'invention de l'empilement des couches d'anode et de cathode comprenant un empilement de couches de recouvrement.
La figure 9A représente une vue en sortie de l'anode montrant les collecteurs de courant anodiques entourés sur leur périphérie par le système d'encapsulation. La figure 9B représente une vue en sortie de la cathode montrant les collecteurs de courant cathodiques entourés sur leur périphérie par le système d'encapsulation.
La figure 10 représente une vue en perspective éclatée des terminaisons d'une batterie entièrement solide, constituées d'un empilement de couches.
La figure 11 représente schématiquement le procédé de fabrication de plusieurs batteries entièrement solides à partir d'un empilement alternatif de feuilles comprenant entre plusieurs dizaines et plusieurs centaines d'anodes délimitées suivant un plan de coupe en forme de U et de feuilles comprenant entre plusieurs dizaines et plusieurs centaines de cathodes délimitées suivant un plan de coupe en forme de U.
La figure 12 représente une vue en perspective avec arrachement d'une batterie entièrement solide, selon la ligne XII-XII de la figure 11 montrant l'empilement des feuilles d'anodes et de cathodes superposées et décalées latéralement.
La figure 13 représente une vue en perspective avec arrachement d'une batterie entièrement solide, selon la ligne XIII-XIII de la figure 11 montrant l'empilement des feuilles d'anodes et de cathodes superposées et décalées latéralement.
La figure 14 représente une vue en perspective avec arrachement d'une batterie entièrement solide montrant l'empilement des feuilles d'anodes et de cathodes superposées et décalées latéralement, ainsi que le système d'encapsulation et les terminaisons.
La figure 15 représente une vue en perspective avec arrachement analogue à la figure 14 illustrant à plus grande échelle le détail VI de cette figure 14, illustrant la structure interne de différents éléments constitutifs d'une batterie entièrement solide.
La figure 16 représente schématiquement, selon un autre mode de réalisation, le procédé de fabrication de plusieurs batteries entièrement solides.
La figure 17 représente de manière schématique une vue en coupe illustrant à plus grande échelle le détail VII de la figure 16.
La figure 18 représente une vue en perspective analogue à la figure 16 illustrant à plus grande échelle le détail VIII de cette figure 16.
La figure 19A représente une vue en perspective avec arrachement d'une batterie entièrement solide, selon la ligne XIX-XIX de la figure 18. La figure 19B représente une vue en perspective avec arrachement d'une batterie entièrement solide, selon la ligne XIX'-XIX' de la figure 18.
La figure 20 représente une vue en perspective de la structure présentée en figure 18 recouverte du système d'encapsulation.
La figure 21A représente une vue en perspective avec arrachement d'une batterie entièrement solide, selon la ligne XXI-XXI de la figure 20. La figure 21B représente une vue en perspective avec arrachement d'une batterie entièrement solide, selon la ligne XXI'-XXI' de la figure 20.
La figure 22 représente une vue en perspective analogue à la figure 21A illustrant à plus grande échelle le détail IX de cette figure 21A.
La figure 23 représente une vue en perspective analogue à la figure 22 illustrant à plus grande échelle le détail X de cette figure 22.
La figure 24 représente une vue en perspective de la structure présentée en figure 20 et montrant le système multicouches d'encapsulation selon l'invention recouvert du système multicouches des terminaisons.
La figure 25 représente une vue en perspective avec arrachement d'une batterie entièrement solide, selon la ligne XXV-XXV ou XXV'-XXV' de la figure 24 montrant l'empilement des feuilles d'anodes et de cathodes superposées.
La figure 25A montre les contacts d'anode recouverts latéralement par le système multicouches des terminaisons.
La figure 25B montre les contacts de cathode recouverts latéralement par le système multicouches des terminaisons.
La figure 26 représente une vue en perspective analogue à la figure 25 illustrant à plus grande échelle le détail XI de cette figure 25.
La figure 27 représente une vue en perspective analogue à la figure 26 illustrant à plus grande échelle le détail XII de cette figure 26.
Les figures 28a et 28b représentent une vue en coupe d'une partie de l'objet **1000** tel qu'un composant électronique ou électrochimique recouvert par le système d'encapsulation selon l'invention.
Les figures 29a et 29b représentent une vue en coupe d'une partie de l'objet **1000** tel qu'un composant électronique ou électrochimique recouvert par le système d'encapsulation selon la première variante de l'invention.
Les figures 30a et 30b représentent une vue en coupe d'une partie de l'objet **1000** tel qu'un composant électronique ou électrochimique recouvert par le système d'encapsulation selon la deuxième variante de l'invention.
Les figures 31a et 31b représentent une vue en coupe d'une partie de l'objet **1000** tel qu'un composant électronique ou électrochimique recouvert par le système d'encapsulation selon la troisième variante de l'invention.
La figure 32 est une représentation schématique d'un procédé de fabrication d'un système d'encapsulation d'un objet **1000** selon l'invention.
La figure 33 est une représentation schématique d'un procédé de fabrication d'une batterie encapsulée par le système d'encapsulation selon l'invention.

**Liste des repères utilisés sur les figures :**

| | | | |
|---|---|---|---|
| 1000 | Objet, de préférence, un composant électronique ou électrochimique | | |
| 1 | Batterie entièrement solide | 30, 30' | Système d'encapsulation selon l'invention |
| 2 | Cellule élémentaire | 31, 31', 31a, 31b, 31n | 1^{ère} couche mince de recouvrement |
| 3 | Empilement de feuilles d'anodes et de cathode | 32, 32', 32a, 32b, 32n | 2^{ème} couche de recouvrement |
| 10, 10' | Anode | 32''', 32'''' | Couches pouvant constituer la 2^{ème} couche de recouvrement |
| 11, 11' | Couche mince d'un substrat conducteur tel que l'inox | 33, 33' | 3^{ème} couche de recouvrement |
| 12, 12' | Couche mince d'un matériau actif d'anode | 40, 40' | Terminaisons |
| 13, 13' | Couche mince d'un matériau d'électrolyte | 41, 41' | Couche métallique déposée par ALD |
| 20, 20' | Cathode | 42, 42' | Couche en résine époxy chargée en Ag |
| 21, 21' | Couche mince d'un substrat conducteur tel que l'inox | 43, 43' | Couche de métallisation (étain) |
| 22, 22' | Couche mince d'un matériau actif de cathode | 43a / 43b | Première/deuxième couche de métallisation |
| 23, 23' | Couche mince d'un matériau d'électrolyte | 50 | Couche de prétraitement |
| F | Flèche indiquant les zones recouvertes par le système d'encapsulation | 50a / 50b | Première/deuxième couche de prétraitement |
| RS | Région en saillie | RR | Région en retrait |
| ZRT | zone de recouvrement | ZC | zones de connexion |
| III, IV, V, VI, VII, VIII, IX, X, XI, XII | | | Grossissements |
| II-II, XII-XII, XIX-XIX, XIX'-XIX', XXI-XXI, XXI'-XXI', XXV-XXV, XXV'-XXV' | | | Axe |

### Description de l'invention

La présente invention concerne un système d'encapsulation d'un objet **1000** lui conférant une isolation électrique et le protégeant de l'environnement externe, et notamment de l'atmosphère ambiante. Le système d'encapsulation selon l'invention permet d'offrir une protection adaptée aux contraintes que les composants électroniques doivent effectivement pouvoir supporter sans perturbation notable de leur fonctionnement ou sans dommage.

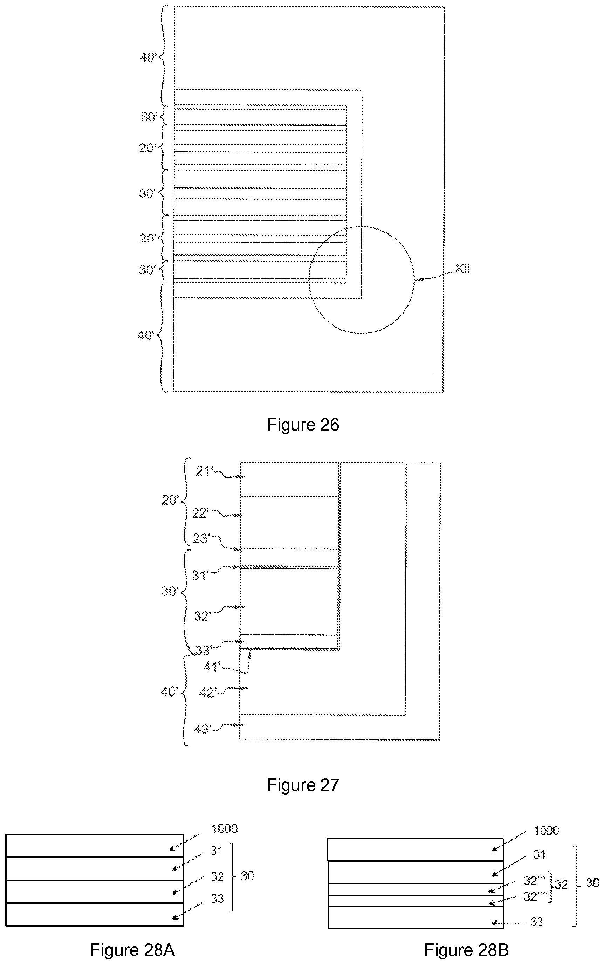

Le système d'encapsulation d'un objet selon l'invention, représenté en figure 28a, comprend :
i. une première couche de recouvrement composée d'une matière électriquement isolante déposée par ALD (Atomic Layer Déposition) destinée à recouvrir au moins en partie ledit objet,
ii. une deuxième couche de recouvrement comprenant du parylène et/ou du polyimide disposée sur la première couche de recouvrement,
iii. une troisième couche de recouvrement déposée sur la deuxième couche de recouvrement de manière à protéger la deuxième couche du système d'encapsulation, notamment de l'oxygène et à accroître la durée de vie de l'objet.

L'objet encapsulé peut être un composant électronique (tel qu'un circuit intégré, une résistance, un condensateur), ou électrochimique tel qu'une batterie, un panneau photovoltaïque.

La première couche de recouvrement 31 du système d'encapsulation est constituée d'une matière électriquement isolante telle que l'Al₂O₃, le SiO₂, le SiO_{y}Nₓ et les résines époxydes. Avantageusement, ladite matière électriquement isolante est choisie parmi des matières polymères organiques ou inorganiques ayant des propriétés de barrière par rapport à l'eau. Cette première couche est déposée sur au moins une partie dudit objet par une technique de dépôt conformai, telle qu'un procédé de dépôt par couches atomiques (Atomic Layer Déposition en anglais, plus connue sous le sigle ALD). Lorsque l'objet est une batterie, la première couche de recouvrement 31 est déposée sur l'empilement ou la superposition primaire par ALD. Ainsi on obtient un recouvrement conformai de l'ensemble des surfaces accessibles de l'empilement ; cette première couche est de préférence une couche inorganique.

Les techniques de dépôt par ALD sont particulièrement bien adaptées pour recouvrir des surfaces présentant une forte rugosité de manière totalement étanche et conforme. Les techniques de dépôt par ALD permettent de réaliser des couches conformales, exempts de défauts, de trous. Ces couches sont qualifiées de « exempt de trous » (pinhole free) et représentent des très bonnes barrières. Leur coefficient WVTR est extrêmement faible. Le coefficient WVTR (Water Vapor Transmission Rate) permet d'évaluer la perméance à la vapeur d'eau du système d'encapsulation. Plus le coefficient WVTR est faible plus le système d'encapsulation est étanche. A titre d'exemple, un dépôt d'Al₂O₃ de 100 nm d'épaisseur par ALD présente une perméation à la vapeur d'eau de 0,00034 g/m2.d.

La première couche d'encapsulation ainsi obtenue peut être en matériau céramique, en matériau vitreux ou en matériau vitrocéramique. Elle est généralement constituée d'oxydes, de type Al₂O₃, de nitrure, de phosphates, d'oxynitrure, de siloxane, d'une épaisseur inférieure à 200 nm, de préférence comprise entre 5 nm et 200 nm, plus préférentiellement comprise entre 10 nm et 100 nm et encore plus préférentiellement de l'ordre d'une cinquantaine de nanomètres. Toutefois, ces couches déposées par ALD sont très fragiles mécaniquement et nécessitent une surface d'appui rigide. Le dépôt d'une couche fragile sur une surface souple conduirait à la formation de fissures, engendrant une perte d'intégrité de cette couche de protection. Par ailleurs, pour permettre industriellement une vitesse de dépôt relativement élevée, ces couches doivent être déposées à une température assez élevée, i.e. à une température comprise entre 180 °C et 300 °C. Les matériaux constituants l'objet doivent ainsi résister à de telles températures et présenter une surface suffisamment rigide pour garantir la réalisation d'une encapsulation de qualité par ALD. Ceci s'applique en particulier aux empilements rigides, aux empilements solides monoblocs de cellules à ions de lithium, i.e. de batterie à ions de lithium. Or, la plupart des électrolytes usuels à base de polymères contenant des sels de lithium, i.e des électrolytes sous forme de gel, liquides ou contenant des poches de liquide, ne résistent pas à une telle température et ne présentent pas une surface suffisamment rigide pour garantir la réalisation d'une encapsulation fiable par ALD. En effet, sous vide et à haute température, ces électrolytes dégazent et empêchent ainsi la réalisation de dépôts minces homogènes et protecteurs directement sur leurs surfaces. De manière préférée on évitera donc l'utilisation de ces électrolytes dans des batteries qui bénéficieront du système d'encapsulation selon l'invention.

Une exception peut être faite pour les batteries à ions de lithium employant au moins une électrode poreuse et/ou au moins un électrolyte comprenant une couche inorganique poreuse, l'électrode et la couche inorganique poreuse possédant un réseau interconnecté de pores ouverts dont le diamètre moyen D₅₀ des pores est compris entre 2 nm et 80 nm, de préférence entre 2 nm et 50 nm, préférentiellement entre 6 nm et 30 nm, et encore plus préférentiellement entre 8 nm et 20 nm et dont les pores, de par leur taille, sont capables d'absorber une phase liquide par simple capillarité et sont imprégnés par une phase porteuse d'ions de lithium, i.e. par un électrolyte, telle qu'une solution formée par un sel de lithium dissout dans un solvant organique ou un mélange de solvants organiques, et/ou comprenant un polymère contenant au moins un sel de lithium possiblement dissout dans un solvant organique ou un mélange de solvants organiques, et/ou comprenant au moins un liquide ionique contenant au moins un sel de lithium possiblement dissout dans un solvant organique ou un mélange de solvants organiques.

La phase liquide « nanoconfinée » ou « nanopiégée » dans les porosités, de préférence dans les mésoporosités, ne peut plus ressortir. Elle est liée par un phénomène appelé ici « d'absorption dans la structure mésoporeuse » (qui ne semble pas avoir été décrit dans la littérature dans le contexte des batteries à ions de lithium) et ne peut plus sortir même lorsque la cellule est mise sous vide. Cette batterie comprenant une telle électrode poreuse et/ou un tel électrolyte est alors considérée comme quasi-solide. Grâce au nanoconfinement de la phase conductrice porteuse d'ions de lithium dans les porosités, la batterie peut subir des traitements sous vide contrairement aux batteries à ions de lithium qui utilisent des séparateurs imprégnés d'électrolytes usuels comme indiqué précédemment ; ces batteries à ions de lithium employant des séparateurs ne sont pas suffisamment rigides pour subir ces traitements sous vide sans être dégradées.

Lorsque l'objet **1000** est une batterie, cette première couche d'encapsulation 31 permet aussi de séparer les sections des électrodes, afin de réduire l'autodécharge et les risques de vieillissement de la batterie, ce qui facilite ainsi le rapprochement des électrodes.

Selon l'invention, une seconde couche d'encapsulation **32** est déposée sur la première couche d'encapsulation afin d'améliorer la protection de l'objet (i.e. composant électronique ou électrochimique tel qu'une batterie) de son environnement externe. Typiquement, cette seconde couche est en polymère, par exemple en silicone (déposé par exemple par imprégnation ou par dépôt chimique en phase vapeur assisté par plasma à partir d'hexaméthyldisiloxane (HMDSO)), ou en résine epoxy, ou en polyimide, ou en parylène, de préférence en parylène et/ou en polyimide. Cette deuxième couche d'encapsulation est avantageusement obtenue à partir de la condensation de monomères gazeux déposés par dépôt chimique en phase vapeur (CVD) sur les surfaces, ce qui permet d'avoir un recouvrement conformai et uniforme de l'ensemble des surfaces de l'objet accessible.

Cette deuxième couche assure le remplissage du système d'encapsulation sans dégrader la première couche du système d'encapsulation. Elle permet de suivre les variations de volume de l'objet lors de son fonctionnement et facilite la découpe propre des batteries de par ses propriétés élastiques. L'épaisseur de ladite deuxième couche d'encapsulation est comprise entre 1 µm et 50 µm, de préférence comprise entre 1 µm et 35 µm, de préférence comprise entre 2 µm et 10 µm, préférentiellement comprise entre 2 µm et 5 µm et encore plus préférentiellement d'environ 3 µm.

Avantageusement, on dépose sur la première couche de recouvrement 31 un film de parylène, tel qu'un film de parylène C, de parylène D, un film de parylène N (CAS 1633-22-3) ou un film comprenant un mélange de parylène C, D et/ou N. Ce film de parylène permet de protéger les éléments sensibles de l'objet de leur environnement. Le parylène (appelé aussi polyparaxylylène ou poly(p-xylylène)) est un matériau diélectrique, transparent, semi cristallin qui présente une grande stabilité thermodynamique, une excellente résistance aux solvants ainsi qu'une très faible perméabilité. Le parylène a également des propriétés barrières permettant de protéger l'objet de son environnement externe. La protection de la batterie est accrue lorsque cette deuxième couche d'encapsulation est réalisée à partir de parylène N.

De manière alternative, on dépose sur la première couche de recouvrement une couche à base de polyimide. Cette couche de polyimide protège les éléments sensibles de la batterie de leur environnement.

De manière alternative et particulièrement avantageuse, la deuxième couche d'encapsulation 32 (i.e. deuxième couche de recouvrement) est constituée d'une première couche de polyimide 32''' déposée sur la première couche de recouvrement, de préférence d'environ 1 µm d'épaisseur sur laquelle est déposée une seconde couche de parylène 32"", de préférence d'environ 2 µm d'épaisseur. Cette protection est accrue lorsque cette seconde couche de parylène, de préférence d'environ 2 µm d'épaisseur est réalisée à partir de parylène N. La couche de polyimide associée à la couche de parylène améliore la protection des éléments sensibles de la batterie de leur environnement (cf. figure 28b). Toutefois, les inventeurs ont observé que cette deuxième couche de recouvrement déposée sur la première couche d'encapsulation, notamment lorsqu'elle est à base de parylène, ne présente pas une stabilité suffisante en présence d'oxygène. Lorsque cette deuxième couche est à base de polyimide, elle ne présente pas une étanchéité suffisante, notamment en présence d'eau. Selon l'invention, elle est revêtue d'une troisième couche, qui la protège contre l'air et améliore la durée de vie du composant électronique ou électrochimique (en l'occurrence de la batterie).

Avantageusement cette troisième couche barrière 33 est choisie également pour résister à une température élevée, et présente une résistance mécanique suffisante pour la protéger lors de l'utilisation ultérieure de l'objet. Avantageusement, l'épaisseur de la troisième couche mince de recouvrement est comprise entre 1 µm et 50 µm. Idéalement, l'épaisseur de la troisième couche mince de recouvrement est d'environ 10-15 µm, une telle gamme d'épaisseur permet de protéger la batterie contre l'endommagement mécanique. L'épaisseur de la troisième couche mince peut être, de préférence, inférieure à 10 µm, préférentiellement inférieure à 5 µm et encore plus préférentiellement d'environ 2 µm.

Cette troisième couche 33 est de préférence à base de résine époxy, de polyéthylène naphtalate (PEN), polyimide, polyamide, polyuréthane ou de silicone. Avantageusement les matériaux utilisés pour réaliser cette troisième couche sont choisis pour faciliter l'assemblage du composant électronique ou électrochimique. Avantageusement, cette troisième couche est déposée par trempage.

Dans ce qui suit, trois variantes du système d'encapsulation selon l'invention seront décrites. Puis, vont être décrits deux modes de réalisation dont chacun peut être combiné avec l'invention ou avec l'une quelconque des trois variantes de l'invention.

### Première variante de l'invention

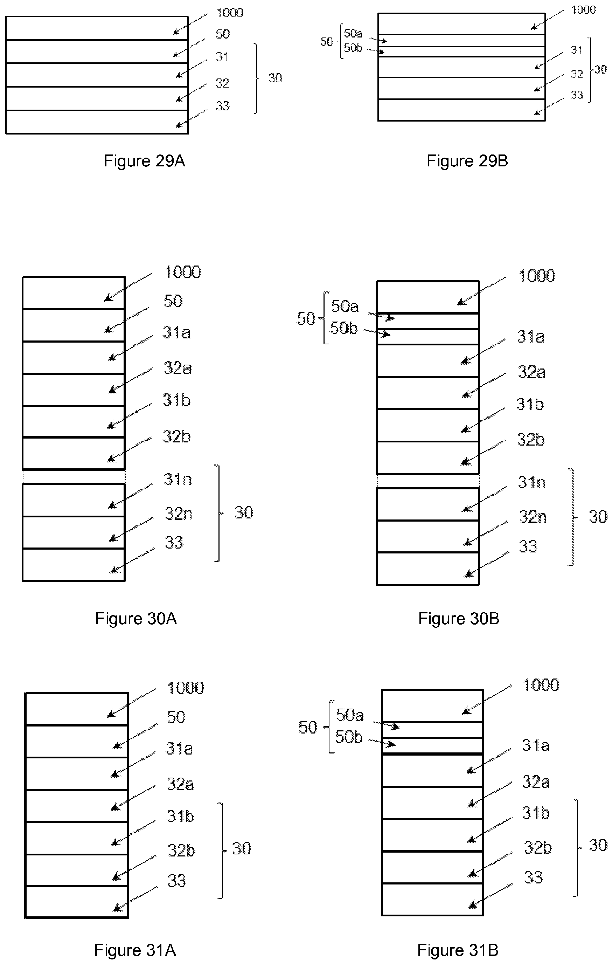

Selon une variante avantageuse de l'invention qui est mis en oeuvre indifféremment avec l'un ou l'autre des modes de réalisation décrits ci-dessous, un prétraitement de l'objet est réalisé avant son encapsulation par le système d'encapsulation selon l'invention (cf. figure 29a). Ce prétraitement de l'objet **1000** consiste à le recouvrir d'une couche polymérique, de préférence à base de polyimide et/ou de parylène, de préférence de parylène, **n**otamment de parylène N afin d'améliorer la protection de l'objet. Cette couche de prétraitement **50** est une couche de recouvrement. Cette couche de prétraitement **50** est avantageusement employée pour protéger des batteries à ions de lithium usitant au moins une électrode poreuse et/ou au moins un électrolyte comprenant une couche inorganique poreuse comme indiqué précédemment et où l'électrode et la couche inorganique poreuse possèdent un réseau interconnecté de pores ouverts dont le diamètre moyen D₅₀ des pores est compris entre 2 nm et 80 nm, de préférence entre 2 nm et 50 nm, préférentiellement entre 6 nm et 30 nm, et encore plus préférentiellement entre 8 nm et 20 nm et dont les pores sont imprégnés par une phase porteuse d'ions de lithium, de préférence par un liquide ionique « nanoconfiné » ou « nanopiégé » dans les porosités. Cette couche de prétraitement **50** sur ce type de batterie à ions de lithium empêche le dégazage éventuel des électrolytes lors de toute manipulation de celle-ci, notamment sous vide et à haute température.

Cette couche de prétraitement **50** permet de réaliser des encapsulations performantes sur des batteries à ions de lithium usitant au moins une électrode poreuse et/ou au moins un électrolyte comprenant une couche inorganique poreuse comme indiqué précédemment, de préférence imprégné(es) par un liquide ionique « nanoconfiné ».

Elle peut être déposée sous vide, par une technique de dépôt chimique en phase vapeur (CVD). Cette couche de prétraitement **50** est avantageusement obtenue à partir de la condensation de monomères gazeux déposés par une technique de dépôt chimique en phase vapeur (CVD) sur les surfaces, ce qui permet d'avoir un recouvrement conformai et uniforme de l'ensemble des surfaces de l'empilement accessibles. Elle permet de suivre les variations de volume de l'objet tel qu'une batterie lors de son fonctionnement et facilite la découpe propre des batteries de par ses propriétés élastiques. De préférence, l'épaisseur de cette couche de prétraitement est comprise entre 1 µm et 50 µm, de préférence comprise entre 2 µm et 10 µm, préférentiellement comprise entre 2 µm et 5 µm et encore plus préférentiellement d'environ 3 µm. Elle permet de recouvrir l'ensemble des surfaces accessibles de l'empilement, de fermer l'ensemble des pores de ces surfaces accessibles et d'uniformiser la nature chimique du substrat. L'encapsulation peut ainsi être réalisée directement sur les empilements, le revêtement pouvant pénétrer dans l'ensemble des cavités disponibles.

Avantageusement, on dépose une couche de parylène comme couche de prétraitement **50**, telle qu'une couche de parylène C, de parylène D, une couche de parylène N (CAS 1633-22-3) ou une couche comprenant un mélange de parylène C, D et/ou N sur l'objet. Le parylène (appelé aussi polyparaxylylène ou poly(p-xylylène)) est un matériau diélectrique, transparent, semi cristallin qui présente une grande stabilité thermodynamique, une excellente résistance aux solvants ainsi qu'une très faible perméabilité. De par ses propriétés, notamment ses propriétés barrières par rapport à l'eau, le parylène contribue à l'isolation de l'objet de son environnement extérieur. Cette couche de parylène protège les éléments sensibles de la batterie de leur environnement. Cette protection est accrue lorsque cette couche de prétraitement est réalisée à partir de parylène N. De manière alternative, on dépose une couche de prétraitement à base de polyimide. Cette couche de polyimide protège les éléments sensibles de la batterie de leur environnement.

De manière alternative et particulièrement avantageuse, la couche de prétraitement **50** est constituée d'une première couche de polyimide **50a**, de préférence d'environ 1 µm d'épaisseur sur laquelle est déposée une seconde couche de parylène **50b**, de préférence d'environ 2 µm d'épaisseur (cf. figure 29b). Cette protection est accrue lorsque cette seconde couche de parylène **50b**, de préférence d'environ 2 µm d'épaisseur est réalisée à partir de parylène N. La couche de polyimide **50a** associée à la couche de parylène **50b** améliore la protection des éléments sensibles de la batterie de leur environnement.

Toutefois, les inventeurs ont observé que cette couche de prétraitement **50**, lorsqu'elle est à base de parylène, ne présente pas une stabilité suffisante en présence d'oxygène. Lorsque cette couche de prétraitement est à base de polyimide, elle ne présente pas une étanchéité suffisante, notamment en présence d'eau. Pour ces raisons on dépose la première couche du système d'encapsulation 31 sur cette couche de prétraitement 50 de manière à ce que la première couche d'encapsulation 31 enrobe la couche de prétraitement **50**. La couche de prétraitement **50** est disposée entre l'objet **1000** et la première couche du système d'encapsulation 31 selon l'invention.

Avantageusement, la première couche d'encapsulation **31** composée d'une matière électriquement isolante, de préférence inorganique, est déposée par une technique de dépôt conformai, telle que le dépôt de couches atomiques (ALD) sur la couche de prétraitement. Ainsi on obtient un recouvrement conformai de l'ensemble des surfaces accessibles de l'empilement préalablement recouvert de la couche de prétraitement ; la première couche est de préférence une couche inorganique. La croissance de la couche déposée par ALD est influencée par la nature du substrat. Une couche déposée par ALD sur un substrat présentant différentes zones de natures chimiques différentes aura une croissance inhomogène, pouvant engendrer une perte d'intégrité de cette couche de protection.

Les techniques de dépôt par ALD sont particulièrement bien adaptées pour recouvrir des surfaces présentant une forte rugosité de manière totalement étanche et conforme. Elles permettent de réaliser des couches conformales, exemptes de défauts, tels que des trous (couches dits « pinhole free », exempts de trous) et représentent de très bonnes barrières. Leur coefficient WVTR est extrêmement faible. Le coefficient WVTR (water vapor transmission rate) permet d'évaluer la perméance à la vapeur d'eau du système d'encapsulation. Plus le coefficient WVTR est faible plus le système d'encapsulation est étanche.

La première couche **31** peut être en matériau céramique, en matériau vitreux ou en matériau vitrocéramique, par exemple sous forme d'oxyde, de type Al₂O₃, de nitrure, de phosphates, d'oxynitrure, ou de siloxane. Cette première couche d'encapsulation **31** présente une épaisseur inférieure à 200 nm, de préférence comprise entre 5 nm et 200 nm, plus préférentiellement comprise entre 10 nm et 100 nm et encore plus préférentiellement de l'ordre d'une cinquantaine de nanomètres. On préfère la déposer par une technique de dépôt conformai, telle que par le dépôt de couches atomiques (ALD).

Cette première couche **31** déposée par ALD sur la couche de prétraitement **50** polymérique permet d'une part, d'assurer l'étanchéité de la structure, i.e. d'empêcher la migration de l'eau à l'intérieur de l'objet et d'autre part de protéger la couche de prétraitement **50**, de préférence de parylène et/ou de polyimide de l'atmosphère, notamment de l'air et de l'humidité, des expositions thermiques afin d'éviter sa dégradation. Cette première couche **31** améliore la durée de vie de la batterie encapsulée.

Toutefois, les couches déposées par ALD sont très fragiles mécaniquement et nécessitent une surface d'appui rigide pour assurer leur rôle protecteur. Le dépôt d'une couche fragile sur une surface souple conduirait à la formation de fissures, engendrant une perte d'intégrité de cette couche de protection.

Avantageusement, une seconde couche d'encapsulation **32** est déposée sur la première couche d'encapsulation **31** pour augmenter la protection des cellules batteries de leur environnement externe. Typiquement, cette deuxième couche **32** est en polymère, par exemple en silicone (déposé par exemple par imprégnation ou par dépôt chimique en phase vapeur assisté par plasma à partir d'hexaméthyldisiloxane (HMDSO)), ou en résine epoxy, ou en parylène, ou en polyimide, de préférence en parylène et/ou en polyimide comme indiqué précédemment. Selon la première variante de l'invention, la seconde couche d'encapsulation **32** est revêtue d'une troisième couche **33**, qui la protège contre l'air et améliore la durée de vie de l'objet (en l'occurrence de la batterie). Avantageusement cette troisième couche barrière **33** est choisie également pour résister à une température élevée, et présente une résistance mécanique suffisante pour la protéger lors de l'utilisation ultérieure de l'objet. Avantageusement, l'épaisseur de la troisième couche mince de recouvrement est comprise entre 1 µm et 50 µm. Idéalement, l'épaisseur de la troisième couche mince de recouvrement est d'environ 10-15 µm, une telle gamme d'épaisseur permet de protéger la batterie contre l'endommagement mécanique. L'épaisseur de la troisième couche mince **33** peut être, de préférence inférieure à 10 µm, préférentiellement inférieure à 5 µm et encore plus préférentiellement d'environ 2 µm.

Cette troisième couche **33** est de préférence à base de résine époxy, de polyéthylène naphtalate (PEN), polyimide, polyamide, polyuréthane ou de silicone. Avantageusement les matériaux utilisés pour réaliser cette troisième couche sont choisis pour faciliter l'assemblage du composant électronique ou électrochimique. Avantageusement, cette troisième couche **33** est déposée par trempage.

### Seconde variante de l'invention

Cette seconde variante avantageuse de l'invention peut être mise en oeuvre indifféremment avec l'un ou l'autre des modes de réalisation décrits ci-dessous.

Selon une seconde variante de l'invention, l'objet peut être encapsulé par une succession alternée de couches de parylène et/ou de polyimide, d'épaisseur comprise entre 2 µm et 10 µm, préférentiellement comprise entre 2 µm et 5 µm et encore plus préférentiellement d'environ 3 µm, et de couches composées d'une matière électriquement isolante d'épaisseur comprise entre 10 nm et 100 nm, de préférence d'environ 50 nm, telles que des couches inorganiques déposées de manière conformale, de préférence par ALD, comme décrit précédemment pour créer un système d'encapsulation multi-couches.

Afin d'améliorer les performances de l'encapsulation, un prétraitement de l'objet peut être réalisé avant son encapsulation par le système d'encapsulation selon l'invention. Ce prétraitement de l'objet consiste à recouvrir l'objet d'une couche polymérique (couche de prétraitement **50**), de préférence à base de polyimide et/ou de parylène, de préférence de parylène, notamment de parylène N afin d'améliorer la protection de l'objet comme indiqué dans la première variante.

Avantageusement, on peut déposer une couche de parylène comme couche de prétraitement **50**, telle qu'une couche de parylène C, de parylène D, une couche de parylène N (CAS 1633-22-3) ou une couche comprenant un mélange de parylène C, D et/ou N sur l'objet. De par ses propriétés, notamment ses propriétés barrières par rapport à l'eau, le parylène contribue à l'isolation de l'objet de son environnement extérieur. Cette couche de parylène protège les éléments sensibles de la batterie de leur environnement. Cette protection est accrue lorsque cette couche de prétraitement **50** est réalisée à partir de parylène N.
De manière alternative, on peut déposer une couche de prétraitement **50** à base de polyimide. Cette couche de polyimide protège les éléments sensibles de la batterie de leur environnement.
De manière alternative et particulièrement avantageuse, la couche de prétraitement **50** est constituée d'une première couche de polyimide **50a**, de préférence d'environ 1 µm d'épaisseur sur laquelle est déposée une seconde couche de parylène 50b, de préférence d'environ 2 µm d'épaisseur. Cette protection est accrue lorsque cette seconde couche de parylène, de préférence d'environ 2 µm d'épaisseur est réalisée à partir de parylène N. La couche de polyimide associée à la couche de parylène améliore la protection des éléments sensibles de la batterie de leur environnement.

L'objet ainsi recouvert par cette couche de prétraitement **50** est ensuite recouvert par une succession alternée d'au moins une première couche **31a** composée d'une matière électriquement isolante, de préférence une couche inorganique, ayant de préférence une épaisseur comprise entre 10 nm et 100 nm, de préférence d'environ 50 nm, déposée de manière conformale par ALD et d'au moins une seconde couche du système d'encapsulation **32a** selon l'invention, de préférence à base de parylène et/ou de polyimide, de préférence d'environ 3 µm d'épaisseur déposée sur au moins la première couche **31a.**

Avantageusement, une troisième couche d'encapsulation 33 est déposée sur cette succession alternée d'au moins une première couche 31a, **31b, 31n** et d'au moins une seconde couche 32a, 32b, 32n du système d'encapsulation selon l'invention, de manière à ce que l'objet soit encapsulé dans le système d'encapsulation 30 selon l'invention comprenant les trois couches successives précédemment énoncées (cf. figures 30a et 30b). Avantageusement, la troisième couche d'encapsulation 33 permet d'augmenter la protection des cellules batteries de leur environnement externe et de les protéger contre l'endommagement mécanique. Cette troisième et dernière couche d'encapsulation 33 présente une épaisseur d'environ 10-15 µm. Typiquement, cette troisième et dernière couche est en polymère, par exemple en silicone (déposé par exemple par trempage ou par dépôt chimique en phase vapeur assisté par plasma à partir d'hexaméthyldisiloxane (HMDSO)), ou en résine epoxy, ou en polyimide, ou en parylène. Par exemple, on peut déposer par injection une couche de silicone (épaisseur typique environ 15 µm) pour protéger la batterie contre l'endommagement mécanique. Le choix d'un tel matériau vient du fait qu'il résiste à des températures élevées et la batterie peut ainsi être assemblée aisément par soudure sur des cartes électroniques sans apparition de transitions vitreuses.

### Troisième variante de l'invention

Cette troisième variante avantageuse de l'invention peut être mise en oeuvre indifféremment avec l'un ou l'autre des modes de réalisation décrits ci-dessous.

Avantageusement, l'objet est recouvert par une couche de prétraitement **50** comme indiqué précédemment, puis est ensuite recouvert par une succession alternée d'une première couche **31a** composée d'une matière électriquement isolante, de préférence une couche inorganique, ayant de préférence une épaisseur comprise entre 10 nm et 100 nm, de préférence d'environ 50 nm, déposée de manière conformale par ALD, puis d'une seconde couche **32a**, de préférence à base de parylène et/ou de polyimide comme indiqué précédemment dans le cadre des variantes précédentes, de préférence d'environ 3 µm d'épaisseur déposée sur au moins la première couche, puis d'une nouvelle première couche **31b** composée d'une matière électriquement isolante, de préférence une couche inorganique, ayant de préférence une épaisseur comprise entre 10 nm et 100 nm, de préférence d'environ 50 nm, déposée de manière conformale par ALD sur la seconde couche **32a**, puis d'une nouvelle seconde couche **32b**, de préférence à base de parylène et/ou de polyimide, de préférence d'environ 3 µm d'épaisseur déposée sur au moins la nouvelle première couche **31b.** L'objet ainsi recouvert est ensuite revêtu d'une dernière couche correspondant à la troisième couche du système d'encapsulation **33** selon l'invention (cf. figures 31a et 31b). Typiquement, cette troisième et dernière couche est en polymère, par exemple en silicone (déposé par exemple par trempage ou par dépôt chimique en phase vapeur assisté par plasma à partir d'hexaméthyldisiloxane (HMDSO)), ou en résine epoxy, ou en polyimide, ou en parylène. Avantageusement, l'épaisseur de la troisième couche du système d'encapsulation **33** est comprise entre 1 µm et 50 µm. Idéalement, l'épaisseur de la troisième couche mince de recouvrement 33 est d'environ 10-15 µm, une telle gamme d'épaisseur permet de protéger la batterie contre l'endommagement mécanique. L'épaisseur de la troisième couche mince **33** peut être, de préférence, inférieure à 10 µm, préférentiellement inférieure à 5 µm et encore plus préférentiellement d'environ 2 µm surtout lorsque l'on cherche à minimiser la taille de la batterie et à conserver une bonne protection de la batterie contre l'endommagement mécanique. Cette succession de couches permet d'accroitre notablement la protection de l'objet tout en conservant une épaisseur relativement faible.

### Superposition primaire de feuilles d'anode et de feuilles de cathode/ empilement d'anode et de cathode

Avantageusement, l'objet protégé par le système d'encapsulation selon l'invention est une batterie et de préférence une batterie entièrement solide ou quasi-solide comme indiqué ci-après.

Dans la présente description, on entend par batterie « entièrement solide » (appelée aussi ici « tout solide »), une batterie comprenant au moins une couche mince de cathode, une couche mince d'anode et une couche mince d'électrolyte solide, chacune des couches minces présentant un très faible nombre de pores.

Dans la présente demande, une cellule élémentaire d'une batterie, de préférence une batterie entièrement solide comprend, de manière alternée, une anode et une cathode, chacune éventuellement constituée d'un empilement de couches minces. L'anode comprend au moins une couche mince d'un matériau actif d'anode et éventuellement une couche mince d'un matériau d'électrolyte. La cathode comprend au moins une couche mince d'un matériau actif de cathode et éventuellement une couche mince d'un matériau d'électrolyte de sorte que la cellule élémentaire d'une batterie, de préférence une batterie entièrement solide comprenne successivement au moins une couche mince d'un matériau actif d'anode, au moins une couche mince d'un matériau d'électrolyte et au moins une couche mince d'un matériau actif de cathode.

Lorsque la batterie est obtenue à partir d'une succession alternée d'au moins une anode et d'au moins une cathode, l'anode comprend avantageusement, successivement :
- éventuellement une couche mince d'un matériau d'électrolyte,
- une couche mince d'un matériau actif d'anode,
- une couche mince métallique,
- une couche mince d'un matériau actif d'anode, et
- éventuellement, une couche mince d'un matériau d'électrolyte.

Dans la présente demande, le terme « feuille d'anode » sera employé pour désigner cette succession de couche utilisable pour réaliser une superposition primaire à partir de laquelle au moins une batterie unitaire sera obtenue ultérieurement, de préférence plusieurs batteries unitaires.

De la même manière, la cathode comprend avantageusement et successivement :
- éventuellement une couche mince d'un matériau d'électrolyte,
- une couche mince d'un matériau actif de cathode,
- une couche mince métallique,
- une couche mince d'un matériau actif de cathode, et
- éventuellement, une couche mince d'un matériau d'électrolyte,
de sorte qu'une batterie, de préférence une batterie entièrement solide comprenne successivement au moins une couche mince d'un matériau actif d'anode, au moins une couche mince d'un matériau d'électrolyte et au moins une couche mince d'un matériau actif de cathode.

Dans le cadre de la présente invention l'épaisseur de chacune des couches minces présentes au sein de la batterie, est inférieure à 10 µm et préférentiellement inférieure à 5 µm.

Dans la présente demande, le terme « feuille de cathode » sera employé pour désigner cette succession de couches utilisable pour réaliser une superposition primaire. La superposition primaire comprend une succession alternée de feuilles de cathode et de feuilles d'anode, à partir de laquelle au moins une batterie unitaire comprenant un empilement d'au moins une anode et d'au moins une cathode sera obtenue ultérieurement, de préférence plusieurs batteries unitaires. Deux feuilles adjacentes de cette superposition primaire définissent au moins une région en saillie, destinée à former une zone de connexion accessible, ainsi qu'au moins une région en retrait, destinée à former une zone de recouvrement, i.e. une zone recouverte par le système d'encapsulation ou par l'une des trois variantes du système d'encapsulation. Ces régions en saillie et en retrait seront explicitées en plus grand détail au regard de deux modes de réalisation, qui ne limitent pas l'invention.

La présente invention concerne en particulier l'encapsulation des batteries à ions de lithium entièrement solides. La présente invention concerne aussi l'encapsulation des batteries à ions de lithium employant au moins une électrode poreuse et/ou au moins un électrolyte comprenant une couche inorganique poreuse, l'électrode et la couche inorganique poreuse possédant un réseau interconnecté de pores ouverts dont le diamètre moyen D50 des pores est compris entre 2 nm et 80 nm, de préférence entre 2 nm et 50 nm, préférentiellement entre 6 nm et 30 nm, et encore plus préférentiellement entre 8 nm et 20 nm et dont les pores, de par leur taille, sont capables d'absorber une phase liquide par simple capillarité et sont imprégnés par une phase porteuse d'ions de lithium, i.e. par un électrolyte, telle qu'une solution formée par un sel de lithium dissout dans un solvant organique ou un mélange de solvants organiques, et/ou comprenant un polymère contenant au moins un sel de lithium possiblement dissout dans un solvant organique ou un mélange de solvants organiques, et/ou comprenant au moins un liquide ionique contenant au moins un sel de lithium possiblement dissout dans un solvant organique ou un mélange de solvants organiques. La phase liquide « nanoconfinée » ou « nanopiégée » dans les porosités, de préférence dans les mésoporosités, ne peut plus ressortir. Cette batterie comprenant une telle électrode poreuse et/ou un tel électrolyte est alors considérée comme quasi-solide. Selon l'invention, le système d'encapsulation selon l'invention ne peut être utilisé sur des batteries à ions de lithium employant des séparateurs car elles ne sont pas suffisamment rigides pour subir des traitements sous vide sans être dégradées.

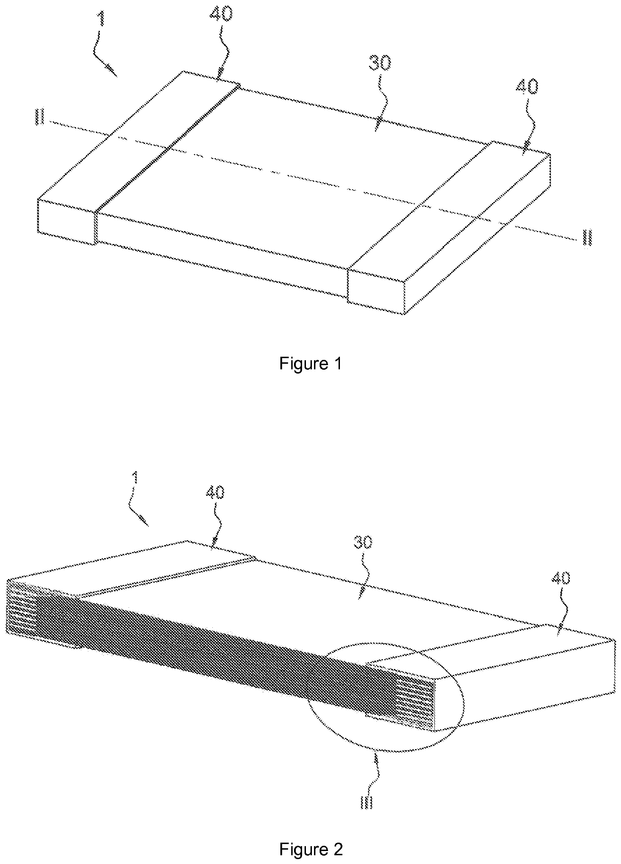

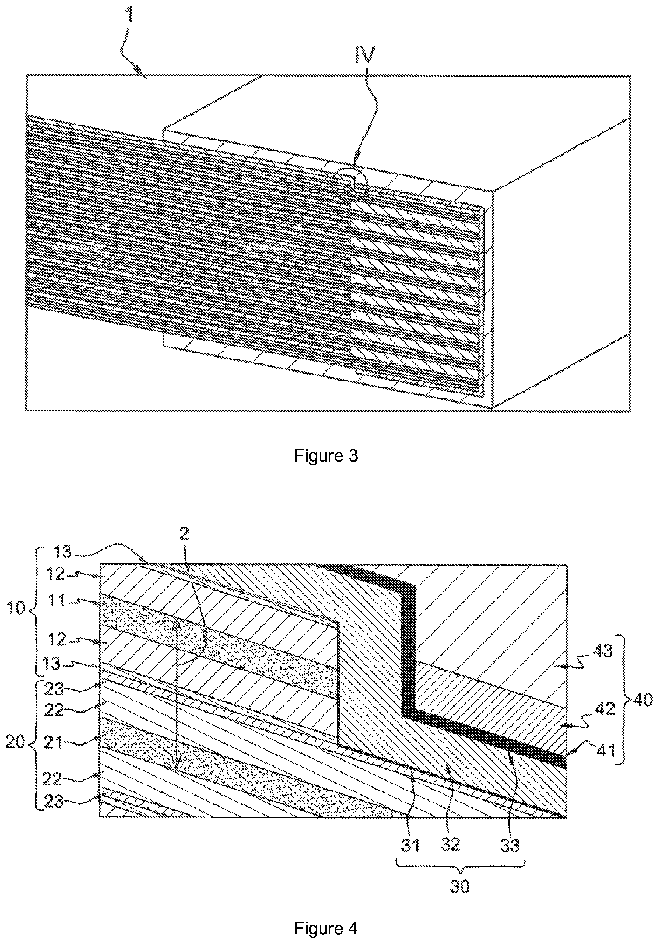

Les batteries entièrement solides **1** présentent une structure monobloc rigide sur laquelle on peut déposer un système d'encapsulation **30** (cf. figure 1). La figure 3, tout comme la figure 2, est une vue en perspective avec arrachement d'une batterie entièrement solide **1**. Elle fait apparaitre la structure interne de l'élément central comprenant un assemblage de cellules élémentaires **2** recouvert par un système d'encapsulation **30** selon l'invention et celle des terminaisons **40**. La figure 4 représente en plus grand détail une batterie entièrement solide comprenant une anode **10** et une cathode **20**, chacune constituée d'un empilement de couches minces. L'anode comprend successivement une couche mince d'un matériau d'électrolyte **13**, une couche mince d'un matériau actif d'anode **12** tel que du Li₄Ti₅O₁₂, une couche mince métallique **11** (par exemple en inox), une couche mince d'un matériau actif d'anode tel que du Li₄Ti₅O₁₂ **12** et une couche mince d'un matériau d'électrolyte **13**.

La cathode **20** comprend successivement une couche mince d'un matériau d'électrolyte 23, une couche mince d'un matériau actif de cathode **22** tel que du LiMn₂O₄, une couche mince métallique 21 (par exemple en inox), une couche mince d'un matériau actif de cathode **22** tel que du LiMn₂O₄) et une couche mince d'un matériau d'électrolyte **23**, étant entendu que la batterie comprend une succession alternée d'au moins une anode **10** et d'au moins une cathode **20** dont deux feuilles adjacentes définissent au moins une région en saillie, destinée à former une zone de connexion accessible et au moins une région en retrait, destinée à former une zone de recouvrement, i.e. zone recouverte par le système d'encapsulation.

Cette batterie est constituée d'un assemblage de plusieurs cellules élémentaires connectées en parallèle, est formée à partir de films minces d'anode et de cathode élaborés de préférence à partir de matériaux stables dimensionnellement pendant les étapes de charge et décharge de la batterie.

Parmi les matériaux actifs d'anode pouvant être utilisés pour réaliser une telle fonction on peut citer les matériaux à insertion de type Li₄Ti₅O₁₂, certain des nitrures de type Li₃₋ₓMₓN dans une plage d'insertion en lithium limitée, ainsi que d'autres anodes de type Li_{y}SiTON ou Sn₃N₄.

Les matériaux à insertion de lithium utilisés pour réaliser les cathodes sont souvent beaucoup plus stables dimensionnellement que les matériaux d'anode. Les oxydes avec une structure spinelle comme le LiMn₂O₄, LiMn_{1,5}Ni_{0,5}O₄, ainsi que les structures de type olivine comme le LiFePO₄ sont particulièrement stables dimensionnellement, et leur utilisation est préférée dans le cadre de la présente invention.

De la même manière, ces matériaux actifs d'anode et de cathode sont assemblés à l'aide d'électrolytes solides afin d'assurer une surface rigide et stable pour l'encapsulation et éviter le risque de détérioration de cette dernière pendant les cycles d'utilisation de la batterie. Ces électrolytes solides peuvent être des polymères, des céramiques, des verres, vitrocéramiques et/ou des matériaux hybrides composés à la fois d'une partie organique et inorganique.

Pour assurer une excellente protection contre les gaz de l'atmosphère, il est nécessaire d'avoir un film protecteur qui ait un WVTR extrêmement faible. Selon l'état de la technique, les meilleures protections sont offertes par les films métalliques, cependant ces derniers ne peuvent pas recouvrir l'intégralité de la batterie sans mettre les électrodes en court-circuit.

Après l'étape d'empilement (cf. figures 4, 7 et 15) et avant l'ajout des terminaisons, l'empilement est encapsulé dans un système d'encapsulation selon l'invention permettant d'assurer la protection de la batterie vis-à-vis de l'atmosphère.

### Système d'encapsulation

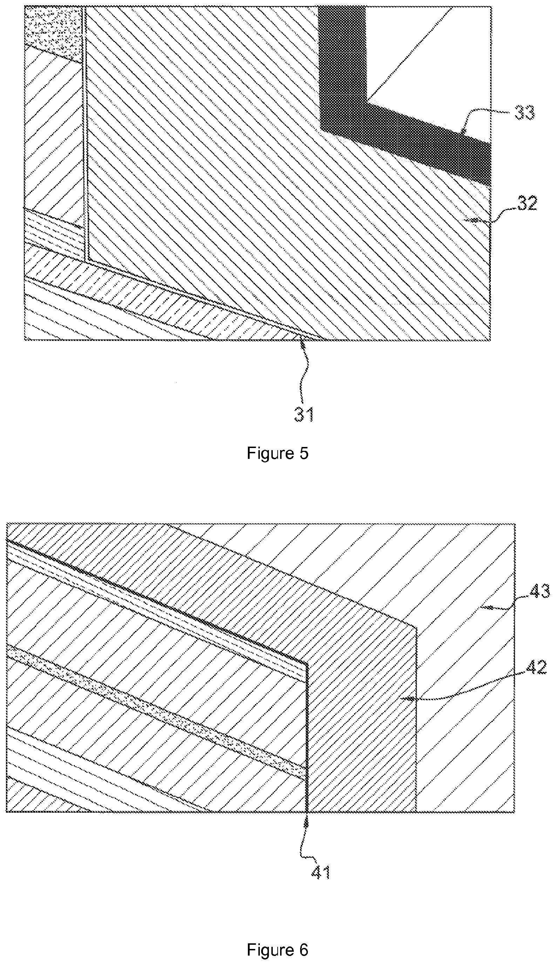

La qualité de l'encapsulation est d'une importance capitale pour les batteries aux ions de lithium. Le système d'encapsulation **30** selon l'invention est stable chimiquement, résiste à une température élevée, offre une protection contre l'humidité et est imperméable à l'atmosphère pour jouer sa fonction de couche barrière. Il est constitué de plusieurs couches déposées successivement sur l'empilement (cf. figures 5, 8, 27a, 27b, 28a, 28b, 29a, 29b, 30a et 30b), comme décrit ci-dessus.

Pour ce faire, le système d'encapsulation selon l'invention est constitué de plusieurs couches déposées successivement sur l'objet, notamment sur les parties de l'objet nécessitant d'être protégées.

Ce système d'encapsulation permet une isolation électrique et une étanchéité des composants électroniques ou batteries tout en assurant la possibilité de pouvoir ultérieurement les connecter électriquement entre eux/elles et/ou avec des points de connexion externes. Ce système d'encapsulation peut aussi être réalisé selon la première, la deuxième ou la troisième variante de l'invention.

### Terminaisons

Après l'étape d'encapsulation du composant électronique ou électrochimique tel qu'une batterie par le système d'encapsulation ou l'une quelconque de ses variantes, des terminaisons sont ajoutées pour établir les contacts électriques nécessaires au bon fonctionnement dudit composant.

Les terminaisons décrites ci-après peuvent être réalisées sur des composants électroniques ou électrochimiques tels qu'une batterie, obtenus selon le premier ou le deuxième mode de réalisation, et enrobés par le système d'encapsulation selon l'invention ou l'une quelconque de ses variantes, et ce, dans la mesure où ces combinaisons sont possibles ou envisageables pour l'homme du métier.

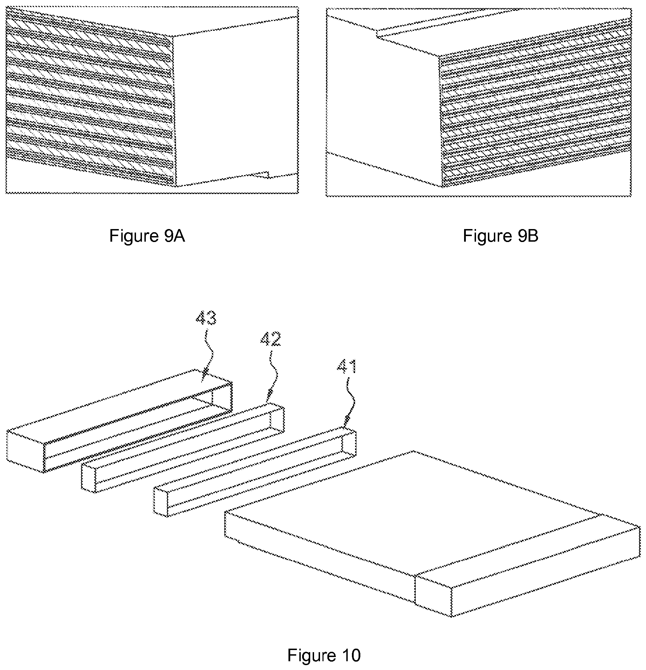

Pour réaliser les terminaisons **40**, l'empilement enrobé par le système d'encapsulation ou l'une quelconque de ses variantes est découpé suivant des plans de coupe permettant d'obtenir des composants de batterie unitaires, avec la mise à nue sur chacun des plans de coupe des connexions (+) et (-) de la batterie, notamment dans les régions en saillie, de sorte que le système d'encapsulation revêt quatre des six faces de ladite batterie, de préférence de manière continue, afin que le système puisse être assemblé sans soudure, les deux autres faces de la batterie étant revêtues ultérieurement par les terminaisons. Avantageusement, la batterie comprend des terminaisons au niveau où les collecteurs de courant cathodique, respectivement anodique, sont apparents. De préférence, les connexions anodiques et les connexions cathodiques se trouvent sur les côtés opposés de l'empilement. Sur et autour de ces connexions est déposé un système de terminaison (cf. figure 6). Les connexions peuvent ensuite être métallisées à l'aide de techniques de dépôt plasma connu de l'homme du métier, de préférence par ALD (cf. figure 6 ou figure 10, repère **41**) et / ou par immersion dans une résine époxy conductrice (chargée à l'argent - (cf. figure 6 ou figure 10, repère **42**) et / ou un bain d'étain en fusion (cf. figure 6 ou figure 10, repère **43**) ou par dépôt électrolytique. De préférence, les terminaisons sont constituées d'un empilement de couches comprenant successivement une première couche mince de recouvrement métallique déposée par ALD **41**, une deuxième couche en résine époxy chargée en argent **42** déposée sur la première couche et une troisième couche à base d'étain 43 déposée sur la deuxième couche.

La première couche conductrice déposée par ALD **41** sert à protéger la section de la batterie de l'humidité. Cette première couche conductrice déposée par ALD est optionnelle. Elle permet d'augmenter la durée de vie calendaire de la batterie en réduisant le WVTR au niveau de la terminaison. La seconde couche en résine époxy chargée en argent **42**, permet de procurer de la « souplesse » à la connectique sans rompre le contact électrique lorsque le circuit électrique est soumis à des contraintes thermiques et/ou vibratoires.

La troisième couche de métallisation à base d'étain **43** sert à réduire le WVTR, ce qui augmente la durée de vie de la batterie.

Dans un autre mode de réalisation, cette troisième couche peut être composée de deux couches de matériaux différents. Une première couche **43a** venant au contact de la couche en résine époxy chargée en argent **42**. Cette couche est en nickel **43a** et est réalisée par dépôt électrolytique. La couche en nickel sert de barrière thermique et protège le reste du composant de la diffusion pendant les étapes d'assemblage par refusion. La dernière couche **43b**, déposée sur la couche en nickel **43a** est également une couche de métallisation, préférentiellement en étain pour rendre l'interface compatible des assemblages par refusion. Cette couche en étain peut être déposée soit par trempage dans un bain d'étain fondu soit par électrodéposition ; ces techniques sont connues en tant que telles.

Pour certains assemblages sur des pistes en cuivre par microcâblage, il peut être nécessaire d'avoir une dernière couche **43b** de métallisation en cuivre. Une telle couche peut être réalisée par électrodéposition à la place de l'étain.

Dans un autre mode de réalisation, les terminaisons peuvent être constituées d'un empilement de couches comprenant successivement une couche en résine époxy chargée en argent **42** et une deuxième couche à base d'étain ou de nickel 43 déposée sur la première couche.

Dans un autre mode de réalisation, les terminaisons peuvent être constituées d'un empilement de couches comprenant successivement une couche de polymère conducteur telle qu'une couche en résine époxy chargée en argent **42,** une deuxième couche à base de nickel **43a** déposée sur la première couche et une troisième couche à base d'étain ou de cuivre **43b.**

Dans un mode de réalisation préférentiel, les terminaisons peuvent être constituées de différentes couches qui sont respectivement, de manière non limitative, une couche de polymère conducteur tel qu'une résine époxy chargée à l'argent, une couche de nickel et une couche d'étain.

Les terminaisons permettent de reprendre les connections électriques alternativement positives et négatives sur chacune des extrémités de la batterie. Ces terminaisons permettent de réaliser les connections électriques en parallèle entre les différents éléments de batterie. Pour cela, seule les connections (+) sortent sur une extrémité (région en saillie), et les (-) sont disponibles sur les autres extrémités (autres régions en saillie).

On va maintenant décrire un premier mode de réalisation, combinable avec le système d'encapsulation selon l'invention ou l'une quelconque de ses variantes.

### Description du procédé de fabrication d'une batterie, de préférence une batterie entièrement solide selon un premier mode de réalisation

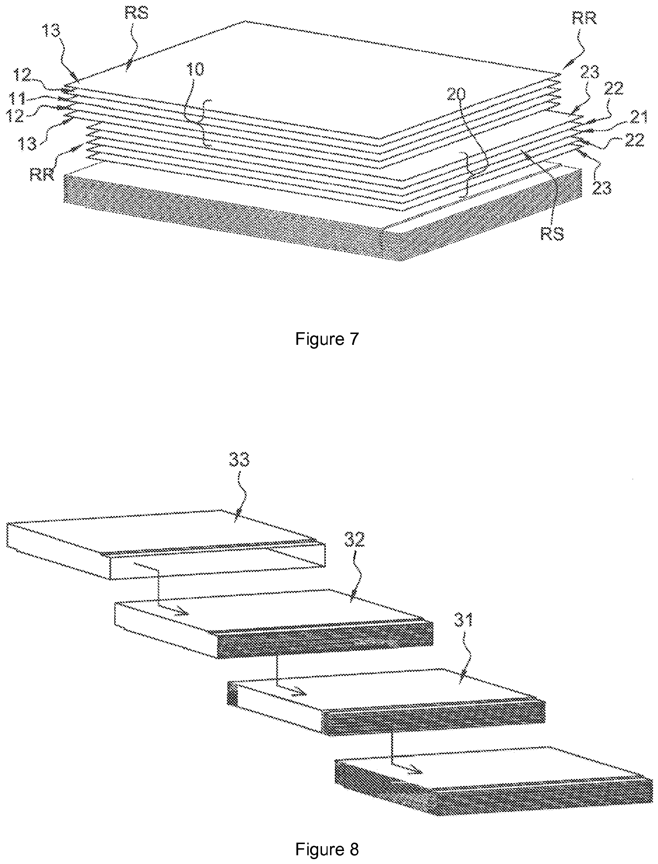

La figure 7 représente selon un premier mode de réalisation, tout comme la figure 4, une batterie entièrement solide comprenant des anodes **10** et des cathodes **20**, chacune constituée d'un empilement de couches minces ; les anodes et les cathodes sont décalées latéralement de manière à former des régions en saillie **RS**, destinée à former une zone de connexion accessible et des régions en retrait **RR**, destinée à former une zone de recouvrement, .i.e. zone recouverte par le système d'encapsulation.

Dans ce premier mode de réalisation et avantageusement, l'encapsulation de la batterie est réalisée sur quatre des six faces de l'empilement étant entendu que les sections de cathode apparaissant sur une première face et les sections d'anode apparaissant sur une deuxième face ne sont pas recouvertes par ce système d'encapsulation de manière à faciliter la collection de courant sur les côtés latéraux. Les couches d'encapsulation entourent la périphérie de l'empilement, le reste de la protection à l'atmosphère étant assuré par les couches obtenues par les terminaisons.

De manière préférentielle les connections cathodiques et anodiques sont décalées latéralement, ce qui permet à la couche d'encapsulation de fonctionner comme diélectrique pour éviter la présence de court-circuit sur ces extrémités.

Une fois l'empilement réalisé, et après l'étape d'encapsulation de l'empilement, des terminaisons (contacts électriques, cf. figure 6, référence **40)** sont ajoutées au niveau où les collecteurs de courant cathodiques, respectivement anodiques sont apparents (non revêtus d'électrolyte isolant). Ces zones de contact peuvent être sur les côtés opposés de l'empilement pour collecter le courant (collecteurs de courant latéraux) ou sur des côtés adjacents (cf. figure 9A et figure 9 B).

Avantageusement, la batterie selon l'invention obtenue à partir d'une superposition primaire, comprenant une succession alternée de feuilles d'anode et de feuilles de cathode comme indiqué précédemment, est caractérisée en ce que ledit système d'encapsulation ou l'une quelconque des variantes 1 à 3 dudit système d'encapsulation selon l'invention revêt totalement quatre des six faces de ladite batterie et partiellement les deux faces restantes latéralement opposées, les dites deux faces restantes étant partiellement revêtues par au moins ladite première couche de recouvrement (31,31') et au moins ladite deuxième couche (32,32') et les dites deux faces restantes comprenant une zone de connexion anodique et une zone de connexion cathodique. La troisième couche de recouvrement dudit système d'encapsulation pénètre difficilement dans la superposition primaire. Par conséquent, cette troisième couche recouvre difficilement les deux faces restantes latéralement opposées.

### Procédé de fabrication simultanée de plusieurs batteries

### Premier mode de réalisation

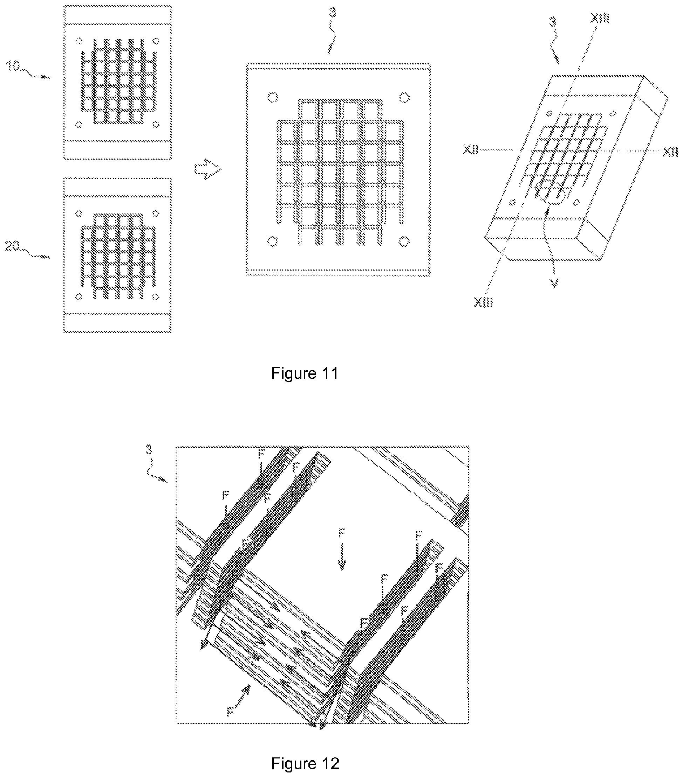

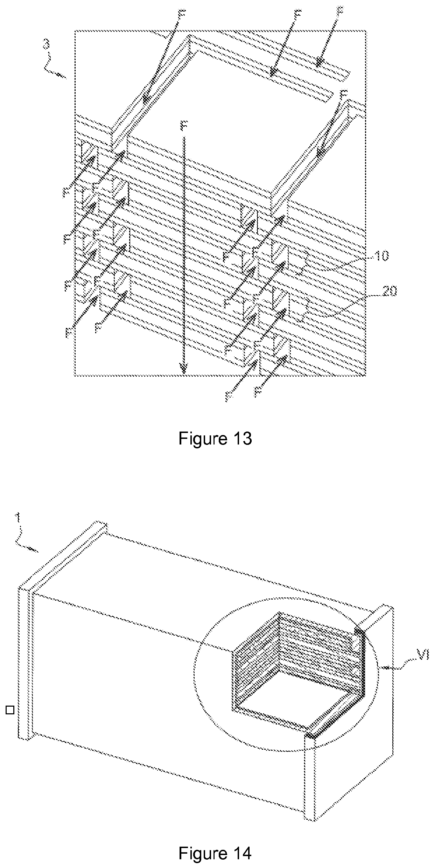

Afin d'accroitre le rendement de production des batteries, de préférence des batteries entièrement solides, la fabrication simultanée de plusieurs batteries entièrement solides peut être réalisée à partir d'une superposition primaire de feuilles alternées comprenant entre plusieurs dizaines et plusieurs centaines d'anodes délimitées suivant un plan de coupe en forme de U et de feuilles comprenant entre plusieurs dizaines et plusieurs centaines de cathodes délimitées suivant un plan de coupe en forme de U (cf. figure 11, premier mode de réalisation). Toutes ces feuilles présentent des perforations à leurs quatre extrémités de manière à ce que lorsque ces perforations sont superposées, toutes les cathodes et toutes les anodes de ces feuilles sont superposées et décalées latéralement (cf. figures 12 et 13, premier mode de réalisation).

L'encapsulation est ensuite réalisée comme décrit précédemment suivant les flèches (F) présentes sur les figures 12 et 13. Ces flèches indiquent les zones recouvertes par le système d'encapsulation selon l'invention (régions en retrait). Le système d'encapsulation selon l'invention remplit l'espace présent dans les découpes en forme de U positionnées façon tête bêche et décalés comme présentées sur les figures 12 et 13. Avantageusement, la superposition primaire de feuilles d'anode et de feuilles de cathode peut être recouverte du système d'encapsulation selon la première ou la deuxième ou la troisième variante comme indiqué précédemment.

La superposition primaire de feuilles d'anode et de cathode ainsi enrobée est ensuite découpée par tout moyen approprié de manière à mettre à nu les collecteurs de courant anodiques et cathodiques et à obtenir des batteries unitaires.

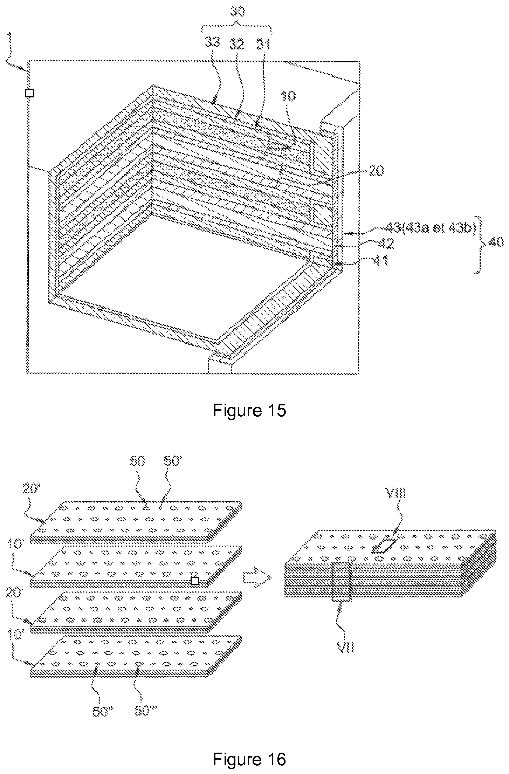

Des terminaisons (contacts électriques, cf. figure 15, référence **40, 41'**, **42'** et **43'**) sont ajoutées au niveau où les collecteurs de courant cathodiques, respectivement anodiques sont apparents (non revêtus d'électrolyte isolant). Ces zones de contact sont, de préférence, disposées sur les côtés opposés de l'empilement de la batterie pour collecter le courant (collecteurs de courant latéraux) ou sur des côtés adjacents.

On va maintenant décrire un second mode de réalisation, combinable avec le système d'encapsulation selon l'invention ou l'une quelconque de ses variantes.

### Second mode de réalisation

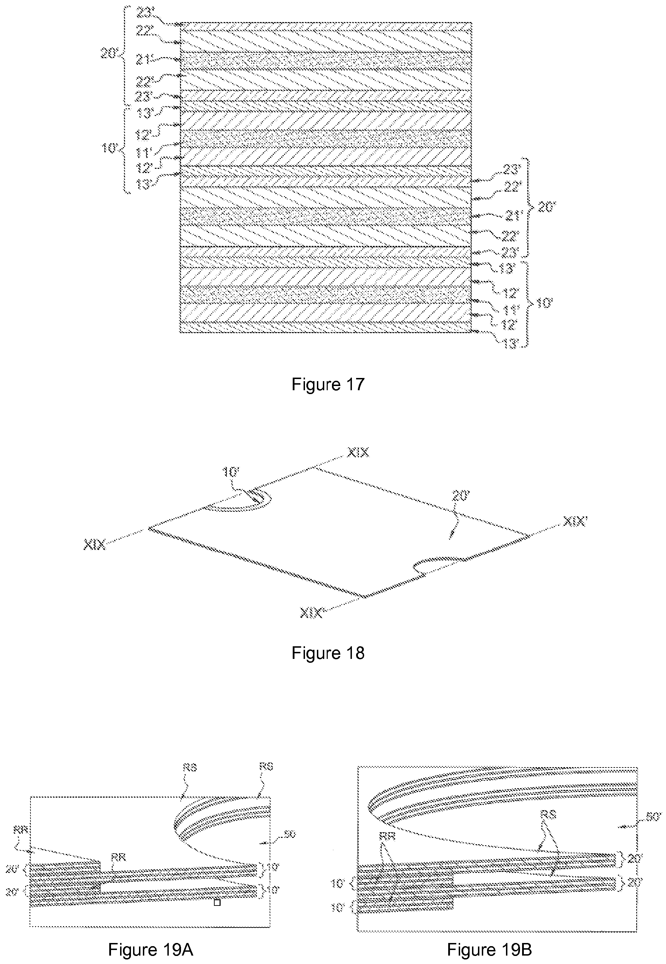

Dans un autre mode de réalisation, la fabrication simultanée de plusieurs batteries, de préférence de plusieurs batteries entièrement solides peut être réalisée à partir d'une superposition primaire alternative de feuilles comprenant entre plusieurs dizaines et plusieurs centaines d'anodes **10'** présentant des échancrures **50, 50'** et de feuilles comprenant entre plusieurs dizaines et plusieurs centaines de cathodes **20'** présentant des échancrures **50"**, **50'''.** Toutes ces feuilles présentent des échancrures, de préférence des orifices ou trous concentriques de manière à ce que lorsque ces perforations sont superposées, toutes les cathodes et toutes les anodes de ces feuilles définissent au moins une région en saillie **RS**, destinée à former une zone de connexion accessible, ainsi qu'au moins une région en retrait **RR**, destinée à former une zone de recouvrement, i.e. zone recouverte par le système d'encapsulation (cf. figures 16, 17, 18 et 19). Sur la figure 16, chaque feuille d'anode comprend une succession alternative de trous de diamètres D₁ et D₂ où D₂ est un diamètre inférieur à D₁ et chaque feuille de cathode comprend une succession alternative de trous de diamètres D₂ et D₁ où D₂ est un diamètre inférieur à D₁, de manière à ce que les trous présents sur les feuilles d'anode de diamètre D₁ (respectivement D₂) et de cathode de diamètre D₂ (respectivement D₁) soient concentriques. La figure 19 représente une vue en perspective analogue à la figure 16 illustrant à plus grande échelle la superposition primaire de feuilles d'anode et de feuilles de cathode, et notamment la superposition des trous concentriques de diamètres différents D₁ et D₂ présents sur ces feuilles mettant en exergue les régions en saillie et les régions en retrait.

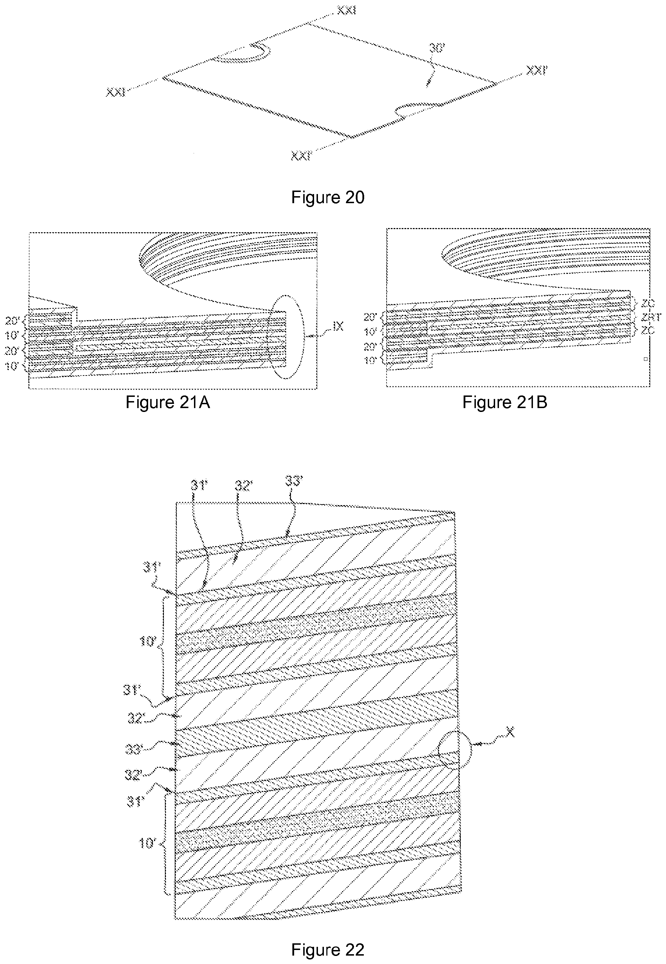

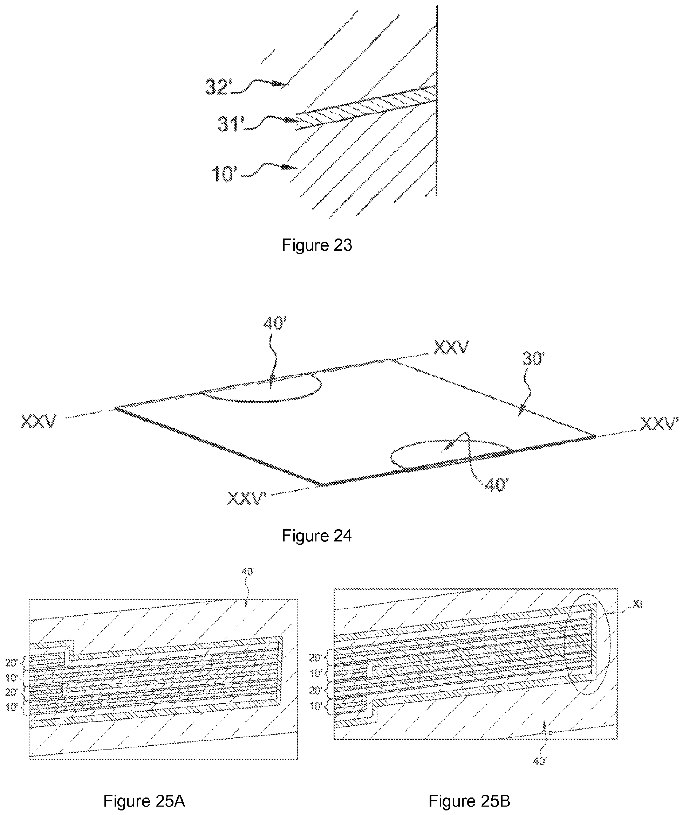

La superposition primaire de feuilles d'anode et de feuilles de cathode est ensuite recouverte du système d'encapsulation selon l'invention comprenant :
- une première couche de recouvrement du système d'encapsulation **31**', identique à la première couche de recouvrement du système d'encapsulation **31** et déposée sur l'empilement par un procédé de dépôt par couche atomique,
- une seconde couche d'encapsulation **32**' comparable à la seconde couche d'encapsulation **32** déposée sur la première couche d'encapsulation afin d'améliorer la protection des cellules des batteries de leur environnement externe,
- une troisième couche **33** comparable à la troisième couche **33'** déposée sur la deuxième couche d'encapsulation (cf. figure 22 et 23).

De manière alternative, la superposition primaire de feuilles d'anode et de feuilles de cathode peut être recouverte du système d'encapsulation selon la première ou la deuxième ou la troisième variante comme indiqué précédemment.

La superposition primaire de feuilles d'anode et de cathode ainsi enrobée est ensuite perforée au niveau des perforations concentriques par tout moyen approprié de manière à ce que le diamètre de ces nouvelles perforations soit compris entre D₁ et D₂ et ainsi laisse apparaitre pour chaque trou, soit les connexions anodiques soit les connexions cathodiques, i.e. les connexions (+) et (-) de la batterie (cf. figures 21A et 21B) afin de faciliter la collection de courant dans les trous concentriques latéraux.

Après découpe dite tertiaire, dans une partie médiane de ladite superposition primaire, des batteries unitaires sont obtenues (cf. figure 20) et des terminaisons (contacts électriques, cf. figure 24, référence **40**, figure 27 référence **41', 42**' et **43**') sont ajoutées au niveau où les collecteurs de courant cathodiques, respectivement anodiques sont apparents (non revêtus d'électrolyte isolant). Ces zones de contact sont, de préférence, disposées sur les côtés opposés de l'empilement de la batterie pour collecter le courant (collecteurs de courant latéraux) ou sur des côtés adjacents (cf. figures 24, 25 à 27).

Les connexions sont métallisées à l'aide de techniques de dépôt plasma connu de l'homme du métier, de préférence par ALD (cf. figure 27, repère **41'**) et / ou par immersion dans une résine époxy conductrice chargée à l'argent - (cf. figure 27, repère **42'**) et / ou un bain d'étain en fusion (cf. figure 27, repère **43'**). De préférence, les terminaisons sont constituées d'un empilement de couches comprenant successivement une première couche mince de recouvrement métallique déposée par ALD 41', une deuxième couche en résine époxy chargée en argent 42' déposée sur la première couche et une troisième couche à base d'étain **43'** déposée sur la deuxième couche. Les terminaisons permettent de reprendre les connections électriques alternativement positives et négatives sur chacune des extrémités concentriques. Ces terminaisons permettent de réaliser les connections électriques en parallèle entre les différents éléments de batterie. Pour cela, seule les connections (+) sortent sur une extrémité concentrique, et les (-) sont disponibles sur une autre extrémité concentrique.

### Exemples

L'invention est illustrée ci-dessous par des exemples qui cependant ne limitent pas l'invention. Ces exemples portent sur la préparation d'une batterie entièrement solide et sur l'encapsulation d'une telle batterie.

### 1. Préparation d'une batterie à ions de lithium

Une suspension du matériau d'anode à 10 g/l a été obtenue par broyage puis dispersion de Li₄Ti₅O₁₂ dans de l'éthanol absolu avec ajout quelques ppm d'acide citrique. Une suspension de matériau de cathode à 25 g/l a été obtenue par broyage puis dispersion de LiMn₂O₄ dans de l'éthanol absolu. La suspension de cathode a ensuite été diluée dans l'acétone jusqu'à une concentration de 5 g/l. La suspension de matériau d'électrolyte à 5 g/l a été obtenue par broyage puis dispersion d'une poudre de Li₃Al_{0,4}Sc_{1,6}(PO₄)₃ dans de l'éthanol absolu.

Pour toutes ces suspensions, le broyage a été conduit de manière à obtenir des suspensions stables avec une taille de particules inférieure à 100 nm.

Les électrodes négatives ont été préparées par dépôt électrophorétique des nanoparticules de Li₄Ti₅O₁₂ contenues dans la suspension préalablement préparée. Le film mince de Li₄Ti₅O₁₂ (épaisseur environ 1 µm) a été déposé sur les deux faces du substrat. Ces électrodes négatives ont ensuite été recuites à 600 °C.

Les électrodes positives ont été préparées de la même manière, par dépôt électrophorétique à partir de la suspension de LiMn₂O₄. Le film mince de LiMn₂O₄ (épaisseur environ 1 µm) a été déposé sur les deux faces du substrat. Les électrodes positives ont ensuite été recuites à 600 °C.

Après recuit les électrodes négatives et les électrodes positives ont été recouvertes d'une couche d'électrolyte Li₃Al_{0,4}Sc_{1,6}(PO₄)₃ par EPD. L'épaisseur de Li₃Al_{0,4}Sc_{1,6}(PO₄)₃ était d'environ 500 nm sur chaque électrode. Ces films d'électrolyte ont ensuite été séchés.

L'empilement des anodes et cathodes revêtues Li₃Al_{0,4}Sc_{1,6}(PO₄)₃ a été ensuite réalisé de manière à obtenir un empilement multicouche décalé latéralement (cf. figure 7). L'ensemble a ensuite été maintenu sous pression pendant 15 minutes à 600 °C pour réaliser l'assemblage.

### 2. Encapsulation de la batterie

Le système d'encapsulation a ensuite été déposé sur l'empilement multicouche précédent. Une couche d'alumine Al₂O₃ représentant la première couche du système d'encapsulation a été déposée par ALD). L'empilement multicouche des anodes et cathodes revêtues a été introduit dans la chambre d'un réacteur ALD P300 Picosun™. La chambre du réacteur ALD a été préalablement mise sous vide à 5 hPa et à 180 °C et préalablement soumise pendant 30 minutes à un flux de triméthylaluminium (ci-après TMA) - (CAS : 75-24-1), un précurseur chimique de l'alumine sous azote contenant moins de 3 ppm d'eau ultra-pure de type 1 (σ ≈ 0,05 µS/cm) comme gaz porteur à un débit de 150 sccm (cm³ standard / min), afin de stabiliser l'atmosphère de la chambre du réacteur avant tout dépôt. Après stabilisation de la chambre, une couche d'Al₂O₃ de 100 nm a été déposée par ALD.

Sur cette première couche d'alumine a ensuite été déposée par CVD un film de parylène N de 12 µm +/- 2 µm d'épaisseur.

Sur cette deuxième couche a ensuite été déposée une troisième couche d'encapsulation. Celle-ci peut être réalisée à base de résine époxy, de polyéthylène naphtalate (PEN), de silicone, de polyimide, de polyamide ou de polyuréthane. De préférence, elle est réalisée à base d'une résine époxy. Cette troisième couche a ensuite été durcie sous ultraviolets (UV) de manière à réduire la vitesse de dégradation de la batterie par des éléments atmosphériques.

### 3. Réalisation des terminaisons de la batterie

L'empilement ainsi encapsulé a ensuite été découpé suivant des plans de coupe permettant d'obtenir une batterie unitaire, avec la mise à nue sur chacun des plans de coupe les collecteurs de courant cathodiques, respectivement anodiques de la batterie. L'empilement encapsulé a ainsi été découpé sur deux des six faces de l'empilement de manière à rendre apparents les collecteurs de courant cathodiques, respectivement anodiques. Des terminaisons ont ensuite été ajoutées au niveau où les collecteurs de courant cathodiques, respectivement anodiques sont apparents (non revêtus d'électrolyte isolant).

Les connexions ont ensuite été rendu électroniquement conductrices, de préférence métallisées, par un dépôt de couches atomiques (ALD). Cette première couche mince de terminaison peut notamment être métallique ou à base de nitrure métallique. Cette première couche de terminaison a ensuite été immergée dans une résine époxy conductrice (chargée à l'argent) puis immergée dans un bain d'étain en fusion.

La batterie ainsi obtenue a été cyclée entre 2 et 2,7 V.

## Revendications

1. Système d'encapsulation (30) d'un objet (1000) tel qu'un composant électronique ou électrochimique tel qu'une batterie, **caractérisé en ce qu'**il est formé par trois couches successives comprenant :
(i) une première couche de recouvrement (31,31') composée d'une matière électriquement isolante déposée par dépôt de couches atomiques, qui recouvre au moins en partie ledit objet, ladite matière électriquement isolante étant, de préférence choisie parmi Al₂O₃, SiO₂, SiO_{y}Nₓ,
(ii) une deuxième couche de recouvrement (32,32') comprenant du parylène et/ou du polyimide, disposée sur la première couche de recouvrement, ladite deuxième couche de recouvrement comprenant, de préférence, du parylène N,
(iii) une troisième couche de recouvrement (33,33') déposée sur la deuxième couche de recouvrement de manière à protéger la deuxième couche d'encapsulation, notamment, vis-à-vis de l'oxygène, et à accroître la durée de vie de l'objet.

2. Composant électronique ou électrochimique tel qu'une batterie comprenant un système d'encapsulation (30) selon la revendication 1.

3. Composant électrochimique selon la revendication 2, ledit composant étant une batterie, ladite batterie comprenant
- un empilement alterné entre au moins une anode (10,10') et au moins une cathode (20,20'), chacune constituée d'un empilement de couches minces et dans lequel l'anode (10,10') comprend
∘ au moins une couche mince d'un matériau actif d'anode (12), et
∘ éventuellement une couche mince d'un matériau d'électrolyte (13),
et dans lequel empilement la cathode (20,20') comprend
∘ au moins une couche mince d'un matériau actif de cathode (22), et
∘ éventuellement une couche mince d'un matériau d'électrolyte (23) de sorte que la batterie comprenne successivement au moins une couche mince d'un matériau actif d'anode (12), au moins une couche mince d'un matériau d'électrolyte (13,23) et au moins une couche mince d'un matériau actif de cathode (22),
- un système d'encapsulation (30) selon la revendication 1, dans lequel ladite première couche (31,31') recouvre au moins en partie l'empilement,
ledit système recouvrant partiellement ledit empilement, une première anode (10) ou cathode (20) comprenant au moins une zone de connexion accessible, alors que la cathode (20) ou l'anode (10) adjacente comprend une zone de recouvrement (ZRT), qui est recouverte par au moins ladite première couche de recouvrement (31,31') et ladite deuxième couche de recouvrement (32,32'), ladite zone de recouvrement étant située en regard des zones de connexion (ZC) de la première anode ou cathode, selon une direction perpendiculaire au plan dudit empilement.

4. Procédé de fabrication d'un composant électronique ou électrochimique encapsulé, comprenant la formation d'un système d'encapsulation selon la revendication 1 et dans lequel on dépose successivement de manière à former ledit système d'encapsulation :
- une première couche (31,31') de recouvrement composée d'une matière électriquement isolante par dépôt de couches atomiques,
- une deuxième couche de recouvrement (32,32') comprenant du parylène et/ou du polyimide, déposée sur ladite première couche de recouvrement,
- une troisième couche de recouvrement (33,33'), déposée sur la deuxième couche de recouvrement, apte à, et déposée de manière à, protéger la deuxième couche d'encapsulation notamment de l'oxygène.

5. Procédé de fabrication d'une batterie en couches minces selon la revendication 4, ladite batterie comprenant un empilement alterné entre au moins une anode (10) et au moins une cathode (20,20'), chacune constituée d'un empilement de couches minces et dans lequel l'anode (10,10') comprend :
∘ au moins une couche mince d'un matériau actif d'anode (12), et
∘ éventuellement une couche mince d'un matériau d'électrolyte (13),
et dans lequel la cathode (20,20') comprend :
∘ au moins une couche mince d'un matériau actif de cathode (22), et
∘ éventuellement une couche mince d'un matériau d'électrolyte (23) de sorte que la batterie comprenne successivement au moins une couche mince d'un matériau actif d'anode (12), au moins une couche mince d'un matériau d'électrolyte (13,23) et au moins une couche mince d'un matériau actif de cathode (22),
ledit procédé comprenant les étapes suivantes :
(a) on forme une superposition primaire, comprenant une succession alternée de feuilles de cathode et de feuilles d'anode, ladite superposition primaire étant destinée à former au moins une batterie, deux feuilles adjacentes définissant au moins une région en saillie (RS), destinée à former ladite zone de connexion accessible (ZC), ainsi qu'au moins une région en retrait (RT), destinée à former ladite zone de recouvrement (RTC),
(b) on dépose le système d'encapsulation selon la revendication 1 par le procédé selon la revendication 4, et
optionnellement, après l'étape (b), on fait apparaître la zone de connexion accessible (ZC) ou chaque zone de connexion accessible (ZC).

6. Procédé de fabrication d'une batterie selon la revendication 5 dans lequel, après l'étape (b), on réalise une étape (c) comprenant au moins une découpe primaire perpendiculairement au plan de ladite superposition primaire de manière à rendre accessible une zone de connexion (ZC) au niveau de l'anode, ci-après zone de connexion anodique, et on réalise au moins une découpe primaire perpendiculairement au plan de ladite superposition primaire de manière à rendre accessible une zone de connexion (ZC) au niveau de la cathode, ci-après zone de connexion cathodique.

7. Procédé de fabrication d'une batterie selon la revendication 6, **caractérisé en ce qu'**on réalise les découpes primaires au niveau des bords opposés de ladite superposition primaire.

8. Procédé de fabrication d'une batterie selon la revendication 5, **caractérisé en ce que** les bords des deux feuilles adjacentes de la superposition primaire comprenant une succession alternée de feuilles de cathode et de feuilles d'anode sont des bords droits, le bord d'une première feuille formant la région en saillie (RS) alors que le bord d'une deuxième feuille formant la région en retrait (RR).

9. Procédé de fabrication d'une batterie selon l'une quelconque des revendications 5 à 6, **caractérisé en ce qu'**on réalise, dans le bord d'une première feuille de la superposition primaire comprenant une succession alternée de feuilles de cathode et de feuilles d'anode, des premières échancrures (50, 50', 50", 50''') ayant une première ou grande section, la paroi desdites premières échancrures constituant ladite région en retrait, et on réalise, dans une deuxième feuille adjacente, des deuxièmes échancrures ayant une deuxième ou petite section, inférieure à la première section, la paroi desdites deuxièmes échancrures (50, 50', 50", 50''') constituant ladite région en saillie (RS),
les échancrures (50, 50', 50", 50''') des feuilles de cathode et des feuilles d'anode, étant, de préférence, des échancrures en forme de cercle.

10. Procédé de fabrication d'une batterie selon l'une quelconque des revendications 5 à 6, **caractérisé en ce qu'**on réalise, dans une première feuille, des premiers orifices ayant une première ou grande section, la paroi desdits orifices constituant ladite région en retrait, on réalise, dans une deuxième feuille adjacente, des deuxièmes orifices ayant une deuxième ou petite section, inférieure à la première section, la paroi desdits orifices constituant ladite région en saillie (RS), on remplit le volume intérieur desdits orifices au moyen du système d'encapsulation et on réalise au moins une découpe secondaire à l'intérieur desdits premiers et deuxièmes orifices, de sorte que les zones de connexion (ZC) sont formées au voisinage des parois présentant la petite section et les zones de recouvrement sont formées au voisinage des parois présentant la grande section.

11. Procédé de fabrication d'une batterie selon l'une quelconque des revendications 5 à 8, **caractérisé en ce qu'**on réalise, dans deux feuilles adjacentes, des premières et deuxièmes fentes, mutuellement décalées selon la direction perpendiculaire au plan desdites feuilles, on remplit le volume intérieur desdites fentes au moyen du système d'encapsulation et on réalise au moins une découpe secondaire à l'intérieur desdites fentes, de sorte que les zones de connexion sont formées au voisinage des parois d'une première fente et les zones de recouvrement sont formées au voisinage des parois d'une deuxième fente.

12. Procédé de fabrication d'une batterie selon l'une quelconque des revendications 6 à 11 dans lequel, après l'étape (c), on connecte les zones de connexion (ZC) anodique et cathodique électriquement entre elles :
- par un dépôt en couche mince d'un conducteur électronique et dans lequel le dépôt est réalisé par dépôt de couches atomiques (41, 41'), ou
- par un système de terminaison comprenant successivement :
▪ une première couche électroniquement conductrice, de préférence métallique, optionnelle, de préférence déposée par dépôt de couches atomiques (41, 41'),
▪ une seconde couche (42, 42') à base de résine époxy chargée à l'argent, déposée sur la première couche électroniquement conductrice, et
▪ une troisième couche (43, 43') à base d'étain, déposée sur la deuxième couche, ou
- par un système de terminaison comprenant successivement :
▪ une première couche électroniquement conductrice, de préférence métallique, optionnelle, de préférence déposée par dépôt de couches atomiques (41),
▪ une seconde couche (42) à base de résine époxy chargée à l'argent, déposée sur la première couche électroniquement conductrice, et
▪ une troisième couche (43a) à base de nickel, déposée sur la deuxième couche,
▪ une quatrième couche (43b) à base d'étain ou de cuivre, déposée sur la troisième couche.

13. Procédé de fabrication d'une batterie selon l'une quelconque des revendications 6 à 11 **caractérisé en ce qu'**on réalise des terminaisons (40, 40') anodiques et cathodiques par métallisation des sections préalablement recouvertes d'une couche mince d'un conducteur électronique.

14. Procédé de fabrication d'une batterie selon l'une quelconque des revendications 5 à 13, dans lequel les feuilles présentent des dimensions supérieures à celles de la batterie finale, **caractérisé en ce qu'**on réalise au moins une autre découpe dite tertiaire, dans une partie médiane desdites feuilles.

15. Procédé de fabrication d'une batterie selon l'une quelconque des revendications 5 à 14, **caractérisé en ce que**
- l'épaisseur de la première couche mince de recouvrement est inférieure à 200 nm, de préférence comprise entre 5 nm et 200 nm, et encore plus préférentiellement d'environ 50 nm,
- l'épaisseur de la deuxième couche de recouvrement est comprise entre 1 µm et 50 µm, de préférence d'environ 10 µm, et
- optionnellement, l'épaisseur de la troisième couche mince de recouvrement est comprise entre 1 µm et 50 µm, de préférence inférieure à 10 µm, préférentiellement inférieure à 5 µm et encore plus préférentiellement d'environ 2 µm.

16. Procédé de fabrication d'une batterie selon l'une quelconque des revendications 5 à 15, **caractérisé en ce que** la couche de matériau d'anode est réalisée à partir d'un matériau choisi parmi :
- les oxynitrures d'étain (de formule typique SnOₓN_{y}) ;
- le phosphate de fer lithié (de formule typique LiFePO₄) ;
- les oxynitrures mixtes de silicium et étain (de formule typique SiₐSn_{b}O_{y}N_{z} avec a>0, b>0, a+b≤2, 0<y≤4, 0<z≤3) (appelés aussi SiTON), et en particulier le SiSn_{0,87}O_{1,2}N_{1,72} ; ainsi que les oxynitrures-carbures de formule typique SiₐSn_{b}C_{c}O_{y}N_{z} avec a>0, b>0, a+b≤2, 0<c<10, 0<y<24, 0<z<17; SiₐSn_{b}C_{c}O_{y}N_{z}Xₙ avec Xₙ au moins un des éléments parmi F, Cl, Br, I, S, Se, Te, P, As, Sb, Bi, Ge, Pb et a>0, b>0, a+b>0, a+b≤2, 0<c<10, 0<y<24 et 0<z<17; et SiₐSn_{b}O_{y}N_{z}Xₙ avec Xₙ au moins un des éléments parmi F, Cl, Br, I, S, Se, Te, P, As, Sb, Bi, Ge, Pb et a>0, b>0, a+b≤2, 0<y≤4 et 0<z≤3;
- les nitrures de type SiₓN_{y} (en particulier avec x=3 et y=4), SnₓN_{y} (en particulier avec x=3 et y=4), ZnₓN_{y} (en particulier avec x=3 et y=4), Li₃₋ₓMₓN (avec M = Co et 0≤x≤0.5, avec M = Ni et 0≤x≤0.6 ou avec M = Cu et 0≤x≤0.3) ;
- les oxydes SnO₂, Li₄Ti₅O₁₂, SnB_{0,6}P_{0,4}O_{2,9} et TiO₂,
et/ou **en ce que**
la couche de matériau d'électrolyte est réalisée à partir de matériau d'électrolyte choisi parmi :
∘ les grenats de formule Li_{d} A¹ₓ A²_{y}(TO₄)_{z} où
▪ A¹ représente un cation de degré d'oxydation +II, de préférence Ca, Mg, Sr, Ba, Fe, Mn, Zn, Y, Gd ; et où
▪ A² représente un cation de degré d'oxydation +III, de préférence Al, Fe, Cr, Ga, Ti, La ; et où
▪ (TO₄) représente un anion dans lequel T est un atome de degré d'oxydation +IV, situé au centre d'un tétraèdre formé par les atomes d'oxygène, et dans lequel TO₄ représente avantageusement l'anion silicate ou zirconate, sachant que tout ou partie des éléments T d'un degré d'oxydation +IV peuvent être remplacés par des atomes d'un degré d'oxydation +III ou +V, tels que Al, Fe, As, V, Nb, In, Ta ;
▪ sachant que : d est compris entre 2 et 10, préférentiellement entre 3 et 9, et encore plus préférentiellement entre 4 et 8 ; x est de 3 mais peut être compris entre 2,6 et 3,4 (de préférence entre 2,8 et 3,2) ; y est de 2 mais peut être compris entre 1,7 et 2,3 (de préférence entre 1,9 et 2,1) et z est de 3 mais peut être compris entre 2,9 et 3,1;
∘ les grenats, de préférence choisi parmi : le Li₇La₃Zr₂O₁₂; le Li₆La₂BaTa₂O₁₂ ; le Li_{5,5}La₃Nb_{1,75}In_{0.25}O₁₂ ; le Li₅La₃M₂O₁₂ avec M = Nb ou Ta ou un mélange des deux composés ; le Li₇₋ₓBaₓLa₃₋ₓM₂O₁₂ avec 0≤x≤1 et M = Nb ou Ta ou un mélange des deux composés ; le Li₇₋ₓLa₃Zr₂₋ₓMₓO₁₂ avec 0≤x≤2 et M = Al, Ga ou Ta ou un mélange de deux ou trois de ces composés ;
∘ les phosphates lithiés, de préférence choisi parmi : les phosphates lithiés de type NASICON ; le Li₃PO₄; le LiPO₃; le Li₃Al_{0,4}Sc_{1,6}(PO₄)₃ appelés « LASP » ; le Li₃(Sc₂₋ₓMₓ)(PO₄)₃ avec M=AI ou Y et 0 ≤ x ≤ 1 ; le Li₁₊ₓMₓ(Sc)₂₋ₓ(PO₄)₃ avec M = Al, Y, Ga ou un mélange des trois composés et 0 ≤ x ≤ 0,8 ; le Li₁₊ₓMₓ(Ga_{1-y}SC_{y})₂₋ₓ(PO₄)₃ avec 0 ≤ x ≤ 0,8 ; 0 ≤ y ≤ 1 et M= Al ou Y ou un mélange des deux composés; le Li₁₊ₓMₓ(Ga)₂₋ₓ(PO₄)₃ avec M = Al, Y ou un mélange des deux composés et 0 ≤ x ≤ 0,8 ; le Li₁₊ₓAlₓTi₂₋ₓ(PO₄)₃ avec 0 ≤ x ≤ 1 appelés « LATP » ; ou le Li₁₊ₓAlₓGe₂₋ₓ(PO₄)₃ avec 0 ≤ x ≤ 1 appelés « LAGP » ; ou le Li_{1+x+z}Mₓ(Ge_{1-y}Ti_{y})₂₋ₓSi_{z}P_{3-z}O₁₂ avec 0≤x≤0,8 et 0≤y≤1,0 et 0≤z≤0,6 et M= Al, Ga ou Y ou un mélange de deux ou trois de ces composés ; le Li_{3+y}(Sc₂₋ₓMₓ)Q_{y}P_{3-y}O₁₂ avec M = Al et/ou Y et Q = Si et/ou Se, 0 ≤ x ≤ 0,8 et 0 ≤ y ≤ 1 ; ou le Li_{1+x+y}MₓSc₂₋ₓQ_{y}P_{3-y}O₁₂ avec M = Al, Y, Ga ou un mélange des trois composés et Q = Si et/ou Se, 0 ≤ x ≤ 0,8 et 0 ≤ y ≤ 1 ; ou le Li_{1+x+y+z}Mₓ(Ga_{1-y}Sc_{y})₂₋ₓQ_{z}P_{3-z}O₁₂ avec 0 ≤ x ≤ 0,8, 0 ≤ y≤ 1, 0 ≤ z ≤ 0,6 avec M = Al ou Y ou un mélange des deux composés et Q= Si et/ou Se ; ou Li₁₊ₓ M³ₓM₂₋ₓP₃O₁₂, avec 0 ≤ x ≤ 1 et M³= Cr et/ou V, M = Sc, Sn, Zr, Hf, Se ou Si, ou un mélange de ces composés ;
∘ les composés soufrés lithiés, de préférence choisi parmi : le LiₓAl_{z-y}Ga_{y}S_{w}(PO₄)_{c} avec 4<w<20, 3<x<10, 0≦y<1, 1≦z<4 et 0<c<20 ; le LiₓAl_{z-y}Ga_{y}S_{w}(BO₃)_{c} avec 4<w<20, 3<x<10, 0≦y<1, 1≦z<4 et 0<c<20; le LiₓAl_{z-y}Sc_{y}S_{w}(PO₄)_{c} avec 4<w<20, 3<x<10, 0≦y<1, 1≦z<4 et 0<c<20 ; le LiₓAl_{z-y}Sc_{y}S_{w}(BO₃)_{c} avec 4<w<20, 3<x<10, 0≦y<1, 1≦z<4 et 0<c<20 ; le LiₓGe_{z-y}Si_{y}S_{w}(PO₄)_{c} avec 4<w<20, 3<x<10, 0≦y<1, 1≦z<4 et 0<c<20 ; le LiₓGe_{(z-y)}Si_{y}S_{w}(BO₃)_{c} avec 4<w<20, 3<x<10, 0≦y<1, 1≦z<4 et 0<c<20 ;
∘ les borates lithiés, de préférence choisi parmi : le Li₃(Sc₂₋ₓMₓ)ₓ)(BO₃)₃ avec M=AI ou Y et 0 ≤ x ≤ 1 ; le Li₁₊ₓMₓ(Sc)₂₋ₓ(BO₃)₃ avec M = Al, Y, Ga ou un mélange des trois composés et 0 ≤ x ≤ 0,8; le Li₁₊ₓMₓ(Ga_{1-y}SC_{y})₂₋ₓ(BO₃)₃ avec 0 ≤ x ≤ 0,8 , 0 ≤ y ≤ 1 et M= Al ou Y ; le Li₁₊ₓMₓ(Ga)₂₋ₓ(BO₃)₃ avec M = Al, Y ou un mélange des deux composés et 0 ≤ x ≤ 0,8; le Li₃BO₃, le Li₃BO₃-Li₂SO₄, le Li₃BO₃-Li₂SiO₄, le Li₃BO₃-Li₂SiO₄-Li₂SO₄ ;
∘ les oxynitrures, de préférence choisis parmi Li₃PO₄₋ₓN_{2x/3}, Li₄SiO₄₋ₓN_{2x/3}, Li₄GeO₄₋ₓN_{2x/3} avec 0 < x < 4 ou Li₃BO₃₋ₓN_{2x/3} avec 0 < x < 3 ;
∘ les composés lithiés à base d'oxynitrure de lithium et de phosphore, appelés « LiPON », sous forme de LiₓPO_{y}N_{z} avec x -2,8 et 2y+3z -7,8 et 0,16 ≤ z ≤ 0,4, et en particulier le Li_{2,9}PO_{3,3}N_{0,46}, mais également les composés Li_{w}POₓN_{y}S_{z} avec 2x+3y+2z = 5 = w ou les composés Li_{w}POₓN_{y}S_{z} avec 3,2 ≤ x ≤ 3,8, 0,13 ≤ y ≤ 0,4, 0 ≤ z ≤ 0,2 , 2,9 ≤ w ≤ 3,3 ou les composés sous forme de LiₜPₓAl_{y}OᵤNᵥS_{w} avec 5x+3y=5, 2u+3v+2w=5+t, 2,9≤t≤3,3, 0,84≤x≤0,94, 0,094≤y≤0,26, 3,2≤u≤3,8, 0,13≤v≤0,46, 0≤w≤0,2 ;
∘ les matériaux à base d'oxynitrures de lithium de phosphore ou de bore, appelés respectivement « LiPON » et « LIBON » pouvant également contenir du silicium, du soufre, du zirconium, de l'aluminium, ou une combinaison d'aluminium, bore, soufre et/ou silicium, et du bore pour les matériaux à base d'oxynitrures de lithium de phosphore ;
∘ les composés lithiés à base d'oxynitrure de lithium, de phosphore et de silicium appelés « LiSiPON », et en particulier le Li_{1.9}Si_{0.28}P_{1.0}O_{1.1}N_{1.0} ;
∘ les oxynitrures de lithium de types LiBON, LiBSO, LiSiPON, LiSON, thio-LiSiCON, LiPONB (ou B, P et S représentent respectivement le bore, le phosphore et le soufre);
∘ les oxynitrures de lithium de type LiBSO tels que (1-x)LiBO₂- xLi₂SO₄ avec 0,4 ≤ x ≤ 0,8 ;
∘ les oxydes lithiés, de préférence choisis parmi le Li₇La₃Zr₂O₁₂ ou le Li₅₊ₓLa₃(Zr_{x,}A₂₋ₓ)O₁₂ avec A=Sc, Y, Al, Ga et 1,4 ≤ x ≤ 2 ou le Li_{0,35}La_{0,55}TiO₃ ou le Li₃ₓLa_{2/3-x}TiO₃ avec 0 ≤ x ≤ 0,16 (LLTO);
∘ les silicates, de préférence choisis parmi Li₂Si₂O₅, Li₂SiO₃, Li₂Si₂O₆, LiAlSiO₄, Li₄SiO₄, LiAlSi₂O₆;
∘ les électrolytes solides de type anti-perovskite choisis parmi :
▪ Li₃OA avec A un halogénure ou un mélange d'halogénures, de préférence au moins un des éléments choisi parmi F, Cl, Br, I ou un mélange de deux ou trois ou quatre de ces éléments ;
• Li₍₃₋ₓ₎M_{x/2}OA avec 0 < x ≤ 3, M un métal divalent, de préférence au moins un des éléments choisi parmi Mg, Ca, Ba, Sr ou un mélange de deux ou trois ou quatre de ces éléments, A un halogénure ou un mélange d'halogénures, de préférence au moins un des éléments choisi parmi F, Cl, Br, I ou un mélange de deux ou trois ou quatre de ces éléments ;
Li_{(3-X)} M³_{x/3}OA avec 0 ≤ x ≤ 3, M³ un métal trivalent, A un halogénure ou un mélange d'halogénures, de préférence au moins un des éléments choisi parmi F, Cl, Br, I ou un mélange de deux ou trois ou quatre de ces éléments ; ou LiCOX_{z}Y_{(1-z)} avec X et Y des halogénures comme mentionnés ci-dessus en relation avec A, et 0 ≤ z ≤ 1 ;
∘ les composés La_{0,51}Li_{0,34}Ti_{2,94}, Li_{3,4}V_{0,4}Ge_{0,6}O₄, Li₂O-Nb₂O₅, LiAlGaSPO₄ ;
∘ les formulations à base de Li₂CO₃, B₂O₃, Li₂O, Al(PO₃)₃LiF, P₂S₃, Li₂S, Li₃N, Li₁₄Zn(GeO₄)₄, Li_{3,6}Ge_{0,6}V_{0,4}O₄, LiTi₂(PO₄)₃, Li_{3,25}Ge_{0,25}P_{0,25}S₄, Li_{1,3}Al_{0.3}Ti_{1.7}(PO₄)₃, Li₁₊ₓAlₓM₂₋ₓ(PO₄)₃ (où M = Ge, Ti, et/ou Hf, et où 0 < x < 1), Li_{1+x+y}AlₓTi₂₋ₓSi_{y}P_{3-y}O₁₂ (où 0≤x≤1 et 0≤y≤1),
∘ les électrolytes à base de polymères conducteurs d'ions lithium imprégnés ou non par des sels de lithium,
∘ les électrolytes hybrides comprenant une matrice inorganique telle qu'une matrice céramique dans laquelle une phase porteuse d'ions de lithium est insérée, telle qu'un électrolyte organique comprenant au moins un sel de lithium, qu'une solution formée par un sel de lithium dissout dans un solvant organique ou un mélange de solvants organiques, et/ou comprenant un polymère contenant au moins un sel de lithium possiblement dissout dans un solvant organique ou un mélange de solvants organiques, et/ou comprenant au moins un liquide ionique contenant au moins un sel de lithium possiblement dissout dans un solvant organique ou un mélange de solvants organiques.

17. Batterie en couches minces susceptible d'être obtenue par le procédé selon l'une quelconque des revendications 5 à 16.

18. Batterie en couches minces susceptible d'être obtenue par le procédé selon l'une quelconque des revendications 6 à 16, **caractérisée en ce que** ledit système d'encapsulation revêt totalement quatre des six faces de ladite batterie et partiellement les deux faces restantes latéralement opposées, les dites deux faces restantes étant partiellement revêtues par au moins ladite première couche de recouvrement (31,31') et au moins ladite deuxième couche (32,32') et les dites deux faces restantes comprenant une zone de connexion anodique et une zone de connexion cathodique.

## Patentansprüche

1. Verkapselungssystem (30) eines Objekts (1000), wie einer elektronischen oder elektrochemischen Komponente, wie einer Batterie, **dadurch gekennzeichnet, dass** es durch drei aufeinanderfolgende Schichten gebildet ist, umfassend:
(i) eine erste Abdeckungsschicht (31, 31'), die sich aus einem elektrisch isolierenden Material zusammensetzt, das durch Abscheiden atomarer Schichten abgeschieden wird, das das Objekt mindestens teilweise abdeckt, wobei das elektrisch isolierende Material vorzugsweise ausgewählt ist aus Al₂O₃, SiO₂, SiO_{y}Nₓ,
(ii) eine zweite Abdeckungsschicht (32, 32'), die Parylen und/ oder Polyimid umfasst, das auf der ersten Abdeckungsschicht abgeschieden wird, wobei die zweite Abdeckungsschicht vorzugsweise Parylen N umfasst,
(iii) eine dritte Abdeckungsschicht (33, 33'), die derart auf der zweiten Abdeckungsschicht abgeschieden wird, um die zweite Verkapselungsschicht, insbesondere gegenüber Sauerstoff zu schützen, und die Lebensdauer des Objekts zu erhöhen.

2. Elektronische oder elektrochemische Komponente, wie eine Batterie, ein Verkapselungssystem (30) nach Anspruch 1 umfassend.

3. Elektrochemische Komponente nach Anspruch 2, wobei die Komponente eine Batterie ist, wobei die Batterie umfasst:
- einen abwechselnden Stapel zwischen mindestens einer Anode (10, 10') und mindestens einer Kathode (20, 20'), von denen jede aus einem Stapel dünner Schichten gebildet ist, und wobei die Anode (10, 10') umfasst
∘ mindestens eine dünne Schicht aus einem aktiven Anodenmaterial (12), und
∘ eventuell eine dünne Schicht aus einem Elektrolytmaterial (13),
und wobei die Kathode (20, 20') in dem Stapel umfasst
∘ mindestens eine dünne Schicht aus einem aktiven Kathodenmaterial (22), und
∘ eventuell eine dünne Schicht aus einem Elektrolytmaterial (23), sodass die Batterie nacheinander mindestens eine dünne Schicht eines aktiven Anodenmaterials (12), mindestens eine dünne Schicht eines Elektrolytmaterials (13, 23) und mindestens eine dünne Schicht eines aktiven Kathodenmaterials (22) umfasst,
- ein Verkapselungssystem (30) nach Anspruch 1, wobei die erste Schicht (31, 31') den Stapel mindestens teilweise abdeckt,
wobei das System, das teilweise den Stapel, eine erste Anode (10) oder Kathode (20) abdeckt, mindestens eine zugängliche Verbindungszone umfasst, während die angrenzende Kathode (20) oder die Anode (10) eine Abdeckungszone (ZRT) umfasst, die durch mindestens die erste Abdeckunsschicht (31, 31') und die zweite Abdeckungsschicht (32, 32') abgedeckt ist, wobei die Abdeckungszone gegenüber den Verbindungszonen (ZC) der ersten Anode oder Kathode in einer zur Ebene des Stapels senkrechten Richtung gelegen ist.

4. Verfahren zur Herstellung einer verkapselten elektronischen oder elektrochemischen Komponente, die Bildung eines Verkapselungssystems nach Anspruch 1 umfassend und wobei nacheinander Folgendes abgeschieden wird, um das Verkapselungssystem zu bilden:
- eine erste Abdeckungsschicht (31, 31'), die sich aus einem elektrisch isolierenden Material zusammensetzt, durch Abscheiden atomarer Schichten,
- eine zweite Abdeckungsschicht (32, 32'), die Parylen und/ oder Polyimid umfasst, das auf der ersten Abdeckungsschicht abgeschieden wird,
- eine dritte Abdeckungsschicht (33, 33'), die auf der zweiten Abdeckungsschicht abgeschieden wird, die imstande ist, und derart abgeschieden wird, um die zweite Verkapselungsschicht insbesondere gegenüber Sauerstoff zu schützen.

5. Verfahren zur Herstellung einer Batterie in dünnen Schichten nach Anspruch 4, wobei die Batterie einen abwechselnden Stapel zwischen mindestens einer Anode (10) und mindestens einer Kathode (20, 20') umfasst, von denen jede aus einem Stapel dünner Schichten gebildet ist, und wobei die Anode (10, 10') umfasst:
∘ mindestens eine dünne Schicht aus einem aktiven Anodenmaterial (12), und
∘ eventuell eine dünne Schicht aus einem Elektrolytmaterial (13),
und wobei die Kathode (20, 20') umfasst:
∘ mindestens eine dünne Schicht aus einem aktiven Kathodenmaterial (22), und
∘ eventuell eine dünne Schicht aus einem Elektrolytmaterial (23), sodass die Batterie nacheinander mindestens eine dünne Schicht eines aktiven Anodenmaterials (12), mindestens eine dünne Schicht eines Elektrolytmaterials (13, 23) und mindestens eine dünne Schicht eines aktiven Kathodenmaterials (22) umfasst, wobei das Verfahren die folgenden Schritte umfasst:
(a) Bilden einer primären Überlagerung, umfassend eine abwechselnde Aufeinanderfolge von Kathodenfolien und Anodenfolien, wobei die primäre Überlagerung dazu bestimmt ist, mindestens eine Batterie zu bilden, wobei zwei angrenzende Folien mindestens eine Überstandsregion (RS) definieren, die dazu bestimmt ist, die zugängliche Verbindungszone (ZC) zu bilden, sowie mindestens eine Aussparungsregion (RT), die dazu bestimmt ist, die Überdeckungszone (RTC) zu bilden,
(b) Abscheiden des Verkapselungssystems nach Anspruch 1, durch das Verfahren nach Anspruch 4, und
optional, nach dem Schritt (b) Erscheinenlassen der zugänglichen Verbindungszone (ZC) oder jeder zugänglichen Verbindungszone (ZC).

6. Verfahren zur Herstellung einer Batterie nach Anspruch 5, wobei nach dem Schritt (b) ein Schritt (c) umgesetzt wird, der mindestens einen primären Schnitt senkrecht zur Ebene der primären Überlagerung umfasst, um eine Verbindungszone (ZC) im Bereich der Anode, nachfolgend Anodenverbindungszone, zugänglich zu machen, und mindestens ein primärer Schnitt senkrecht zu der Ebene der primären Überlagerung derart realisiert wird, um eine Verbindungszone (ZC) im Bereich der Kathode, nachfolgend Kathodenverbindungszone, zugänglich zu machen.

7. Verfahren zur Herstellung einer Batterie nach Anspruch 6, **dadurch gekennzeichnet, dass** die primären Schnitte im Bereich der gegenüberliegenden Ränder der primären Überlagerung realisiert werden.

8. Verfahren zur Herstellung einer Batterie nach Anspruch 5, **dadurch gekennzeichnet, dass** die Ränder der beiden angrenzenden Folien der primären Überlagerung, die eine abwechselnde Aufeinanderfolge von Kathodenfolien und Anodenfolien umfassen, gerade Ränder sind, wobei der Rand einer ersten Folie die Überstandsregion (RS) bildet, während der Rand einer zweiten Folie die Aussparungsregion (RR) bildet.

9. Verfahren zur Herstellung einer Batterie nach einem der Ansprüche 5 bis 6, **dadurch gekennzeichnet, dass** am Rand einer ersten Folie der primären Überlagerung, die eine abwechselnde Aufeinanderfolge von Kathodenfolien und Anodenfolien umfasst, erste Einkerbungen (50, 50', 50", 50''') realisiert werden, die eine erste oder große Sektion aufweisen, wobei die Wand der ersten Einkerbungen die Aussparungsregion bildet, und in einer zweiten angrenzenden Folie zweite Einkerbungen realisiert werden, die eine zweite oder kleine Sektion aufweisen, wobei die Wand der zweiten Einkerbungen (50, 50', 50", 50''') die Überstandsregion (RS) bildet,
wobei die Einkerbungen (50, 50', 50", 50''') der Kathodenfolien und der Anodenfolien vorzugsweise Einkerbungen in Kreisform sind.

10. Verfahren zur Herstellung einer Batterie nach einem der Ansprüche 5 bis 6, **dadurch gekennzeichnet, dass** in einer ersten Folie erste Öffnungen realisiert werden, die eine erste oder große Sektion aufweisen, wobei die Wand der Öffnungen die Aussparungsregion bildet, in einer zweiten angrenzenden Folie zweite Öffnungen realisiert werden, die eine zweite oder kleine Sektion aufweisen, die kleiner als die erste Sektion ist, wobei die Wand der Öffnungen die Überstandsregion (RS) bildet, das Innenvolumen der Öffnungen anhand des Verkapselungssystems gefüllt wird, und mindestens ein sekundärer Schnitt im Inneren der ersten und zweiten Öffnung realisiert wird, sodass die Verbindungszonen (ZC) in der Nachbarschaft der Wände gebildet werden, die die kleine Sektion aufweisen, und die Abdeckungszonen in der Nachbarschaft der Wände gebildet werden, die die große Sektion aufweisen.

11. Verfahren zur Herstellung einer Batterie nach einem der Ansprüche 5 bis 8, **dadurch gekennzeichnet, dass** in zwei angrenzenden Folien erste und zweite Schlitze realisiert werden, die zueinander in der Richtung senkrecht zur Ebene der Folien versetzt sind, das Innenvolumen der Schlitze anhand des Verkapselungssystems gefüllt wird, und mindestens ein sekundärer Schnitt im Inneren der Schlitze realisiert wird, sodass die Verbindungszonen in der Nachbarschaft der Wände eines ersten Schlitzes gebildet werden und die Überdeckungszonen in der Nachbarschaft der Wände eines zweiten Schlitzes gebildet werden.

12. Verfahren zur Herstellung einer Batterie nach einem der Ansprüche 6 bis 11, wobei nach dem Schritt (c) die Anoden- und Kathodenverbindungszonen (ZC) elektrisch miteinander verbunden werden:
- durch Abscheiden einer dünnen Schicht eines elektronischen Leiters und wobei die Abscheidung durch Abscheiden atomarer Schichten (41, 41') realisiert wird, oder
- durch ein Abschlusssystem, nacheinander Folgendes umfassend:
• eine erste elektronisch leitfähige, vorzugsweise metallische Schicht, optional vorzugsweise durch Abscheiden atomarer Schichten (41, 41') abgeschieden,
• eine zweite Schicht (42, 42') auf Basis eines mit Silber geladenen Epoxidharzes, das auf der elektronisch leitfähigen Schicht abgeschieden wird, und
• eine dritte Schicht (43, 43') auf Basis von Zinn, die auf der zweiten Schicht abgeschieden wird, oder
- durch ein Abschlusssystem, nacheinander Folgendes umfassend:
• eine erste elektronisch leitfähige, vorzugsweise metallische Schicht, optional vorzugsweise durch Abscheiden atomarer Schichten (41) abgeschieden,
• eine zweite Schicht (42) auf Basis eines mit Silber geladenen Epoxidharzes, das auf der elektronisch leitfähigen Schicht abgeschieden wird, und
• eine dritte Schicht (43a) auf Basis von Nickel, die auf der zweiten Schicht abgeschieden wird,
• eine vierte Schicht (43b) auf Basis von Zinn oder Kupfer, die auf der dritten Schicht abgeschieden wird.

13. Verfahren zur Herstellung einer Batterie nach einem der Ansprüche 6 bis 11, **dadurch gekennzeichnet, dass** Anoden- und Kathodenabschlüsse (40, 40') durch Metallisierung der zuvor abgedeckten Sektionen einer dünnen Schcht eines elektronischen Leiters realisiert werden.

14. Verfahren zur Herstellung einer Batterie nach einem der Ansprüche 5 bis 13, wobei die Folien Abmessungen aufweisen, die größer als jene der endültigen Batterie sind, **dadurch gekennzeichnet, dass** mindestens ein weiterer, sogenannter tertiärer Schnitt in einem Mittelteil der Folien realisiert wird.

15. Verfahren zur Herstellung einer Batterie nach einem der Ansprüche 5 bis 14, **dadurch gekennzeichnet, dass**
- die Dicke der ersten dünnen Abdeckungsschicht kleiner als 200 nm ist, vorzugsweise zwischen 5 nm und 200 nm enthalten ist, und noch bevorzugter etwa 50 nm beträgt,
- die Dicke der zweiten dünnen Abdeckungsschicht zwischen 1 µm und 5 µm enthalten ist, vorzugsweise etwa 10 µm beträgt,
- optional die Dicke der dritten dünnen Abdeckungsschicht zwischen 1 µm und 50 µm liegt, vorzugsweise kleiner als 10 µm ist, vorzugsweise kleiner als 5 µm ist und noch bevorzugter etwa 2 µm beträgt.

16. Verfahren zur Herstellung einer Batterie nach einem der Ansprüche 5 bis 15, **dadurch gekennzeichnet, dass** die Anodenmaterialschicht aus einem Material gefertigt ist, das ausgewählt ist aus:
- Zinnoxynitrid (mit der typischen Formel SnOₓN_{y}) ;
- mit Lithium versetztem Eisenphosphat (mit der typischen Formel LiFePO₄) ;
- gemischten Silicium- und Zinnoxynitriden (mit der typischen Formel SiₐSn_{b}O_{y}N_{z} mit a>0, b>0, a+b≤2, 0<y≤4, 0<z≤3) (auch SiTON genannt), und insbesondere SiSn_{0,87}O_{1,2}N_{1,72}; sowie Oxynitride-Karbide mit der typischen Formel SiₐSn_{b}C_{c}O_{y}N_{z} mit a>0, b>0, a+b≤2, 0<c<10, 0<y<24, 0<z<17; SiₐSn_{b}C_{c}O_{y}N_{z}Xₙ mit Xₙ als mindestens eines der Elemente aus F, Cl, Br, I, S, Se, Te, P, As, Sb, Bi, Ge, Pb und a>0, b>0, a+b>0, a+b≤2, 0<c<10, 0<y<24, 0<z<17; und SiₐSn_{b}O_{y}N_{z}Xₙ mit Xₙ als mindestens eines der Elemente aus F, Cl, Br, I, S, Se, Te, P, As, Sb, Bi, Ge, Pb und a>0, b>0, a+b≤2, 0<y≤4, 0<z≤3;
- die Nitride vom Typ SiₓN_{y} (insbesondere mit x=3 und y=4), SnₓN_{y} (insbesondere mit x=3 und y=4), Li₃₋ₓMₓN (mit M = Co und 0≤x≤0,5, mit M = Ni und 0≤x≤0,6 oder M = Cu und 0≤x≤0,3) ;
- die Oxyde SnO₂, Li₄Ti₅O₁₂, SnB_{0,6}P_{0,4}O_{2,9} und TiO₂, und/oder dadurch, dass
die Elektrolytmaterialschicht aus einem Elektrolymaterial gefertigt ist, ausgewählt aus:
∘ den Granaten der Formel Li_{d}A¹ₓA²_{y} (TO₄)_{z}, wobei
• A¹ ein Kation mit Oxidationsgrad +II darstellt, vorzugsweise Ca, Mg, Sr, Ba, Fe, Mn, Zn, Y, Gd; und wobei
• A² ein Kation mit Oxidationsgrad +III darstellt, vorzugsweise Al, Fe, Cr, Ga, Ti, La; und wobei
• (TO₄) ein Anion darstellt, in dem T ein Atom mit Oxydationsgrad +IV ist, in der Mitte eines Tetraeders gelegen, der durch die Sauerstoffatome gebildet wird, und wobei TO₄ vorteilhafterweise das Silikat- oder Zirkonatanion darstellt, wobei festzuhalten ist, dass alle Elemente T mit einem Oxydationsgrad +IV oder ein Teil davon durch Atome mit einem Oxydationsgrad +III oder +IV ersetzt werden können, wie Al, Fe, As, V, Nb, In, Ta;
• wobei Folgendes festzuhalten ist: d ist zwischen 2 und 10 enthalten, vorzugsweise zwischen 3 und 9, und noch bevorzugter zwischen 4 und 8; x ist 3, kann aber zwischen 2,6 und 3,4 (vorzugsweise zwischen 2,8 und 3,2) enthalten sein; y ist 2, kann aber zwischen 1,7 und 2,3 (vorzugsweise zwischen 1,9 und 2,1) enthalten sein, und z ist 3, kann aber zwischen 2,9 und 3,1 enthalten sein;
∘ den Granaten, vorzugsweise ausgewählt aus: Li₇La₃Zr₂O₁₂; Li₆La₂BaTa₂O₁₂; Li_{5,5}La₃Nb_{1,75}In_{0,25}O₁₂, Li₅La₃M₂O₁₂ mit M = Nb oder Ta oder ein Gemisch der beiden Verbindungen; Li₇₋ₓBaₓLa₃₋ₓM₂O₁₂ mit 0≤x≤1 und M = Nb oder Ta oder ein Gemisch der beiden Verbindungen; Li₇₋ₓLa₃Zr₂₋ₓMₓO₁₂ mit 0≤x≤2 und M = Al, Ga oder Ta oder ein Gemisch von zwei oder drei dieser Verbindungen;
∘ mit Lithium versetzten Phosphaten, vorzugsweise ausgewählt aus: die mit Lithium versetzten Phosphate vom Typ NASICON; Li₃PO₄; LiPO₃; Li₃Al_{0,4}Sc_{1,6}(PO₄)₃, "LASP" genannt; Li₃(Sc₂₋ₓMₓ) (P0₄)₃ mit M=Al oder Y und 0 ≤ x ≤ 1; Li₁₊ₓMₓ(Sc)₂₋ₓ(PO₄)₃ mit M = Al, Y, Ga oder ein Gemisch der drei Verbindungen und 0 ≤ x ≤ 0,8; Li₁₊ₓMₓ(Ga_{1-y}Sc_{y})₂₋ₓ(PO₄)₃ mit 0 ≤ x ≤ 0,8; 0 ≤ y ≤ 1 und M = Al oder Y oder ein Gemisch der beiden Verbindungen; Li₁₊ₓMₓ(Ga)₂₋ₓ(PO₄)₃ mit M = Al, Y oder ein Gemisch der beiden Verbindungen und 0 ≤ x ≤ 0,8; Li₁₊ₓAlₓTi₂₋ₓ(PO₄)₃ mit 0 ≤ x ≤ 1 "LATP" genannt; oder Li₁₊ₓAlₓGe₂₋ₓ(PO₄)₃ mit 0 ≤ x ≤ 1 "LAGP" genannt; oder Li_{1+x+z}Mₓ(Ge_{1-y}Ti_{y})₂₋ₓSi_{z}P_{3-z}O₁₂ mit 0 ≤ x ≤ 0, 8 und 0 ≤ y ≤ 1 und 0 ≤ z ≤ 0,6 und M = Al, Ga oder Y oder ein Gemisch von zwei oder drei dieser Verbindungen; Li_{3+y}(Sc₂₋ₓMₓ)Q_{y}P₃-_{y}O₁₂ mit M = Al und/ oder Y und Q = Si und/ oder Se, 0 ≤ x ≤ 0,8 und 0 ≤ y ≤ 1; oder Li_{1+x+y}MₓSc₂₋ₓQ_{y}P_{3-y}O₁₂ mit M = Al, Y, Ga oder ein Gemisch der drei Verbindungen und Q = Si und/ oder Se, 0 ≤ x ≤ 0, 8 und 0 ≤ y ≤ 1; oder Li_{1+x+y+z}Mₓ (Ga_{1-y}Sc_{y})₂₋ₓQ_{z}P_{3-z}O₁₂ mit 0 ≤ x ≤ 0,8 und 0 ≤ y ≤ 1, 0 ≤ z ≤ 0,6 mit M = Al oder Y oder ein Gemisch der beiden Verbindungen und Q = Si und/ oder Se; oder Li₁₊ₓM³ₓM₂₋ₓP₃O₁₂ mit 0 ≤ x ≤ 1 und M³ = Cr und/ oder V, M = Sc, Sn, Zr, Hf, Se oder Si oder ein Gemisch dieser Verbindungen;
∘ die mit Lithium versetzten Schwefelverbindungen, vorzugsweise ausgewählt aus: LiₓAl_{z-y}Ga_{y}S_{w}(PO₄)_{c} mit 4<w<20, 3<x<10, 0 ≦ y<1, 1 ≦ z<4 und 0<c<20; LiₓAl_{z-y}Ga_{y}S_{w}(BO₃)_{c} mit 4<w<20, 3<x<10, 0≦y<1, 1≦z<4 und 0<c<20; LiₓAl_{z-y}Sc_{y}S_{w}(BO₃)_{c} mit 4<w<20, 3<x<10, 0≦y<1, 1≦z<4 und 0<c<20; LiₓGe_{z-y}Si_{y}S_{w}(PO₄)_{c} mit 4<w<20, 3<x<10, 0 ≦ y<1, 1≦z<4 und 0<c<20; LiₓGe_{(z-y)}Si_{y}S_{w}(BO₃)_{c} mit 4<w<20, 3<x<10, 0≦y<1, 1≦z<4 und 0<c<20;
∘ die mit Lithium versetzten Borate, vorzugsweise ausgewählt aus: Li₃(Sc₂₋ₓMₓ) (BO₃)₃ mit M=Al oder Y und 0 ≤ x ≤ 1; Li₁₊ₓMₓ(Sc)₂₋ₓ(BO₃)₃ mit M = Al, Y, Ga oder ein Gemisch der drei Verbindungen und 0 ≤ x ≤ 0,8; Li₁₊ₓMₓ(Ga_{1-y}Sc_{y})₂₋ₓ(BO₃)₃ mit 0 ≤ x ≤ 0, 8, 0 ≤ y ≤ 1 und M = Al oder Y; Li₁₊ₓMₓ(Ga)₂₋ₓ(BO₃)₃ mit M = Al, Y oder ein Gemisch der beiden Verbindungen und 0 ≤ x ≤ 0, 8; Li₃BO₃, Li₃BO₃-Li₂SO₄, Li₃BO₃-Li₂SiO₄, Li₃BO₃-Li₂SiO₄-Li₂SO₄;
∘ die Oxynitride, vorzugsweise ausgewählt aus Li₃PO₄₋ₓN_{2x/3}, Li₃SiO₄₋ₓN_{2x/3}, Li₄GeO₄₋ₓN_{2x/3}, mit 0 < x < 4 oder Li₃BO₃₋ₓN_{2x/3} mit 0 < x < 3;
∘ die mit Lithium versetzten Verbindungen auf Basis von Lithium- und Phosphor-Oxynitrid, "LiPON" genannt, in Form von LiₓPO_{y}N_{z} mit x ∼ 2,8 und 2y + 3z ∼ 7, 8 und 0,16 ≤ z ≤ 0,4 und insbesondere Li_{2,9}PO_{3,3}N_{0,46} aber auch die Verbindungen Li_{w}POₓN_{y}S_{z} mit 2x+3y+2z = 5 = w oder die Verbindungen Li_{w}POₓN_{y}S_{z} mit 3,2 ≤ x ≤ 3,8, 0,13 ≤ y ≤ 0,4, 0 ≤ z ≤ 0,2, 2,9 ≤ w ≤ 3,3 oder die Verbindungen in Form von LiₜPₓAl_{y}OᵤNᵥS_{w} mit 5x+3y=5, 2u+3v+2w=5+t, 2, 9≤t≤3, 3, 0,84≤x≤0,94, 0,94≤y≤0,26, 3,2≤u≤3,8, 0,13≤v≤0,46, 0≤w≤0,2;
∘ die Materialien auf Basis von Lithium-, Phosphor- oder Bor-Oxynitriden, jeweils "LiPON" und "LiBON" genannt, die auch Silicium, Schwefel, Zirkonium, Aluminium oder eine Kombination aus Aluminium, Bor, Schwefel und/ oder Silicium und Bor für die Materialien auf Basis von Lithium-, Phosphat-Oxynitriden enthalten können;
∘ die mit Lithium versetzten Verbindungen auf Basis von Lithium-, Phosphor- oder Silicium-Oxynitriden, "LiSiPON" genannt, und insbesondere Li_{1,9}Si_{0,28}P_{1,0}O_{1,1}N_{1,0};
° die Lithium-Oxynitride der Typen LiBON, LiBSO, LiSiPON, LiSON, thio-LiSiCON, LiPONB (oder B, P und S jeweils Bor, Phosphor und Schwefel darstellen);
∘ die Lithium-Oxynitride des Typs LiBSO, wie (1-x)LiBO₂₋ₓLi₂SO₄ mit 0,4 ≤ x ≤ 0,8;
∘ die mit Lithium versetzten Oxyde, vorzugsweise ausgewählt aus Li₇La₃Zr₂O₁₂ oder Li₅₊ₓLa₃(Zrₓ,A₂₋ₓ)O₁₂ mit A = Sc, Y, Al, Ga und 1,4 ≤ x ≤ 2 oder Li_{0,35}La_{0,55}TiO₃ oder Li₃ₓLa_{2/3-x}TiO₃ mit 0 ≤ x ≤ 0,16 (LLTO);
∘ die Silikate, vorzugsweise ausgewählt aus Li₂Si₂O₅, Li₂SiO₃, Li₂Si₂O₆, LiAlSiO₄, Li₄SiO₄, LiAlSi₂O₆;
∘ die festen Elektrolyte vom Anti-Perovskite-Typ, ausgewählt aus:
• Li₃OA mit A einem Halogenid oder einem Gemisch aus Halogeniden, vorzugsweise mindestens eines der Elemente, ausgewählt aus F, Cl, Br, I oder einem Gemisch aus zwei oder drei oder vier dieser Elemente;
• Li₍₃₋ₓ₎M_{x/2}OA mit 0 < x ≤ 3, M ein zweiwertiges Metall, vorzugsweise mindestens eines der Elemente ausgewählt aus Mg, Ca, Ba, Sr oder einem Gemisch der zwei oder drei oder vier dieser Elemente, A einem Halogenid oder einem Gemisch aus Halogeniden, vorzugsweise mindestens eines der Elemente, ausgewählt aus F, Cl, Br, I oder einem Gemisch aus zwei oder drei oder vier dieser Elemente;
• Li₍₃₋ₓ₎M³_{x/3}OA mit 0 < x ≤ 3, M³ einem dreiwertigen Metall, A einem Halogenid oder einem Gemisch aus Halogeniden, vorzugsweise mindestens eines der Elemente, ausgewählt aus F, Cl, Br, I oder einem Gemisch aus zwei oder drei oder vier dieser Elemente; oder LiCOX_{z}Y_{(1-z)} mit X und Y Halogenide wie zuvor genannt in Verbindung mit A, und 0 ≤ z ≤ 1;
∘ die Verbindungen La_{0,51}Li_{0,34}Ti_{2,94}, Li_{3,4}V_{0,4}Ge_{0,6}O₄, Li₂O-Nb₂O₅, LiAlGaSPO₄;
∘ die Formulierungen auf Basis von Li₂CO₃, B₂O₃, Li₂O, Al(PO₃)₃LiF, P₂S₃, Li₂S, Li₃N, Li₁₄Zn(GeO₄)₄, Li_{3,6}Ge_{0,6}V_{0,4}O₄, LiTi₂(PO₄)₃, Li_{3,25}Ge_{0,25}P_{0,25}S₄, Li_{1,3}Al_{0,3}Ti_{1,7} (PO₄)₃, Li₁₊ₓAlₓM₂₋ₓ(PO₄)₃ (wobei M = Ge, Ti, und/ oder Hf und wobei 0 < x < 1), Li_{1+x+y}AlₓTi₂₋ₓSi_{y}P_{3-y}O₁₂ (wobei 0≤x≤1 und 0≤y≤1),
∘ die Elektrolyte auf Basis von leitfähigen Polymeren von durch Lithiumsalze imprägnierten oder nicht imprägnierten Lithiumionen,
∘ die Hybridelektrolyte, umfassend eine anorganische Matrix, wie eine keramische Matrix, in der eine Lithiumionen-Trägerphase eingesetzt ist, wie ein organisches Elektrolyt, das mindestens ein Lithiumsalz umfasst, eine Lösung, die durch ein Lithiumsalz gebildet wird, das in einem organischen Lösungsmittel oder einem Gemisch an organischen Lösungsmitteln aufgelöst ist, und/ oder ein Polymer umfassend, das mindestens ein Lithiumsalz enthält, das möglicherweise in einem organischen Lösungsmittel oder einem Gemisch aus organischen Lösungsmitteln aufgelöst ist, und/ oder mindestens eine ionische Flüssigkeit umfassend, die mindestens ein Lithiumsalz umfasst, das möglicherweise in einem organischen Lösungsmittel oder einem Gemisch aus organischen Lösungsmitteln aufgelöst ist.

17. Batterie aus dünnen Schichten, die durch das Verfahren nach einem der Ansprüche 5 bis 16 erhalten werden kann.

18. Batterie aus dünnen Schichten, die durch das Verfahren nach einem der Ansprüche 6 bis 16 erhalten werden kann, **dadurch gekennzeichnet, dass** das Verkapselungssystem vier der sechs Seiten der Batterie vollkommen, und die beiden restlichen, seitlich gegenüberliegenden Seiten teilweise überzieht, wobei die beiden restlichen Seiten teilweise durch mindestens die erste Abdeckungsschicht (31, 31') und mindestens die zweite Schicht (32, 32') überzogen sind, und die beiden restlichen Seiten eine Anodenverbindungszone und eine Kathodenverbindungszone umfassen.

## Claims

1. System (30) for encapsulating an object (1000) such as an electronic or electrochemical component such as a battery, **characterised in that** it is formed by three successive layers comprising:
(i) a first covering layer (31, 31') composed of an electrically insulating material deposited by atomic layer deposition, which at least partly covers said object, said electrically insulating material being, preferably selected from Al₂O₃, SiO₂, SiO_{y}Nₓ,
(ii) a second covering layer (32, 32') comprising parylene and/or polyimide, disposed on the first covering layer, said second covering layer comprising, preferably, parylene N,
(iii) a third covering layer (33, 33') deposited on the second covering layer in such a way as to protect the second encapsulation layer, namely, with respect to oxygen, and to increase the service life of the object.

2. Electronic or electrochemical component such as a battery, comprising an encapsulation system (30) according to claim 1.

3. Electrochemical component according to claim 2, said component being a battery, said battery comprising
- a stack alternating between at least one anode (10, 10') and at least one cathode (20, 20'), each consisting of a stack of thin films and wherein the anode (10, 10') comprises
-- at least one thin film of an active anode material (12), and
-- optionally a thin film of an electrolyte material (13), and in which stack the cathode (20, 20') comprises
-- at least one thin film of an active cathode material (22), and
-- optionally a thin film of an electrolyte material (23) so that the battery successively comprises at least one thin film of an active anode material (12), at least one thin film of an electrolyte material (13, 23) and at least one thin film of an active cathode material (22),
- an encapsulation system (30) according to claim 1, in which said first layer (31, 31') at least partly covers the stack,
said system partly covering said stack, a first anode (10) or cathode (20) comprising at least one accessible connection zone, while the cathode (20) or the adjacent anode (10) comprises a covering zone (ZRT), which is covered by at least said first covering layer (31, 31') and said second covering layer (32, 32'), said covering zone being located facing the connection zones (ZC) of the first anode or cathode, in a direction perpendicular to the plane of said stack.

4. Method for manufacturing an encapsulated electronic or electrochemical component, comprising the formation of an encapsulation system according to claim 1 and wherein the following are successively deposited in such a way as to form said encapsulation system:
- a first covering layer (31, 31') composed of an electrically insulating material by atomic layer deposition,
- a second covering layer (32, 32') comprising parylene and/or polyimide, deposited on said first covering layer,
- a third covering layer (33, 33'), deposited on the second covering layer, able to, and deposited in such a way as to, protect the second encapsulation layer namely from oxygen.

5. Method for manufacturing a thin film battery according to claim 4, said battery comprising a stack alternating between at least one anode (10) and at least one cathode (20, 20'), each consisting of a stack of thin films and wherein the anode (10, 10') comprises:
- at least one thin film of an active anode material (12), and
- optionally a thin film of an electrolyte material (13), and wherein the cathode (20, 20') comprises:
- at least one thin film of an active cathode material (22), and
- optionally a thin film of an electrolyte material (23) so that the battery successively comprises at least one thin film of an active anode material (12), at least one thin film of an electrolyte material (13, 23) and at least one thin film of an active cathode material (22), said method comprising the following steps:
(a) a primary superposition is formed, comprising an alternating succession of sheets of cathode and of sheets of anode, said primary superposition being intended to form at least one battery, two adjacent sheets defining at least one protruding region (RS), intended to form said accessible connection zone (ZC), as well as at least one set-back region (RT), intended to form said covering zone (RTC),
(b) the encapsulation system according to claim 1 is deposited by the method according to claim 4, and
optionally, after step (b), the accessible connection zone (ZC) or each accessible connection zone (ZC) are revealed.

6. Method for manufacturing a battery according to claim 5, wherein, after step (b), a step (c) is carried out comprising at least one primary cut perpendicularly to the plane of said primary superposition in such a way as to make accessible a connection zone (ZC) at the anode, hereinafter anode connection zone, and at least one primary cut is carried out perpendicularly to the plane of said primary superposition in such a way as to make accessible a connection zone (ZC) at the cathode, hereinafter cathode connection zone.

7. Method for manufacturing a battery according to claim 6, **characterised in that** the primary cuts are carried out at the opposite edges of said primary superposition.

8. Method for manufacturing a battery according to claim 5, **characterised in that** the edges of two adjacent sheets of the primary superposition comprising an alternating succession of sheets of cathode and of sheets of anode are straight edges, the edge of a first sheet forming the protruding region (RS) while the edge of a second sheet forming the set-back region (RR).

9. Method for manufacturing a battery according to any one of claims 5 to 6, **characterised in that** first notches (50, 50', 50", 50''') having a first or big cross-section are made in the edge of a first sheet of the primary superposition comprising an alternating succession of sheets of cathode and of sheets of anode, the wall of said first notches forming said set-back region, and second notches having a second or small cross-section, smaller than the first cross-section, are made in a second adjacent sheet, the wall of said second notches (50, 50', 50", 50''') forming said protruding region (RS),
the notches (50, 50', 50", 50''') of the cathode sheets and of the anode sheets, being, preferably, notches in the shape of a circle.

10. Method for manufacturing a battery according to any one of claims 5 to 6, **characterised in that** first orifices having a first or big cross-section are made in a first sheet, the wall of said orifices forming said set-back region, second orifices having a second or small cross-section, smaller than the first cross-section, are made in a second adjacent sheet, the wall of said orifices forming said protruding region (RS), the inner volume of said orifices is filled via the encapsulation system and at least one secondary cut is made inside said first and second orifices, so that the connection zones (ZC) are formed near the walls having the small cross-section and the covering zones are formed near the walls having the big cross-section.

11. Method for manufacturing a battery according to any one of claims 5 to 8, **characterised in that** in two adjacent sheets, first and second slots, mutually offset in the direction perpendicular to the plane of said sheets, are made, the inner volume of said slots is filled via the encapsulation system and at least one secondary cut is made inside said slots, so that the connection zones are formed near the walls of a first slot and the covering zones are formed near the walls of a second slot.

12. Method for manufacturing a battery according to any one of claims 6 to 11, wherein, after step (c), the anode and cathode connection zones (ZC) are electrically connected to each other:
- by thin-film deposition of an electronic conductor and wherein the deposition is carried out by atomic layer deposition (41, 41'), or
- by an interconnection system successively comprising:
-- a first electronically conductive layer, preferably metallic, optional, preferably deposited by atomic layer deposition (41, 41'),
-- a second layer (42, 42') containing epoxy resin loaded with silver, deposited on the first electronically conductive layer, and
-- a third layer (43, 43') containing tin, deposited on the second layer, or
- by an interconnection system successively comprising:
-- a first electronically conductive layer, preferably metallic, optional, preferably deposited by atomic layer deposition (41),
-- a second layer (42) containing epoxy resin loaded with silver, deposited on the first electronically conductive layer, and
-- a third layer (43a) containing nickel, deposited on the second layer,
-- a fourth layer (43b) containing tin or copper, deposited on the third layer.

13. Method for manufacturing a battery according to any one of claims 6 to 11, **characterised in that** anode and cathode interconnections (40, 40') are made by metallisation of the sections previously covered with a thin film of an electronic conductor.

14. Method for manufacturing a battery according to any one of claims 5 to 13, wherein the sheets have dimensions greater than those of the final battery, **characterised in that** at least one other cut called tertiary is carried out, in a median portion of said sheets.

15. Method for manufacturing a battery according to any one of claims 5 to 14, **characterised in that**
- the thickness of the first covering thin film is less than 200nm, preferably between 5nm and 200nm, and even more preferably approximately 50nm,
- the thickness of the second covering layer is between 1µm and 50pm, preferably approximately 10µm, and
- optionally, the thickness of the third covering thin film is between 1µm and 50µm, preferably less than 10µm, preferably less than 5µm and even more preferably approximately 2µm.

16. Method for manufacturing a battery according to any one of claims 5 to 15, **characterised in that** the layer of anode material is made from a material chosen from:
- the oxynitrides of tin (having the typical formula SnOₓN_{y}) ;
- lithiated iron phosphate (having the typical formula LiFePO₄) ;
- the mixed oxynitrides of silicon and tin (having the typical formula SiₐSn_{b}O_{y}N_{z} with a>0, b>0, a+b≤2, 0<y≤4, 0<z≤3) (also called SiTON), and in particular SiSn_{0.87}O_{1.2}N_{1.72}; as well as the oxynitride-carbides having the typical formula SiₐSn_{b}C_{c}O_{y}N_{z} with a>0, b>0, a+b≤2, 0<c<10, 0<y<24, 0<z<17; SiₐSn_{b}C_{c}O_{y}N_{z}Xₙ with Xₙ at least one of the elements out of F, Cl, Br, I, S, Se, Te, P, As, Sb, Bi, Ge, Pb and a>0, b>0, a+b>0, a+b≤2, 0<c<10, 0<y<24 and 0<z<17; and SiₐSn_{b}O_{y}N_{z}Xₙ with Xₙ at least one of the elements out of F, Cl, Br, I, S, Se, Te, P, As, Sb, Bi, Ge, Pb and a>0, b>0, a+b≤2, 0<y≤4 and 0<z≤3;
- the nitrides of the type SiₓN_{y} (in particular with x=3 and y=4), SnₓN_{y} (in particular with x=3 and y=4), ZnₓN_{y} (in particular with x=3 and y=4), Li₃₋ₓMₓN (with M = Co and 0≤x≤0.5, with M = Ni and 0≤x≤0.6 or with M = Cu and 0≤x≤0.3) ;
- the oxides SnO₂, Li₄Ti₅O₁₂, SnB_{0.6}P_{0.4}O_{2.9} and TiO₂,
and/or **in that**
the layer of electrolyte material is made from electrolyte material chosen from:
- the garnets having the formula Li_{d}A¹ₓA²_{y}(TO₄)_{z} where
-- A¹ represents a cation having the degree of oxidation +II, preferably Ca, Mg, Sr, Ba, Fe, Mn, Zn, Y, Gd; and where
-- A² represents a cation having the degree of oxidation +III, preferably Al, Fe, Cr, Ga, Ti, La; and where
-- (TO₄) represents an anion in which T is an atom having the degree of oxidation +IV, located at the centre of a tetrahedron formed by the atoms of oxygen, and in which TO₄ advantageously represents the silicate or zirconate anion, knowing that all or a portion of the elements T having a degree of oxidation +IV can be replaced by atoms having a degree of oxidation +III or +V, such as Al, Fe, As, V, Nb, In, Ta;
-- knowing that: d is between 2 and 10, preferably between 3 and 9, and even more preferably between 4 and 8; x is 3 but can be between 2.6 and 3.4 (preferably between 2.8 and 3.2); y is 2 but can be between 1.7 and 2.3 (preferably between 1.9 and 2.1) and z is 3 but can be between 2.9 and 3.1;
- the garnets, preferably chosen from: Li₇La₃Zr₂O₁₂; Li₆La₂BaTa₂O₁₂; Li_{5.5}La₃Nb_{1.75}In_{0.25}O₁₂; Li₅La₃M₂O₁₂ with M = Nb or Ta or a mixture of the two compounds; Li₇₋ₓBaₓLa₃₋ₓM₂O₁₂ with 0≤x≤1 and M = Nb or Ta or a mixture of the two compounds; Li₇₋ₓLa₃Zr₂₋ₓMₓO₁₂ with 0≤x≤2 and M = Al, Ga or Ta or a mixture of two or three of these compounds;
- the lithiated phosphates, preferably chosen from: the lithiated phosphates of the NASICON type; Li₃PO₄; LiPO₃; the Li₃Al_{0.4}Sc_{1.6}(PO₄)₃ called "LASP"; Li₃(Sc₂₋ₓMₓ) (PO₄)₃ with M=Al or Y and 0 ≤ x ≤ 1; Li₁₊ₓMₓ (Sc)₂₋ₓ(PO₄)₃ with M = Al, Y, Ga or a mixture of the three compounds and 0 ≤ x ≤ 0.8; Li₁₊ₓMₓ(Ga_{1-y}Sc_{y})₂₋ₓ(PO₄)₃ with 0 ≤ x ≤ 0.8; 0 ≤ y ≤ 1 and M= Al or Y or a mixture of the two compounds; Li₁₊ₓMₓ(Ga)₂₋ₓ(PO₄)₃ with M = Al, Y or a mixture of the two compounds and 0 ≤ x ≤ 0.8; the Li₁₊ₓAlₓTi₂₋ₓ(PO₄)₃ with 0 ≤ x ≤ 1 called "LATP"; or the Li₁₊ₓAlₓGe₂₋ₓ(PO₄)₃ with 0 ≤ x ≤ 1 called "LAGP"; or Li_{1+x+z}Mₓ(Ge_{1-y}Ti_{y})₂₋ₓSi_{z}P_{3-z}O₁₂ with 0≤x≤0.8 and 0≤y≤1.0 and 0≤z≤0.6 and M= Al, Ga or Y or a mixture of two or three of these compounds; Li_{3+y}(Sc₂₋ₓMₓ)Q_{y}P_{3-y}O₁₂ with M = Al and/or Y and Q = Si and/or Se, 0 ≤ x ≤ 0.8 and 0 ≤ y ≤ 1; or Li_{1+x+y}MₓSc₂₋ₓQ_{y}P_{3-y}O₁₂ with M = Al, Y, Ga or a mixture of the three compounds and Q = Si and/or Se, 0 ≤ x ≤ 0.8 and 0 ≤ y ≤ 1; or Li_{1+x+y+z}Mₓ(Ga_{1-y}Sc_{y})₂₋ₓQ_{z}P_{3-z}O₁₂ with 0 ≤ x ≤ 0.8, 0 ≤ y ≤ 1, 0 ≤ z ≤ 0.6 with M = Al or Y or a mixture of the two compounds and Q= Si and/or Se; or Li₁₊ₓM³ₓM₂₋ₓP₃O₁₂ with 0 ≤ x ≤ 1 and M³= Cr and/or V, M = Sc, Sn, Zr, Hf, Se or Si, or a mixture of these compounds;
- the lithiated sulphurated compounds, preferably chosen from: LiₓAl_{z-y}Ga_{y}S_{w} (PO₄)_{c} with 4<w<20, 3<x<10, 0≦y<1, 1≦z<4 and 0<c<20; LiₓAl_{z-y}Ga_{y}S_{w}(BO₃)_{c} with 4<w<20, 3<x<10, 0≦y<1, 1≦z<4 and 0<c<20; LiₓAl_{z-y}Sc_{y}S_{w}(PO₄)_{c} with 4<w<20, 3<x<10, 0≦y<1, 1≦z<4 and 0<c<20; LiₓAl_{z-y}Sc_{y}S_{w}(BO₃)_{c} with 4<w<20, 3<x<10, 0≦y<1, 1≦z<4 and 0<c<20; LiₓGe_{z-y}Si_{y}S_{w}(PO₄)_{c} with 4<w<20, 3<x<10, 0≦y<1, 1≦z<4 and 0<c<20; LiₓGe_{(z-y)}Si_{y}S_{w}(BO₃)_{c} with 4<w<20, 3<x<10, 0≦y<1, 1≦z<4 and 0<c<20;
- the lithiated borates, preferably chosen from: Li₃(Sc₂₋ₓMₓ) (BO₃)₃ with M=Al or Y and 0 ≤ x ≤ 1; Li₁₊ₓMx(Sc)₂₋ₓ(BO₃)₃ with M = Al, Y, Ga or a mixture of the three compounds and 0 ≤ x ≤ 0.8; Li₁₊ₓMₓ(Ga_{1-y}Sc_{y})₂₋ₓ(BO₃)₃ with 0 ≤ x ≤ 0.8, 0 ≤ y ≤ 1 and M= Al or Y; Li₁₊ₓMₓ(Ga)₂₋ₓ(BO₃)₃ with M = Al, Y or a mixture of the two compounds and 0 ≤ x ≤ 0.8; Li₃BO₃, Li₃BO₃-Li₂SO₄, Li₃BO₃-Li₂SiO₄, Li₃BO₃-Li₂SiO₄-Li₂SO₄;
- the oxynitrides, preferably chosen from Li₃PO₄₋ₓN_{2x/3}, Li₄SiO₄₋ₓN_{2x/3}, Li₄GeO₄₋ₓN_{2x/3} with 0 < x < 4 or Li₃BO₃₋ₓN_{2x/3} with 0 < x < 3;
- the lithiated compounds containing oxynitride of lithium and of phosphorus, called "LiPON", in the form of LiₓPO_{y}N_{z} with x ∼2.8 and 2y+3z ∼7.8 and 0.16 ≤ z ≤ 0.4, and in particular Li_{2.9}PO_{3.3}N_{0.46}, but also the compounds Li_{w}POₓN_{y}S_{z} with 2x+3y+2z = 5 = w or the compounds Li_{w}POₓN_{y}S_{z} avec 3.2 ≤ x ≤ 3.8, 0.13≤y ≤ 0.4, 0 ≤ z ≤ 0.2, 2.9 ≤ w ≤ 3.3 or the compounds in the form of LiₜPₓAl_{y}OᵤNᵥS_{w} with 5x+3y=5, 2u+3v+2w=5+t, 2.9≤t≤3.3, 0.84≤x≤0.94, 0.094≤y≤0.26, 3.2≤u≤3.8, 0.13≤v≤0.46, 0≤w≤0.2;
- the materials containing oxynitrides of lithium of phosphorus or of boron, respectively called "LiPON" and "LiBON" also capable of containing silicon, sulphur, zirconium, aluminium, or a combination of aluminium, boron, sulphur and/or silicon, and boron for the materials containing oxynitrides of lithium of phosphorus;
- the lithiated compounds containing oxynitride of lithium, of phosphorus and of silicon called "LiSiPON", and in particular Li_{1.9}Si_{0.28}P_{1.0}O_{1.1}N_{1.0};
- the oxynitrides of lithium of the types LiBON, LiBSO, LiSiPON, LiSON, thio-LiSiCON, LiPONB (or B, P and S respectively represent boron, phosphorus and sulphur);
- the oxynitrides of lithium of the type LiBSO such that (1-*x*)LiBO₂ - *x*Li₂SO₄ with 0.4 ≤ x ≤ 0.8;
- the lithiated oxides, preferably chosen from Li₇La₃Zr₂O₁₂ or Lᵢ₅₊ₓLa₃(Zrₓ,A₂₋ₓ)O₁₂ with A=Sc, Y, Al, Ga and 1.4 ≤ x ≤ 2 or Li_{0.35}La_{0.55}TiO₃ or Li₃ₓLa_{2/3-x}TiO₃ with 0 ≤ x ≤ 0.16 (LLTO);
- the silicates, preferably chosen from Li₂Si₂O₅, Li₂SiO₃, Li₂Si₂O₆, LiAlSiO₄, Li₄SiO₄, LiAlSi₂O₆;
- the solid electrolytes of the antiperovskite type chosen from:
-- Li₃OA with A a halide or a mixture of halides, preferably at least one of the elements chosen from F, Cl, Br, I or a mixture of two or three or four of these elements;
-- Li₍₃₋ₓ₎M_{x/2}OA with 0 < x ≤ 3, M a divalent metal, preferably at least one of the elements chosen from Mg, Ca, Ba, Sr or a mixture of two or three or four of these elements, A a halide or a mixture of halides, preferably at least one of the elements chosen from F, Cl, Br, I or a mixture of two or three or four of these elements;
-- Li₍₃₋ₓ₎M³_{x/3}OA with 0 ≤ x ≤ 3, M³ a trivalent metal, A a halide or a mixture of halides, preferably at least one of the elements chosen from F, Cl, Br, I or a mixture of two or three or four of these elements; or LiCOX_{z}Y_{(1-z)} with X and Y halides as mentioned above in relation to A, and 0 ≤ z ≤ 1;
- the compounds La_{0.51}Li_{0.34}Ti_{2.94}, Li_{3.4}V_{0.4}Ge_{0.6}O₄, Li₂O-Nb₂O₅, LiAlGaSPO₄ ;
- the formulations containing Li₂CO₃, B₂O₃, Li₂O, Al(PO₃)₃LiF, P₂S₃, Li₂S, Li₃N, Li₁₄Zn(GeO₄)₄, Li_{3.6}Ge_{0.6}V_{0.4}O₄, LiTi₂(PO₄)₃, Li_{3.25}Ge_{0.25}P_{0.25}S₄, Li_{1.3}Al_{0.3}Ti_{1.7}(PO₄)₃, Li₁₊ₓAlₓM₂₋ₓ(PO₄)₃ (where M = Ge, Ti, and/or Hf, and where 0 < x < 1), Li_{1+x+y}AlₓTi₂₋ₓSi_{y}P_{3-y}O₁₂ (where 0≤x≤1 and 0≤y≤1),
- the electrolytes containing polymers that conduct lithium ions impregnated or not with lithium salts,
- the hybrid electrolytes comprising an inorganic matrix such as a ceramic matrix into which a phase carrying lithium ions is inserted, such as an organic electrolyte comprising at least one lithium salt, a solution formed by a lithium salt dissolved in an organic solvent or a mixture of organic solvents, and/or comprising a polymer containing at least one lithium salt possibly dissolved in an organic solvent or a mixture of organic solvents, and/or comprising at least one ionic liquid containing at least one lithium salt possibly dissolved in an organic solvent or a mixture of organic solvents.

17. Thin film battery capable of being obtained by the method according to any one of claims 5 to 16.

18. Thin film battery capable of being obtained by the method according to any one of claims 6 to 16, **characterised in that** said encapsulation system totally coats four of the six faces of said battery and partly coats the two laterally opposite remaining faces, said two remaining faces being partly coated by at least said first covering layer (31, 31') and at least said second layer (32, 32') and said two remaining faces comprising an anode connection zone and a cathode connection zone.
